# EUROPEAN PATENT APPLICATION

(11) **EP 2 312 646 A1**
(43) Date of publication of application: **20.04.2011**
(21) Application number: 09770014.0
(22) Date of filing: 09.06.2009
(51) Int. Cl.: H01L 31/042

(54) **SOLAR CELL, PHOTOCONCENTRATION-TYPE PHOTOVOLTAIC MODULE, AND METHOD FOR MANUFACTURING SOLAR CELL**

(30) Priority: 23.06.2008 JP 2008163395; 04.03.2009 JP 2009050751
(71) Applicant: Sharp Kabushiki Kaisha, Osaka-shi, Osaka 545-8522 (JP)
(72) Inventor: ARIKAWA, Kazuhiko, Osaka 545-8522 (JP)
(74) Representative: Müller - Hoffmann & Partner
(86) International application number: PCT/JP2009/060540
(87) International publication number: WO 2009/157304

(57) **Abstract**

A solar cell having high heat resistance, reliability and weather resistance that prevents extraneous matter (rain water, dust and the like) from entering, a concentrating solar power generation module and a solar cell manufacturing method are provided.

A solar cell 21 includes an optical member 40 that allows concentrated sunlight Ls to pass therethrough, a solar cell element 23 that converts the sunlight Ls that has passed through the optical member 40 into electricity, and a receiver substrate 22 on which the solar cell element 23 is placed. The solar cell 21 includes a first adhesive portion 31 that is adhered to the receiver substrate 22 and that is formed into a frame shape surrounding the solar cell element 23, a pedestal portion 45 that is in contact with the receiver substrate 22 and that is adhered to the first adhesive portion 31 so as to surround the solar cell element 23, and an optical member 40 (first tabular optical member 40f) disposed in an interior region of a perimeter frame 45f of the pedestal portion 45.

## Description

### Technical Field

The present invention relates to a solar cell including an optical member that directs concentrated sunlight to a solar cell element and a receiver substrate on which the solar cell element is placed, a concentrating solar power generation module incorporating such a solar cell, and a method of manufacturing such a solar cell.

### Background Art

While solar power generation apparatuses which convert solar energy into electric power are commercialized, in order to achieve cost reduction and provide a large amount of electric power, a type of concentrating solar power generation apparatus has been proposed that provides electric power by irradiating a solar cell element having a light-receiving area smaller than that of a concentrating lens with sunlight concentrated by the concentrating lens (see, for example, Patent Document 1).

Because a concentrating solar power generation apparatus concentrates sunlight with the concentrating lens and directs the sunlight to the solar cell element, it is only necessary that the solar cell element has a small light-receiving area capable of receiving the sunlight concentrated by the optical system. That is, the solar cell element can be smaller in size than the light-receiving area of the concentrating lens, and accordingly, the size of solar cell element can be reduced, and the number of solar cell elements, which are an expensive component, used in the solar power generation apparatus can be reduced, resulting in a cost reduction.

Due to these advantages, concentrating solar power generation apparatuses are being increasingly used as electric power supplies in regions where a broad area can be used for power generation.

In order to improve light concentrating properties, concentrating solar power generation apparatuses having a configuration that causes sunlight concentrated by a concentrating lens serving as a primary optical system to enter a secondary optical system disposed so as to correspond to the solar cell element surface have been proposed (see, for example, Patent Documents 2 to 4).

When commercializing the technique disclosed in Patent Document 1, for example, a problem arises in that if extraneous matter (rainwater, dust and the like) enters from the outside of a tube-like lens frame 18, water droplets and dust will seep into the light-receiving region such as the upper edge face of a light conductor 47 attached to a solar cell 46, preventing sufficient light from being received. There is another problem in that a gap may occur between the lens frame 18 supporting a lens assembly 20 and a base panel 23 incorporating the solar cells 46 due to an assembly error because the lens frame 18 and the base panel 23 are large in size.

Furthermore, conventional concentrating solar power generation apparatuses face many difficulties when commercializing them due to complex structure of the optical systems, and it is therefore difficult to achieve easy and accurate positioning of a solar cell element relative to the concentrating lens or positioning of a secondary optical system relative to the concentrating lens. Moreover, due to the complexity of the structure, many problems exist in terms of maintenance of reliability of operation and improvement in productivity.

### Prior Art Documents

### Patent Documents

[Patent Document 1] JP H11-284217A
[Patent Document 2] JP 2002-289896A
[Patent Document 3] JP 2002-289897A
[Patent Document 4] JP 2002-289898A

### Summary of Invention

### Problems to be Solved by the Invention

The present invention has been conceived in view of the above circumstances, and it is a first object of the present invention to provide a solar cell that can be manufactured with high productivity including an optical member that allows concentrated sunlight to pass therethrough, a solar cell element that converts the sunlight that has passed through the optical member into electricity, and a receiver substrate on which the solar cell element is placed, and that by including a first adhesive portion surrounding the solar cell element, a pedestal portion that is adhered to the first adhesive portion and a resin sealing portion that covers the solar cell element, improves power generation efficiency and power generation and improves heat resistance, weather resistance and reliability, as a result of the constituent elements being easily and highly accurately positioned in the plane direction and stacking direction corresponding to the optical axis, concentrated sunlight being effectively directed to the solar cell element, the solar cell element being insulated from the outside to prevent the influence on the solar cell element due to extraneous matter entering from the outside.

It is a second object of the present invention to provide an inexpensive concentrating solar power generation module having high heat resistance, weather resistance and reliability, wherein the concentrating solar power generation module includes a concentrating lens and the solar cell according to the present invention, whereby light concentrating properties over a wide wavelength region are improved, improving the power generation efficiency and the power generation.

It is a third object of the present invention to provide a method of manufacturing the solar cell according to the present invention, wherein with simple steps of sequentially stacking and positioning each constituent member by performing a first adhesive applying step of applying a first adhesive, a pedestal portion placing step of placing a pedestal portion on the first adhesive, a first heat curing step of forming a first adhesive portion, and an optical member disposing step of disposing an optical member (columnar optical member) in a fixing portion, it is possible to easily and highly accurately manufacture solar cells having high heat resistance, weather resistance and reliability, with high productivity.

It is a fourth object of the present invention to provide a method of manufacturing the solar cell according to the present invention, wherein with simple steps of sequentially stacking and positioning each constituent member by performing a first adhesive applying step of applying a first adhesive, a pedestal portion placing step of placing a pedestal portion on the first adhesive, a second adhesive applying step of applying a second adhesive to the pedestal portion, a pedestal covering portion placing step of placing a pedestal covering portion on a receiver substrate, a first heat curing step of forming a first adhesive portion and a second adhesive portion, and a columnar optical member step of disposing a columnar optical member, it is possible to easily and highly accurately manufacture solar cells having high heat resistance, reliability and weather resistance, with high productivity.

It is a fifth object of the present invention to provide a solar cell having high heat resistance, reliability and weather resistance that includes a solar cell element that converts sunlight concentrated by a concentrating lens into electricity, a receiver substrate on which the solar cell element is placed, a columnar optical member that directs the concentrated sunlight to the solar cell element, and a holding portion that holds the columnar optical member, wherein the holding portion is fitted to a frame-shaped pedestal portion that is disposed around the solar cell element in the shape of a frame and that is fixed to the receiver substrate, whereby the columnar optical member is easily and highly accurately positioned and rigidly held relative to the solar cell element, and light concentrating properties over a wide wavelength region are improved, improving the power generation efficiency and the power generation.

It is a sixth object of the present invention to provide an inexpensive concentrating solar power generation module having high heat resistance, reliability and weather resistance, wherein the concentrating solar power generation module includes a concentrating lens and the solar cell according to the present invention, whereby light concentrating properties over a wide wavelength region are improved, improving the power generation efficiency and the power generation.

It is a seventh object of the present invention to provide a method of manufacturing the solar cell according to the present invention, wherein the method includes a frame-shaped pedestal portion placing step of positioning and placing a frame-shaped pedestal portion onto a receiver substrate, a fitting step of fitting a holding portion to the frame-shaped pedestal portion, and a columnar optical member installing step of inserting a columnar optical member into a through hole of the holding portion such that an irradiation face of the columnar optical member that faces the solar cell element is covered with a sealing resin, whereby it is possible to easily and highly accurately position and rigidly hold the columnar optical member relative to the solar cell element, and to easily and highly accurately manufacture highly reliable and inexpensive solar cells having improved light concentrating properties over a wide wavelength region and improved power generation efficiency and power generation, with high productivity.

### Means for Solving the Problems

A first solar cell according to the present invention is a solar cell including an optical member that allows concentrated sunlight to pass therethrough, a solar cell element that converts the sunlight that has passed through the optical member into electricity, and a receiver substrate on which the solar cell element is placed, wherein the solar cell includes a first adhesive portion that is adhered to the receiver substrate and that is formed into a frame shape surrounding the solar cell element, a pedestal portion that is in contact with the receiver substrate and that is adhered to the first adhesive portion so as to surround the solar cell element, and a resin sealing portion that is surrounded by the first adhesive portion and that covers the solar cell element.

With this configuration, the first adhesive portion and the pedestal portion are stacked on the receiver substrate and the solar cell element in the stacking direction and connected, and it is thus possible to easily and highly accurately position the resin sealing portion and the optical member relative to the solar cell element in the plane direction and stacking direction (height direction) corresponding to the optical axis, to effectively direct the concentrated sunlight to the solar cell element, and to insulate the solar cell element from the outside, thereby preventing the influence on the solar cell element due to extraneous matter entering from the outside. Consequently, it is possible to obtain a solar cell that has improved power generation efficiency and power generation, as well as improved heat resistance, weather resistance and reliability, and that can be manufactured with high productivity.

In the first solar cell according to the present invention, the optical member is a first tabular optical member having a tabular shape, and the first tabular optical member is disposed between the first adhesive portion and the pedestal portion.

With this configuration, it is possible to easily and highly accurately position and fix the optical member (first tabular optical member) relative to the first adhesive portion and the pedestal portion in the plane direction and the stacking direction.

In the first solar cell according to the present invention, the solar cell includes a second adhesive portion that is formed on top of the pedestal portion, and also includes a pedestal covering portion including a beam-shaped flange portion that is adhered to the second adhesive portion and that extends in a direction parallel to the receiver substrate and a coupling flange portion that extends outwardly from the beam-shaped flange portion and that is connected to the receiver substrate outside the pedestal portion.

With this configuration, it is possible to easily and highly accurately position the second adhesive portion and the pedestal covering portion relative to the receiver substrate, the solar cell element, the first adhesive portion and the pedestal portion in the plane direction and the stacking direction, enabling the pedestal portion to be fixed by the second adhesive portion and the pedestal covering portion (beam-shaped flange portion and coupling flange portion) and to be protected from the environment by the pedestal covering portion. Accordingly, a highly reliable solar cell having improved physical strength of the pedestal portion can be obtained.

In the first solar cell according to the present invention, the optical member is a second tabular optical member having a tabular shape, and the second tabular optical member is placed on top of the pedestal portion with a perimeter edge thereof covered with the beam-shaped flange portion.

With this configuration, it is possible to easily and highly accurately place and position the optical member (second tabular optical member) relative to the pedestal portion in the plane direction and the stacking direction.

In the first solar cell according to the present invention, the optical member is a columnar optical member having a columnar shape with a top face thereof larger than a bottom face thereof, and the columnar optical member is fixed by a fixing portion at an inner edge of the beam-shaped flange portion.

With this configuration, it is possible to easily and highly accurately position the optical member (columnar optical member) relative to the pedestal portion and the beam-shaped flange portion in the plane direction and the stacking direction, enabling the columnar optical member to be easily and highly accurately positioned relative to the solar cell element.

In the first solar cell according to the present invention, the fixing portion is an upright fixing portion that is provided upright at an inner edge frame of the beam-shaped flange portion and that has a through inclined face that allows the columnar optical member to pass through and that faces the columnar optical member.

With this configuration, it is possible to easily and highly accurately position and fix the columnar optical member to the beam-shaped flange portion (upright fixing portion) in the plane direction and the stacking direction.

A first concentrating sunlight solar cell module according to the present invention is a concentrating solar power generation module including a concentrating lens that concentrates sunlight and a solar cell that receives the concentrated sunlight and converts the sunlight into electricity, wherein the solar cell is a solar cell according to the present invention.

With this configuration, it is possible to obtain an inexpensive concentrating solar power generation module having high heat resistance, weather resistance and reliability that reliably improves the light concentrating properties over a wide wavelength region, improving the power generation efficiency and the power generation.

A method of manufacturing the first solar cell according to the present invention is a method of manufacturing a solar cell including an optical member that allows concentrated sunlight to pass therethrough, a solar cell element that converts the sunlight that has passed through the optical member into electricity, a receiver substrate on which the solar cell element is placed, a first adhesive portion that is adhered to the receiver substrate and that is formed into a frame shape surrounding the solar cell element, a pedestal portion that is in contact with the receiver substrate and that is adhered to the first adhesive portion so as to surround the solar cell element, and a fixing portion that fixes the optical member with respect to the pedestal portion, the method including: a first adhesive applying step of applying a first adhesive that forms the first adhesive portion to the receiver substrate; a pedestal portion placing step of placing the pedestal portion on the receiver substrate by adhering the pedestal portion to the first adhesive; a first heat curing step of forming the first adhesive portion by heating the first adhesive; and an optical member disposing step of disposing the optical member in the fixing portion.

With this configuration, with simple steps of sequentially stacking and positioning each constituent member (first adhesive, pedestal portion, optical member) by performing the first adhesive applying step, the pedestal portion placing step, the first heat curing step and the optical member disposing step, it is possible to easily and highly accurately manufacture solar cells that have high heat resistance, weather resistance and reliability, with high productivity.

Another method of manufacturing the first solar cell according to the present invention is a method of manufacturing a solar cell including an optical member that allows concentrated sunlight to pass therethrough, a solar cell element that converts the sunlight that has passed through the optical member into electricity, a receiver substrate on which the solar cell element is placed, a first adhesive portion that is adhered to the receiver substrate and that is formed into a frame shape surrounding the solar cell element, a pedestal portion that is in contact with the receiver substrate and that is adhered to the first adhesive portion so as to surround the solar cell element, a resin sealing portion that is surrounded by the first adhesive portion and that covers the solar cell element, and a second adhesive portion formed on top of the pedestal portion, and also including a pedestal covering portion including a beam-shaped flange portion that is adhered to the second adhesive portion and that extends in a direction parallel to the receiver substrate and a coupling flange portion that extends outwardly from the beam-shaped flange portion and that is connected to the receiver substrate outside the pedestal portion, and a fixing portion that fixes a columnar optical member that has a columnar shape and that serves as the optical member, the method including: a first adhesive applying step of applying a first adhesive that forms the first adhesive portion to the receiver substrate; a pedestal portion placing step of placing the pedestal portion on the receiver substrate by adhering the pedestal portion to the first adhesive; a second adhesive applying step of applying a second adhesive that forms the second adhesive portion on top of the pedestal portion; a pedestal covering portion placing step of placing the pedestal covering portion on the receiver substrate by adhering the pedestal covering portion to the second adhesive, the pedestal covering portion having an upright fixing portion, serving as the fixing portion, that is provided upright at an inner edge frame of the beam-shaped flange portion and that has a through inclined face that allows the columnar optical member to pass through and that faces the columnar optical member; a first heat curing step of forming the first adhesive portion and the second adhesive portion by heating the first adhesive and the second adhesive; a columnar optical member disposing step of disposing the columnar optical member such that the columnar optical member comes into contact with the through inclined face and is fixed; and a sealing resin injecting step of injecting a sealing resin for resin-sealing the solar cell element into an interior region of the first adhesive portion.

According to this configuration, with simple steps of sequentially stacking and positioning each constituent member (first adhesive portion, pedestal portion, second adhesive portion, pedestal covering portion (fixing portion = upright fixing portion), resin sealing portion, optical member (columnar optical member)) by performing the first adhesive applying step, the pedestal portion placing step, the second adhesive applying step, the pedestal covering portion placing step (fixing portion disposing step), the columnar optical member disposing step (optical member disposing step) and the sealing resin injecting step, it is possible to easily and highly accurately manufacture solar cells that have high heat resistance, weather resistance and reliability, with high productivity.

A second solar cell according to the present invention is a solar cell including a solar cell element that converts sunlight concentrated by a concentrating lens into electricity, a receiver substrate on which the solar cell element is placed, a columnar optical member having an entrance face that allows the concentrated sunlight to enter and an irradiation face that is disposed so as to face the solar cell element and that directs the sunlight to the solar cell element, and a holding portion that holds the columnar optical member, wherein the solar cell includes a frame-shaped pedestal portion that is disposed around the solar cell element in the shape of a frame and that is fixed to the receiver substrate, and the holding portion is fitted to the frame-shaped pedestal portion.

With this configuration, it is possible to easily and highly accurately position and rigidly fix the frame-shaped pedestal portion to the receiver substrate, and to easily and highly accurately position and rigidly hold the holding portion relative to the frame-shaped pedestal portion, and thus the columnar optical member can be easily and highly accurately positioned and rigidly held relative to the solar cell element, as a result of which it is possible to obtain an inexpensive solar cell having high heat resistance, reliability and weather resistance that improves the light concentrating properties over a wide wavelength region, improving the power generation efficiency and the power generation.

Also, the second solar cell according to the present invention includes a positioning pin that is disposed on the receiver substrate and that positions the frame-shaped pedestal portion.

With this configuration, it is possible to easily and highly accurately position the frame-shaped pedestal portion relative to the receiver substrate with good workability.

Also, in the second solar cell according to the present invention, the frame-shaped pedestal portion has a step portion to which the holding portion is fitted.

With this configuration, it is possible to easily and highly accurately position the holding portion relative to the frame-shaped pedestal portion with good workability.

Also, in the second solar cell according to the present invention, the frame-shaped pedestal portion has a groove portion formed in a face coming into contact with the receiver substrate, and is adhered to the receiver substrate by the first adhesive filled into the groove portion.

With this configuration, it is possible to easily and highly accurately fix (adhere) the frame-shaped pedestal portion to the receiver substrate with good workability.

Also, in the second solar cell according to the present invention, the holding portion includes a brim-like protrusion that is fitted to the step portion at an end facing the step portion.

With this configuration, it is possible to reduce the outer perimeter shape of the holding portion, enabling the columnar optical member to be held in a stable manner, and thus achieving weight reduction.

Also, in the second solar cell according to the present invention, the columnar optical member is formed into a quadrangular prism, and the holding portion has a columnar shape having a through hole that makes contact with the quadrangular prism.

With this configuration, it is possible to position the columnar optical member relative to the holding portion in a self-aligned manner, and to highly accurately direct the concentrated sunlight to the solar cell element, thereby improving the light concentrating properties and improving the power generation efficiency.

Also, in the second solar cell according to the present invention, the holding portion is made of a metal.

With this configuration, it is possible to improve the mechanical strength and heat dissipation properties of the holding portion, to reliably hold the columnar optical member in a stable manner, and to improve the power generation efficiency and the reliability.

Also, in the second solar cell according to the present invention, the irradiation face and the solar cell element are resin-sealed by a resin sealing portion filled into the frame-shaped pedestal portion.

With this configuration, it is possible to efficiently guide the sunlight that is directed to the solar cell element through the irradiation face, and to protect (insulate) the solar cell element and the wires connected to the solar cell element from the surrounding environment, thereby improving the power generation efficiency and the reliability.

Also, in the second solar cell according to the present invention, the holding portion has a recessed portion constituting a space in which the columnar optical member is exposed on a side facing the solar cell element.

With this configuration, it is possible to form a space between the resin sealing portion and the holding portion, enabling air bubbles produced from the sealing resin when forming the resin sealing portion to be released to the space, and thus the light-transmitting properties of the resin sealing portion can be improved, improving the power generation efficiency.

Also, in the second solar cell according to the present invention, the through hole has through groove portions formed so as to correspond to the corners of the quadrangular prism.

With this configuration, it is possible to protect the corners of the columnar optical member from damage, and to form air passages extending from the solar cell element to the outside, enabling air bubbles produced when forming the resin sealing portion to be released to the outside, and enabling a convection flow from the solar cell element to the outside to be produced during operation, thereby improving the power generation efficiency.

A second concentrating solar power generation module according to the present invention is a concentrating solar power generation module including a concentrating lens that concentrates sunlight and a solar cell that receives the concentrated sunlight and converts the sunlight into electricity, wherein the solar cell is a solar cell according to the present invention.

With this configuration, it is possible to obtain an inexpensive concentrating solar power generation module having high heat resistance, reliability and weather resistance that improves the light concentrating properties over a wide wavelength region, improving the power generation efficiency and the power generation.

A method of manufacturing the second solar cell according to the present invention is a method of manufacturing a solar cell including a solar cell element that converts sunlight concentrated by a concentrating lens into electricity, a receiver substrate on which the solar cell element is placed, a columnar optical member including an entrance face that allows the concentrated sunlight to enter and an irradiation face that is disposed so as to face the solar cell element and that directs the sunlight to the solar cell element, a holding portion that holds the columnar optical member, and a frame-shaped pedestal portion that is disposed around the solar cell element in the shape of a frame, that is fixed to the receiver substrate, and to which the holding portion is fitted, the method including: a solar cell element mounting step of mounting the solar cell element onto the receiver substrate; a first adhesive applying step of applying a first adhesive for adhering the frame-shaped pedestal portion to the receiver substrate onto the receiver substrate; a frame-shaped pedestal portion placing step of positioning and placing the frame-shaped pedestal portion onto the receiver substrate; a second adhesive applying step of applying a second adhesive for adhering the holding portion to the frame-shaped pedestal portion onto the frame-shaped pedestal portion; a fitting step of fitting the holding portion to the frame-shaped pedestal portion; a first heat curing step of thermally curing the first resin and the second resin by application of heat; a sealing resin injecting step of injecting a sealing resin for resin-sealing the solar cell element into the frame-shaped pedestal portion; a columnar optical member installing step of inserting the columnar optical member into a through hole of the holding portion such that the irradiation face of the columnar optical member that faces the solar cell element is covered with the sealing resin; a defoaming treatment step of performing a defoaming treatment on the sealing resin; and a second heat curing step of thermally curing the sealing resin by application of heat.

With this configuration, it is possible to easily and highly accurately position and rigidly fix the frame-shaped pedestal portion to the receiver substrate, and to easily and highly accurately position and rigidly hold the holding portion relative to the frame-shaped pedestal portion, and it is therefore possible to easily and highly accurately position and rigidly hold the columnar optical member relative to the solar cell element, and to easily and highly accurately manufacture highly reliable and inexpensive solar cells having improved light concentrating properties over a wide wavelength region and improved power generation efficiency and power generation, with high productivity.

### Effects of the Invention

With a first solar cell according to the present invention, because it is a solar cell including an optical member that allows concentrated sunlight to pass therethrough, a solar cell element that converts the sunlight that has passed through the optical member into electricity, and a receiver substrate on which the solar cell element is placed, and the solar cell includes a first adhesive portion that is adhered to the receiver substrate and that is formed into a frame shape surrounding the solar cell element, a pedestal portion that is in contact with the receiver substrate and that is adhered to the first adhesive portion so as to surround the solar cell element, and a resin sealing portion that is surrounded by the first adhesive portion and that covers the solar cell element, the following effects can be obtained: the first adhesive portion and the pedestal portion are stacked on the receiver substrate and the solar cell element in the stacking direction and connected, the resin sealing portion and the optical member are easily and highly accurately positioned relative to the solar cell element in the plane direction and stacking direction (height direction) corresponding to the optical axis, effectively directing the concentrated sunlight to the solar cell element, and the solar cell element is insulated from the outside air, preventing the influence on the solar cell element due to the outside air, as a result of which it is possible to obtain a solar cell that has improved heat resistance, weather resistance and reliability, and that can be manufactured with high productivity.

With a first concentrating sunlight solar cell module according to the present invention, because it is a concentrating solar power generation module including a concentrating lens that concentrates sunlight and a solar cell that receives the concentrated sunlight and converts the sunlight into electricity, and the solar cell is a solar cell according to the present invention, the following effects can be obtained: it is possible to obtain an inexpensive concentrating solar power generation module having high heat resistance, weather resistance and reliability that reliably improves the light concentrating properties over a wide wavelength region, improving the power generation efficiency and the power generation.

With a method of manufacturing the first solar cell according to the present invention, because it is a method of manufacturing a solar cell including an optical member that allows concentrated sunlight to pass therethrough, a solar cell element that converts the sunlight that has passed through the optical member into electricity, a receiver substrate on which the solar cell element is placed, a first adhesive portion that is adhered to the receiver substrate and that is formed into a frame shape surrounding the solar cell element, a pedestal portion that is in contact with the receiver substrate and that is adhered to the first adhesive portion so as to surround the solar cell element, and a fixing portion that fixes the optical member with respect to the pedestal portion, and the method includes: a first adhesive applying step of applying a first adhesive that forms the first adhesive portion to the receiver substrate; a pedestal portion placing step of placing the pedestal portion on the receiver substrate by adhering the pedestal portion to the first adhesive; a first heat curing step of forming the first adhesive portion by heating the first adhesive; and an optical member disposing step of disposing the optical member in the fixing portion, the following effects can be obtained: with simple steps of sequentially stacking and positioning each constituent member (first adhesive, pedestal portion, optical member (columnar optical member)) by performing the first adhesive applying step, the pedestal portion placing step, the first heat curing step and the optical member disposing step, it is possible to easily and highly accurately manufacture solar cells having high heat resistance, weather resistance and reliability, with high productivity.

With a method of manufacturing the first solar cell according to the present invention, because it is a method of manufacturing a solar cell including an optical member that allows concentrated sunlight to pass therethrough, a solar cell element that converts the sunlight that has passed through the optical member into electricity, a receiver substrate on which the solar cell element is placed, a first adhesive portion that is adhered to the receiver substrate and that is formed into a frame shape surrounding the solar cell element, a pedestal portion that is in contact with the receiver substrate and that is adhered to the first adhesive portion so as to surround the solar cell element, a resin sealing portion that is surrounded by the first adhesive portion and that covers the solar cell element, and a second adhesive portion formed on top of the pedestal portion, and also including a pedestal covering portion including a beam-shaped flange portion that is adhered to the second adhesive portion and that extends in a direction parallel to the receiver substrate and a coupling flange portion that extends outwardly from the beam-shaped flange portion and that is connected to the receiver substrate outside the pedestal portion, and a fixing portion that fixes a columnar optical member that has a columnar shape and that serves as the optical member, and the method includes: a first adhesive applying step of applying a first adhesive that forms the first adhesive portion to the receiver substrate; a pedestal portion placing step of placing the pedestal portion on the receiver substrate by adhering the pedestal portion to the first adhesive; a second adhesive applying step of applying a second adhesive that forms the second adhesive portion on top of the pedestal portion; a pedestal covering portion placing step of placing the pedestal covering portion on the receiver substrate by adhering the pedestal covering portion to the second adhesive, the pedestal covering portion having an upright fixing portion, serving as the fixing portion, that is provided upright at an inner edge frame of the beam-shaped flange portion and that has a through inclined face that allows the columnar optical member to pass through and that faces the columnar optical member; a first heat curing step of forming the first adhesive portion and the second adhesive portion by heating the first adhesive and the second adhesive; a columnar optical member disposing step of disposing the columnar optical member such that the columnar optical member comes into contact with the through inclined face and is fixed; and a sealing resin injecting step of injecting a sealing resin for resin-sealing the solar cell element into an interior region of the first adhesive portion, the following effects can be obtained: with simple steps of sequentially stacking and positioning each constituent member (first adhesive portion, pedestal portion, second adhesive portion, pedestal covering portion (fixing portion = upright fixing portion), resin sealing portion, columnar optical member (optical member)) by performing the first adhesive applying step, the pedestal portion placing step, the second adhesive applying step, the pedestal covering portion placing step (fixing portion disposing step), the columnar optical member disposing step (optical member disposing step) and the sealing resin injecting step, it is possible to easily and highly accurately manufacture solar cells having high heat resistance, weather resistance and reliability, with high productivity.

With a second solar cell according to the present invention, because it is a solar cell including a solar cell element that converts sunlight concentrated by a concentrating lens into electricity, a receiver substrate on which the solar cell element is placed, a columnar optical member having an entrance face that allows the concentrated sunlight to enter and an irradiation face that is disposed so as to face the solar cell element and that directs the sunlight to the solar cell element, and a holding portion that holds the columnar optical member, the solar cell includes a frame-shaped pedestal portion that is disposed around the solar cell element in the shape of a frame and that is fixed to the receiver substrate, and the holding portion is fitted to the frame-shaped pedestal portion, the following effects can be obtained: the frame-shaped pedestal portion can be easily and highly accurately positioned and rigidly fixed to the receiver substrate, and the holding portion can be easily and highly accurately positioned and rigidly held relative to the frame-shaped pedestal portion, enabling the columnar optical member to be easily and highly accurately positioned and rigidly held relative to the solar cell element, as a result of which it is possible to obtain an inexpensive solar cell having high heat resistance, reliability and weather resistance that reliably improves the light concentrating properties over a wide wavelength region, improving the power generation efficiency and the power generation.

Also, with a second concentrating solar power generation module according to the present invention, because it is a concentrating solar power generation module including a concentrating lens that concentrates sunlight and a solar cell that receives the concentrated sunlight and converts the sunlight into electricity, and the solar cell is a solar cell according to the present invention, the following effects can be obtained: it is possible to obtain an inexpensive concentrating solar power generation module having high heat resistance, reliability and weather resistance that improves the light concentrating properties over a wide wavelength region, improving the power generation efficiency and the power generation.

Also, with a method of manufacturing the second solar cell according to the present invention, because it is a method of manufacturing a solar cell including a solar cell element that converts sunlight concentrated by a concentrating lens into electricity, a receiver substrate on which the solar cell element is placed, a columnar optical member including an entrance face that allows the concentrated sunlight to enter and an irradiation face that is disposed so as to face the solar cell element and that directs the sunlight to the solar cell element, a holding portion that holds the columnar optical member, and a frame-shaped pedestal portion that is disposed around the solar cell element in the shape of a frame, that is fixed to the receiver substrate, and to which the holding portion is fitted, and the method includes: a solar cell element mounting step of mounting the solar cell element onto the receiver substrate; a first adhesive applying step of applying a first adhesive for adhering the frame-shaped pedestal portion to the receiver substrate onto the receiver substrate; a frame-shaped pedestal portion placing step of positioning and placing the frame-shaped pedestal portion onto the receiver substrate; a second adhesive applying step of applying a second adhesive for adhering the holding portion to the frame-shaped pedestal portion onto the frame-shaped pedestal portion; a fitting step of fitting the holding portion to the frame-shaped pedestal portion; a first heat curing step of thermally curing the first resin and the second resin by application of heat; a sealing resin injecting step of injecting a sealing resin for resin-sealing the solar cell element into the frame-shaped pedestal portion; a columnar optical member installing step of inserting the columnar optical member into a through hole of the holding portion such that the irradiation face of the columnar optical member that faces the solar cell element is covered with the sealing resin; a defoaming treatment step of performing a defoaming treatment on the sealing resin; and a second heat curing step of thermally curing the sealing resin by application of heat, the following effects can be obtained: it is possible to easily and highly accurately position and rigidly fix the frame-shaped pedestal portion to the receiver substrate, and to easily and highly accurately position and rigidly hold the holding portion relative to the frame-shaped pedestal portion, and it is therefore possible to easily and highly accurately position and rigidly hold the columnar optical member relative to the solar cell element, and to easily and highly accurately manufacture highly reliable and inexpensive solar cells having improved light concentrating properties over a wide wavelength region and improved power generation efficiency and power generation, with high productivity.

### Brief Description of Drawings

[FIG. 1] FIG. 1 is a cross-sectional view schematically showing a cross-sectional state of a schematic configuration of a solar cell according to Embodiment 1 of the present invention.
[FIG. 2] FIG. 2 is a cross-sectional view schematically showing a cross-sectional state of a schematic configuration of a solar cell according to Embodiment 2 of the present invention.
[FIG. 3] FIG. 3 is a cross-sectional view schematically showing a cross-sectional state of a schematic configuration of a solar cell according to Embodiment 3 of the present invention.
[FIG. 4] FIG. 4 is a cross-sectional view schematically showing a cross-sectional state of a schematic configuration of a solar cell and a concentrating solar power generation module according to Embodiment 4 of the present invention.
[FIG. 5] FIG. 5 is an enlarged cross-sectional view showing a cross-sectional state of an enlarged schematic configuration of the solar cell shown in FIG. 4.
[FIG. 6] FIG. 6 is a perspective plan view showing the schematic configuration of the solar cell shown in FIG. 4.
[FIG. 7] FIG. 7 is a perspective view showing the arrangement of a solar cell element and a receiver substrate of the solar cell shown in FIG. 4.
[FIG. 8] FIG. 8 is a perspective view showing a schematic configuration of a pedestal portion of the solar cell shown in FIG. 4.
[FIG. 9] FIG. 9 is a cross-sectional view showing a cross-sectional state of the pedestal portion shown in FIG. 8.
[FIG. 10] FIG. 10 is a perspective view showing a schematic configuration of a pedestal covering portion, a fixing portion and a columnar optical member of the solar cell shown in FIG. 4.
[FIG. 11] FIG. 11 is a cross-sectional view showing a cross-sectional state of the pedestal covering portion, the fixing portion and the columnar optical member shown in FIG. 10.
[FIG. 12] FIG. 12 is a perspective view showing a schematic configuration of a cap shown in FIG. 4.
[FIG. 13] FIG. 13 is a cross-sectional view showing a cross-sectional shape of the cap shown in FIG. 12.
[FIG. 14] FIG. 14 is a flowchart illustrating process steps of a method of manufacturing a solar cell according to Embodiment 5 of the present invention.
[FIG. 15] FIG. 15 is a perspective view showing a step of setting a receiver substrate onto a positioning jig that is performed as a preparation step for applying a first adhesive that forms a first adhesive portion in the process of the solar cell manufacturing method according to Embodiment 5 of the present invention.
[FIG. 16] FIG. 16 is a perspective view showing a state in which the receiver substrate has been set on the positioning jig through the preparation step of FIG. 15.
[FIG. 17] FIG. 17 is a perspective view showing a step of applying a first adhesive portion in the process of the solar cell manufacturing method according to Embodiment 5 of the present invention.
[FIG. 18] FIG. 18 is a perspective view showing a step of placing a pedestal portion onto the receiver substrate in the process of the solar cell manufacturing method according to Embodiment 5 of the present invention.
[FIG. 19] FIG. 19 is a perspective view showing a step of applying a second adhesive portion to the pedestal portion in the process of the solar cell manufacturing method according to Embodiment 5 of the present invention.
[FIG. 20] FIG. 20 is a perspective view showing a step of placing a pedestal covering portion on the pedestal portion in the process of the solar cell manufacturing method according to Embodiment 5 of the present invention.
[FIG. 21] FIG. 21 is a perspective view showing a step of injecting a sealing resin for resin-sealing a solar cell element to the pedestal portion in the process of the solar cell manufacturing method according to Embodiment 5 of the present invention.
[FIG. 22] FIG. 22 is a perspective view showing a step of inserting a columnar optical member into a through hole of an upright fixing portion in the process of the solar cell manufacturing method according to Embodiment 5 of the present invention.
[FIG. 23] FIG. 23 is a perspective view showing a step of applying a translucent adhesive to a top face of the columnar optical member in the process of the solar cell manufacturing method according to Embodiment 5 of the present invention.
[FIG. 24] FIG. 24 is a perspective view showing a step of applying a third adhesive onto the upright fixing portion in the process of the solar cell manufacturing method according to Embodiment 5 of the present invention.
[FIG. 25] FIG. 25 is a perspective view showing a step of placing a translucent protective plate onto the upright fixing portion in the process of the solar cell manufacturing method according to Embodiment 5 of the present invention.
[FIG. 26] FIG. 26 is a perspective view showing a step of placing a cap onto the upright fixing portion in the process of the solar cell manufacturing method according to Embodiment 5 of the present invention.
[FIG. 27] FIG. 27 is a cross-sectional view showing a cross-sectional state of a concentrating solar power generation module and a solar cell according to Embodiment 6 of the present invention.
[FIG. 28] FIG. 28 is a perspective view showing an outer appearance of the solar cell shown in FIG. 27.
[FIG. 29] FIG. 29 is a perspective view showing a state in which the solar cell element shown in FIG. 27 has been mounted on a receiver substrate.
[FIG. 30A] FIG. 30A is a cross-sectional view showing a cross-sectional shape of a frame-shaped pedestal portion shown in FIG. 27.
[FIG. 30B] FIG. 30B is a perspective view showing a schematic structure of a holding portion shown in FIG. 27.
[FIG. 30C] FIG. 30C is a cross-sectional view showing a cross-sectional shape of the holding portion shown in FIG. 30B.
[FIG. 31] FIG. 31 is a flowchart illustrating process steps of a method of manufacturing a solar cell according to Embodiment 7 of the present invention.
[FIG. 32] FIG. 32 is a perspective view showing a step of applying a first adhesive in the process of the solar cell manufacturing method according to Embodiment 7 of the present invention.
[FIG. 33] FIG. 33 is a perspective view showing a step of placing a frame-shaped pedestal portion onto a receiver substrate in the process of the solar cell manufacturing method according to Embodiment 7 of the present invention.
[FIG. 34] FIG. 34 is a perspective view showing a step of applying a second adhesive to the frame-shaped pedestal portion in the process of the solar cell manufacturing method according to Embodiment 7 of the present invention.
[FIG. 35] FIG. 35 is a perspective view showing a step of fitting a holding portion to the frame-shaped pedestal portion in the process of the solar cell manufacturing method according to Embodiment 7 of the present invention.
[FIG. 36] FIG. 36 is a perspective view showing a step of injecting a sealing resin for resin-sealing a solar cell element into the frame-shaped pedestal portion in the process of the solar cell manufacturing method according to Embodiment 7 of the present invention.
[FIG. 37] FIG. 37 is a perspective view showing a step of inserting a columnar optical member into a through hole of the holding portion in the process of the solar cell manufacturing method according to Embodiment 7 of the present invention.

### Modes for Carrying out the Invention

Hereinafter, embodiments of the present invention will be described with reference to the drawings.

### Embodiment 1

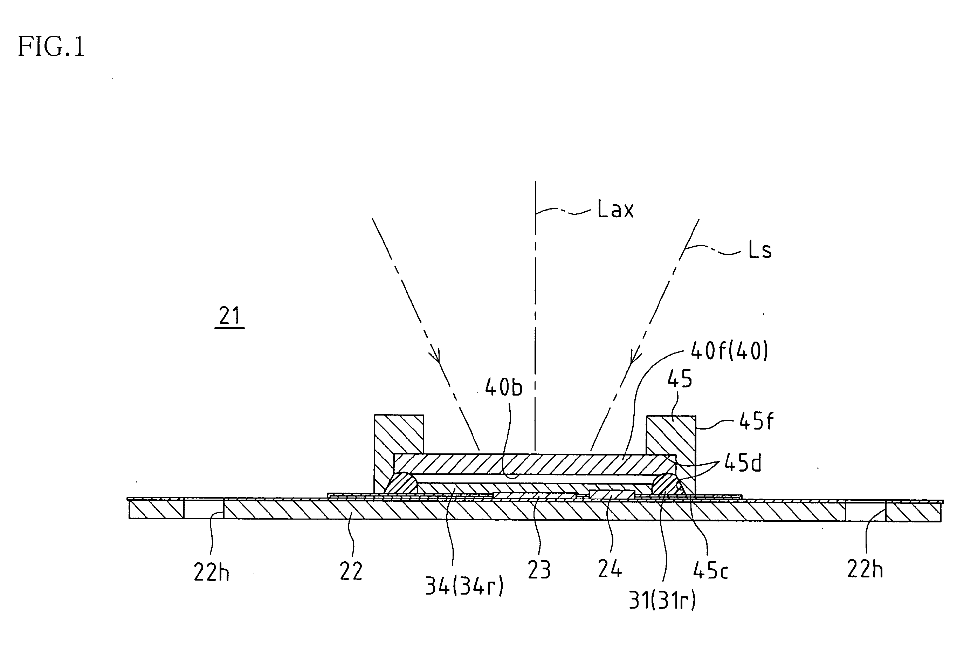

A solar cell according to the present embodiment and a method of manufacturing the solar cell will be described with reference to FIG. 1.

FIG. 1 is a cross-sectional view schematically showing a cross-sectional state of a schematic configuration of a solar cell according to Embodiment 1 of the present invention.

A solar cell 21 according to the present embodiment includes an optical member 40 (first tabular optical member 40f) that allows concentrated sunlight Ls to pass therethrough, a solar cell element 23 that converts the sunlight Ls that has passed through the optical member 40 into electricity, and a receiver substrate 22 on which the solar cell element 23 is placed.

The solar cell 21 includes a first adhesive portion 31 that is adhered to the receiver substrate 22 and that is formed into a frame shape surrounding the solar cell element 23, a pedestal portion 45 that is in contact with the receiver substrate 22 and that is adhered to the first adhesive portion 31 so as to surround the solar cell element 23, and a resin sealing portion 34 that is surrounded by the first adhesive portion 31 and that covers the solar cell element 23.

Accordingly, the first adhesive portion 31 and the pedestal portion 45 are stacked on the receiver substrate 22 and the solar cell element 23 in the stacking direction and connected, and it is thus possible to easily and highly accurately position the resin sealing portion 34 and the optical member 40 (first tabular optical member 40f) relative to the solar cell element 23 in the plane direction and stacking direction (height direction) corresponding to the optical axis Lax, to effectively direct the concentrated sunlight Ls to the solar cell element 23, and to insulate the solar cell element 23 from the outside, thereby preventing the influence on the solar cell element due to extraneous matter entering from the outside. Consequently, it is possible to obtain a solar cell 21 that has improved power generation efficiency and power generation, as well as improved heat resistance, weather resistance and reliability, and that can be manufactured with high productivity.

In other words, in the solar cell 21 of the present embodiment, it is possible to, for example, sequentially stack and position the receiver substrate 22, the solar cell element 23, the first adhesive portion 31, the pedestal portion 45 and the optical member 40 in the plane direction and stacking direction corresponding to the optical axis Lax.

The optical member 40 is a first tabular optical member 40f having a tabular shape, and the first tabular optical member 40f is disposed between the first adhesive portion 31 and the pedestal portion 45 in the stacking direction. Accordingly, the optical member 40 (first tabular optical member 40f) can be easily and highly accurately positioned and fixed to the first adhesive portion 31 and the pedestal portion 45 in the plane direction and the stacking direction. Also, the optical member 40 is horizontally disposed in an interior region of a perimeter frame 45f of the pedestal portion 45, and it is thus possible to position the optical member 40 relative to the pedestal portion 45 with high accuracy.

The pedestal portion 45 is adhered to the receiver substrate 22 by the first adhesive portion 31 disposed between a bottom recess 45d formed in the bottom face 45c of the pedestal portion 45 and the receiver substrate 22. In other words, the first adhesive portion 31 is formed between the bottom recess 45d of the pedestal portion 45 and the receiver substrate 22.

Accordingly, the pedestal portion 45 and the receiver substrate 22 can be adhered and fixed to each other via the first adhesive portion 31 with high accuracy. It is preferable to form the pedestal portion 45 so as to have a frame shape similar to the first adhesive portion 31, but the configuration is not limited thereto, and the pedestal portion 45 may have a four-leg structure, for example. That is to say, the pedestal portion 45 can have any structure as long as it is sufficiently adhered to the first adhesive portion 31 and is stably fixed to the receiver substrate 22. The position of the pedestal portion 45 is determined with high accuracy, and thus the focal length of the optical member 40 can be adjusted with high accuracy. The four-leg structure (variation) of the pedestal portion 45 will be described in further detail in Embodiment 5.

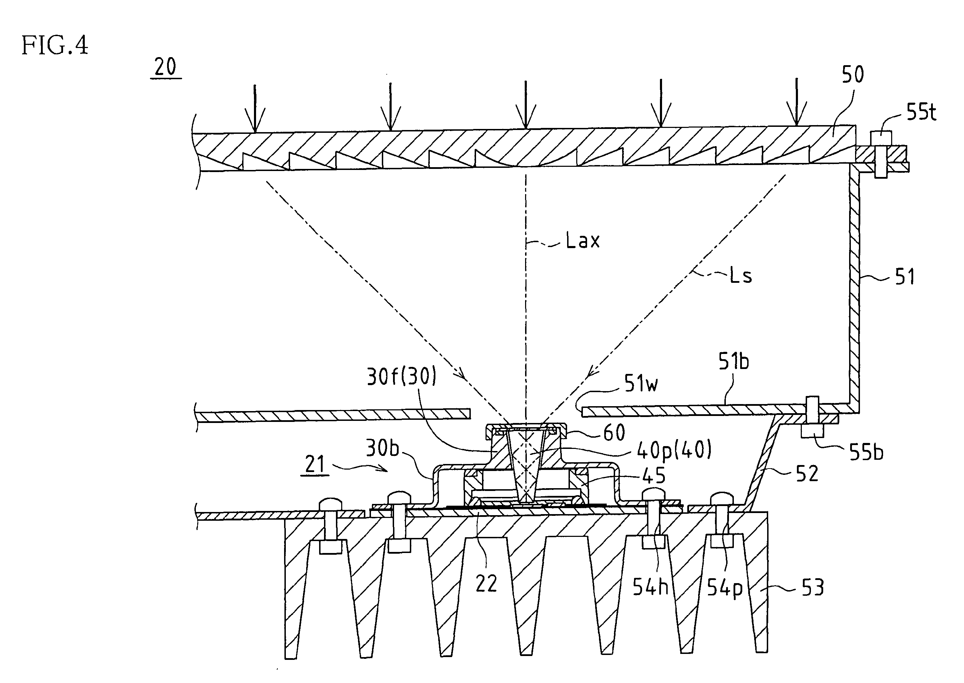

In the case where the degree of sealing a space into which sunlight Ls is guided is increased by reducing gaps at connecting portions such as a lens frame 51 (see FIG. 4) and a base plate 52 (see the same drawing) in order to prevent extraneous matter (rain water and dust) from entering, a moisture-containing gas (air, for example) within a light guiding region extending from the concentrating lens 50 (see the same drawing) to the solar cell element 23 or the optical member 40 will cause condensation as the ambient temperature changes, and water droplets may be created in the light guiding region and adhere to the receiver substrate 22 or the like.

There is a possibility that the water droplets that have adhered to the receiver substrate 22 or the like might flow into the surface of the solar cell element 23 due to changes of the angle of the receiver substrate 22 or the like when tracking sunlight Ls. However, the solar cell element 23 is insulated from the light guiding region side by the first adhesive portion 31, the resin sealing portion 34 and the like, and it is therefore possible to prevent the influence on the solar cell element 23 due to extraneous matter (water droplets and the like) entering from the light guiding region side.

Also, in the case where a surface region of the solar cell element 23 (for example, a space region between the resin sealing portion 34 and a bottom face 40b of the first tabular optical member 40f) is filled with a gas (for example, air, nitrogen or argon) insulated from the light guiding region, it is preferable to fill the space region with a gas having a humidity as low as possible. It is also preferable that the region insulated from the light guiding region side has a volume as small as possible from the viewpoint of reducing the absolute amount of moisture.

Alternatively, the surface region of the solar cell element 23 may be sealed by filling the surface region with a sealing resin, instead of a gas. In order to reduce the absolute amount of the filler so as to reduce the influence of expansion and contraction, it is preferable that the region insulated from the light guiding region side has a volume as small as possible. Furthermore, an insulation region filled with a gas may be provided on the light guiding region side.

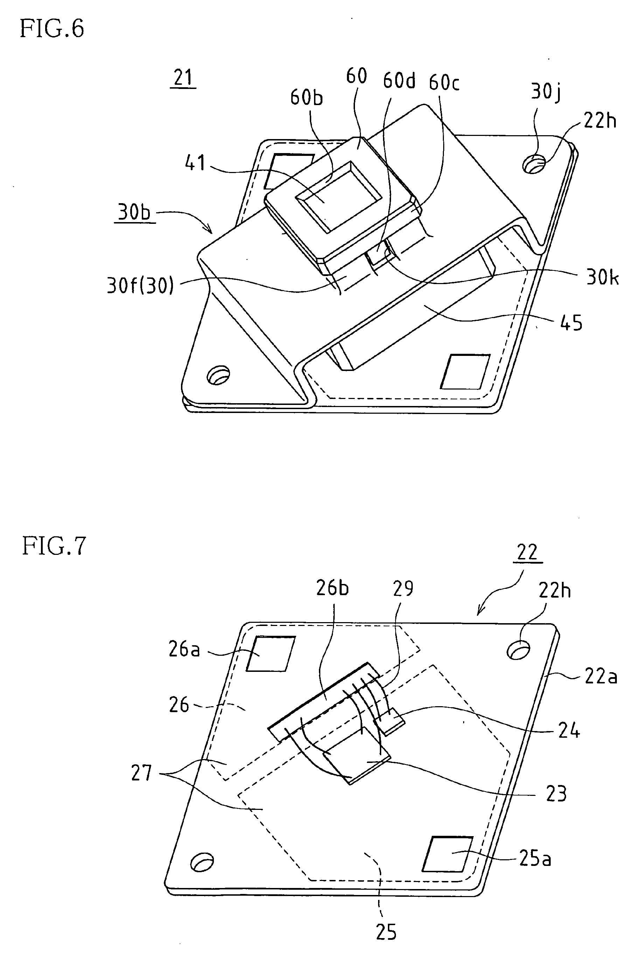

The insulation region may seal a bypass diode 24 and wires 29 (see FIG. 7) that are provided in the periphery of the solar cell element 23, a wiring member and a first connection pattern 25 (see the same drawing) and a second connection pattern 26 (see the same drawing). This eliminates the possibility of the occurrence of short-circuiting between output extracting terminals caused by water droplets and dust that have adhered.

The first tabular optical member 40f is disposed between the bottom recess 45d and the first adhesive portion 31, and closely attached to the first adhesive portion 31. Therefore, the first tabular optical member 40f can be positioned with ease and high accuracy, and the solar cell element 23 can be protected from the external environment.

The resin sealing portion 34 that covers the solar cell element 23 is formed between the optical member 40 (first tabular optical member 40f) and the receiver substrate 22 so as to cover the receiver substrate 22. Accordingly, it is possible to reliably protect (insulate) the solar cell element 23 and connecting members (wires 29 connecting a surface electrode of the solar cell element 23 and an extraction electrode (see FIG. 7) and the like) connected to the solar cell element 23 from the surrounding environment, and thus the reliability can be secured.

The resin sealing portion 34 may be in contact with the bottom face 40b (inner face) of the optical member 40. In other words, FIG. 1 shows a configuration in which a space region is provided between the resin sealing portion 34 and the first tabular optical member 40f, but it is also possible to employ a configuration in which the space region is completely filled with a sealing resin 34r (resin sealing portion 34).

By filling the space region with the resin sealing portion 34, the influence of gas (for example, air) present in the space region can be suppressed. In other words, by removing the gas present between the optical member 40 (first tabular optical member 40f) and the resin sealing portion 34, fluctuations in refractive index between the optical member 40 (first tabular optical member 40f) and the resin sealing portion 34 can be suppressed, and the sunlight Ls can be efficiently guided to the solar cell element 23.

The perimeter of the resin sealing portion 34 is surrounded by the first adhesive portion 31 in the shape of a frame. Accordingly, the members (for example, the solar cell element 23, the bypass diode 24, the wires 29 and the wiring member) disposed on the surface of the receiver substrate 22 within the pedestal portion 45 can be reliably covered and protected (insulated), and therefore the dielectric strength and weather resistance can be improved, thereby improving the reliability.

The solar cell 21 of the present embodiment can be incorporated in a concentrating solar power generation module 20 (see FIG. 4). In other words, it is possible to obtain a concentrating solar power generation module 20 including a concentrating lens 50 (see the same drawing) that concentrates sunlight Ls and the solar cell 21 of the present embodiment that receives the concentrated sunlight Ls and converts the sunlight into electricity. Accordingly, it is possible to obtain an inexpensive concentrating solar power generation module 20 having high heat resistance, weather resistance and reliability that reliably improves light concentrating properties over a wide wavelength region, improving the power generation efficiency and the power generation.

The receiver substrate 22 is provided with attachment holes 22h for attachment of the solar cell 21 to, for example, a concentrating solar power generation module 20.

The application of the solar cell 21 to a concentrating solar power generation module 20 will be described in detail in Embodiment 4.

A method of manufacturing the solar cell 21 according to the present embodiment will be described. A typical example of the manufacturing process will be illustrated in detail in Embodiment 4, and thus an overall description of the method is given here.

A solar cell manufacturing method according to the present embodiment is a method of manufacturing a solar cell 21 including an optical member 40 that allows concentrated sunlight Ls to pass therethrough, a solar cell element 23 that converts the sunlight Ls that has passed through the optical member 40 into electricity, a receiver substrate 22 on which the solar cell element 23 is placed, a first adhesive portion 31 that is adhered to the receiver substrate 22 and that is formed into a frame shape surrounding the solar cell element 23, a pedestal portion 45 that is in contact with the receiver substrate 22 and that is adhered to the first adhesive portion 31 so as to surround the solar cell element 23, and a resin sealing portion 34 that is surrounded by the first adhesive portion 31 and that covers the solar cell element 23.

The solar cell manufacturing method according to the present embodiment includes a first adhesive applying step of applying a first adhesive 31r that forms the first adhesive portion 31 to the receiver substrate 22, a first tabular optical member disposing step of disposing a first tabular optical member 40f that has a tabular shape and serves as the optical member 40 on the first adhesive 31r (optical member disposing step of disposing the optical member 40), a pedestal portion placing step of placing the pedestal portion 45 onto the receiver substrate 22 by adhering the pedestal portion 45 to the first adhesive 31r, a first heat curing step of forming the first adhesive portion 31 by heating the first adhesive 31r, and a sealing resin injecting step of injecting a sealing resin 34r that resin-seals the solar cell element 23 into an interior region of the first adhesive portion 31.

Accordingly, because the first adhesive applying step, the first tabular optical member disposing step (optical member disposing step), the pedestal portion placing step and the sealing resin injecting step are performed, with the simple steps of sequentially stacking and positioning each constituent member (the first adhesive portion 31, the resin sealing portion 34, the first tabular optical member 40f (optical member 40) and the pedestal portion 45), it is possible to easily and highly accurately manufacture a solar cell 21 that has high heat resistance, weather resistance and reliability, with high productivity.

The sealing resin injecting step can be performed during the time before the first adhesive applying step or the time between the first adhesive applying step (inclusive) and the first tabular optical member disposing step (inclusive). Preferably, the sealing resin injecting step is performed after the first adhesive applying step but before the first tabular optical member disposing step.

It is preferable that the sealing resin 34r is subjected to a defoaming treatment and a heat curing treatment. In other words, the solar cell manufacturing method according to the present embodiment includes a defoaming treatment step of performing a defoaming treatment on the sealing resin 34r and a second heat curing step of thermally curing the sealing resin 34r by heating the sealing resin 34r. Accordingly, a highly reliable resin sealing portion 34 can be formed easily and highly accurately.

### Embodiment 2

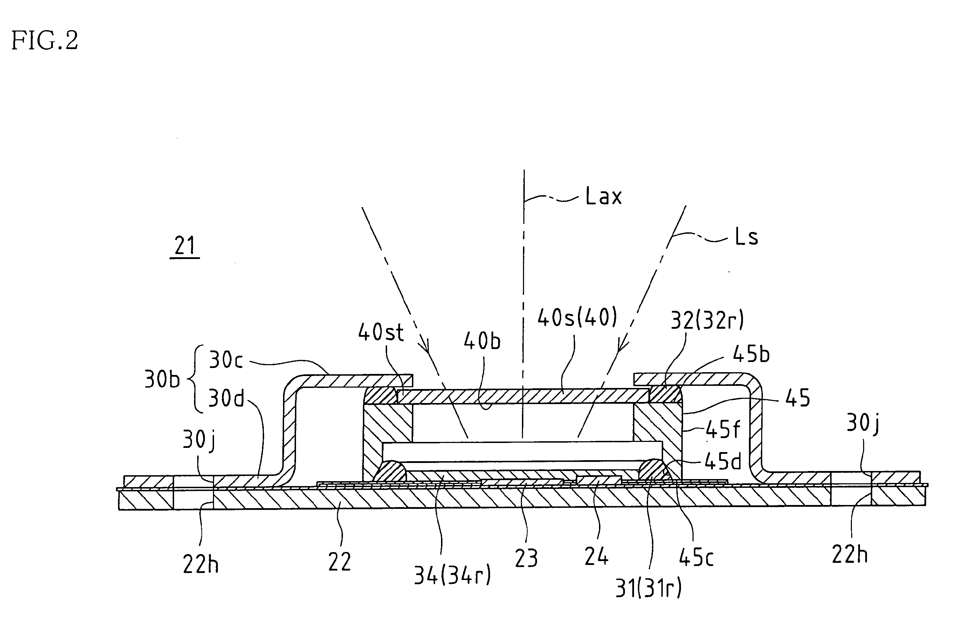

A solar cell according to the present embodiment and a method of manufacturing the solar cell will be described with reference to FIG. 2. The basic configuration of the solar cell of the present embodiment is the same as that of the solar cell 21 of Embodiment 1, which is thus referred to as appropriate to omit redundant description, and differences will mainly be described here.

FIG. 2 is a cross-sectional view schematically showing a cross-sectional state of a schematic configuration of a solar cell according to Embodiment 2 of the present invention.

A solar cell 21 according to the present embodiment includes an optical member 40 (second tabular optical member 40s) that allows concentrated sunlight Ls to pass therethrough, a solar cell element 23 that converts the sunlight Ls that has passed through the optical member 40 into electricity, and a receiver substrate 22 on which the solar cell element 23 is placed.

The solar cell 21 includes a first adhesive portion 31 that is adhered to the receiver substrate 22 and that is formed into a frame shape surrounding the solar cell element 23, a pedestal portion 45 that is in contact with the receiver substrate 22 and that is adhered to the first adhesive portion 31 so as to surround the solar cell element 23, and a resin sealing portion 34 that is surrounded by the first adhesive portion 31 and that covers the solar cell element 23.

Accordingly, the first adhesive portion 31 and the pedestal portion 45 are stacked on the receiver substrate 22 and the solar cell element 23 in the stacking direction and connected, and it is thus possible to easily and highly accurately position the resin sealing portion 34 and the optical member 40 (second tabular optical member 40s) relative to the solar cell element 23 in the plane direction and stacking direction (height direction) corresponding to the optical axis Lax, to effectively direct the concentrated sunlight Ls to the solar cell element 23, and to insulate the solar cell element 23 from the outside, thereby preventing the influence on the solar cell element due to extraneous matter entering from the outside. Consequently, it is possible to obtain a solar cell 21 that has improved power generation efficiency and power generation, as well as improved heat resistance, weather resistance and reliability, and that can be manufactured with high productivity.

In other words, in the solar cell 21 of the present embodiment, it is possible to, for example, position and stack the receiver substrate 22, the solar cell element 23, the first adhesive portion 31, the pedestal portion 45 and the optical member 40 in the plane direction and stacking direction corresponding to the optical axis Lax.

The pedestal portion 45 is adhered to the receiver substrate 22 by the first adhesive portion 31 disposed between a bottom recess 45d formed in the bottom face 45c of the pedestal portion 45 and the receiver substrate 22.

The solar cell 21 of the present embodiment includes a second adhesive portion 32 formed on the top 45b of the pedestal portion 45, and also includes a pedestal covering portion 30b including a beam-shaped flange portion 30c that is adhered to the second adhesive portion 32 and that extends in a direction parallel to the receiver substrate 22 and a coupling flange portion 30d that extends outwardly from the beam-shaped flange portion 30c and that is connected to the receiver substrate 22 outside the pedestal portion 45.

Accordingly, it is possible to easily and highly accurately position the second adhesive portion 32 and the pedestal covering portion 30b relative to the receiver substrate 22, the solar cell element 23, the first adhesive portion 31 and the pedestal portion 45 in the plane direction and the stacking direction, enabling the pedestal portion 45 to be fixed by the second adhesive portion 32 and the pedestal covering portion 30b (beam-shaped flange portion 30c and coupling flange portion 30d) and to be protected from the environment by the pedestal covering portion 30b. Accordingly, a highly reliable solar cell 21 having improved physical strength of the pedestal portion 45 can be obtained.

The optical member 40 is a second tabular optical member 40s having a tabular shape, and the second tabular optical member 40s is placed on the top 45b of the pedestal portion 45 in the stacking direction with its perimeter edge 40st covered with the beam-shaped flange portion 30c. Accordingly, the optical member 40 (second tabular optical member 40s) can be easily and highly accurately placed and positioned relative to the pedestal portion 45 in the plane direction and the stacking direction. Also, the optical member 40 is horizontally disposed in an interior region of a perimeter frame 45f of the pedestal portion 45, and it is thus possible to highly accurately position the optical member 40 relative to the pedestal portion 45.

The resin sealing portion 34 that covers the solar cell element 23 is formed between the optical member 40 (second tabular optical member 40s) and the receiver substrate 22 so as to cover the receiver substrate 22. Accordingly, it is possible to reliably protect (insulate) the solar cell element 23 and connecting members (wires 29 connecting a surface electrode of the solar cell element 23 and an extraction electrode (see FIG. 7) and the like) connected to the solar cell element 23 from the surrounding environment, and thus the reliability can be secured.

The resin sealing portion 34 may be in contact with the bottom face 40b (inner face) of the optical member 40. In other words, FIG. 2 shows a configuration in which a space region is provided between the resin sealing portion 34 and the second tabular optical member 40s, but it is also possible to employ a configuration in which the space region is completely filled with a sealing resin 34r (resin sealing portion 34).

By filling the space region with the resin sealing portion 34, the influence of gas (for example, air) present in the space region can be suppressed. In other words, by removing the gas present between the optical member 40 (second tabular optical member 40s) and the resin sealing portion 34, fluctuations in refractive index between the optical member 40 (second tabular optical member 40s) and the resin sealing portion 34 can be suppressed, and the sunlight Ls can be efficiently guided to the solar cell element 23.

The perimeter of the resin sealing portion 34 is surrounded by the first adhesive portion 31 in the shape of a frame. Accordingly, the members (for example, the solar cell element 23, a bypass diode 24, the wires 29 and the wiring member) disposed on the surface of the receiver substrate 22 within the pedestal portion 45 can be reliably covered and protected, and therefore the dielectric strength and weather resistance can be improved, thereby improving the reliability.

In the coupling flange portion 30d, pedestal covering portion attachment holes 30j aligned with the attachment holes 22h are formed. Accordingly, the pedestal covering portion 30b (coupling flange portion 30d) can be easily and highly accurately positioned relative to the receiver substrate 22.

The solar cell 21 of the present embodiment can be incorporated in a concentrating solar power generation module 20 (see FIG. 4). The manner of application is the same as in Embodiment 1, and a detailed description will be given in Embodiment 4.

A method of manufacturing the solar cell 21 according to the present embodiment will be described. A typical example of the manufacturing process will be illustrated in detail in Embodiment 4, and thus an overall description of the method is given here.

The solar cell manufacturing method according to the present embodiment is a method of manufacturing a solar cell 21 including an optical member 40 that allows concentrated sunlight Ls to pass therethrough, a solar cell element 23 that converts the sunlight Ls that has passed through the optical member 40 into electricity, a receiver substrate 22 on which the solar cell element 23 is placed, a first adhesive portion 31 that is adhered to the receiver substrate 22 and that is formed into a frame shape surrounding the solar cell element 23, a pedestal portion 45 that is in contact with the receiver substrate 22 and that is adhered to the first adhesive portion 31 so as to surround the solar cell element 23, a second adhesive portion 32 formed on the top 45b of the pedestal portion 45, and a resin sealing portion 34 that is surrounded by the first adhesive portion 31 and that covers the solar cell element 23, and also includes a pedestal covering portion 30b including a beam-shaped flange portion 30c that is adhered to the second adhesive portion 32 and that extends in a direction parallel to the receiver substrate 22 and a coupling flange portion 30d that extends outwardly from the beam-shaped flange portion 30c and that is connected to the receiver substrate 22 outside the pedestal portion 45.

The solar cell manufacturing method according to the present embodiment includes a first adhesive applying step of applying a first adhesive 31r that forms the first adhesive portion 31 to the receiver substrate 22, a pedestal portion placing step of placing the pedestal portion 45 onto the receiver substrate 22 by adhering the pedestal portion 45 to the first adhesive 31r, a second adhesive applying step of applying a second adhesive 32r that forms the second adhesive portion 32 to the top 45b of the pedestal portion 45, a second tabular optical member disposing step of disposing a second tabular optical member 40s that has a tabular shape and serves as the optical member 40 on the top 45b of the pedestal portion 45 (optical member disposing step of disposing the optical member 40), a pedestal covering portion placing step of placing the pedestal covering portion 30b onto the receiver substrate 22 by adhering the pedestal covering portion 30b to the second adhesive 32r, a first heat curing step of forming the first adhesive portion 31 and the second adhesive portion 32 by heating the first adhesive 31r and the second adhesive 32r, and a sealing resin injecting step of injecting a sealing resin 34r that resin-seals the solar cell element 23 into an interior region of the first adhesive portion 31.

Accordingly, because the first adhesive applying step, the pedestal portion placing step, the second adhesive applying step, the second tabular optical member disposing step (optical member disposing step), the pedestal covering portion placing step and the sealing resin injecting step are performed, with the simple steps of sequentially stacking and positioning each constituent member (the first adhesive portion 31, the pedestal portion 45, the second adhesive portion 32, the resin sealing portion 34, the second tabular optical member 40s (optical member 40) and the pedestal covering portion 30b), it is possible to easily and highly accurately manufacture a solar cell 21 that has high heat resistance, weather resistance and reliability, with high productivity.

The sealing resin injecting step can be performed during the time before the first adhesive applying step or the time between the first adhesive applying step (inclusive) and the second tabular optical member disposing step (inclusive). Preferably, the sealing resin injecting step is performed after the first adhesive portion 31 has been formed in the first heat curing step but before the second tabular optical member disposing step.

### Embodiment 3

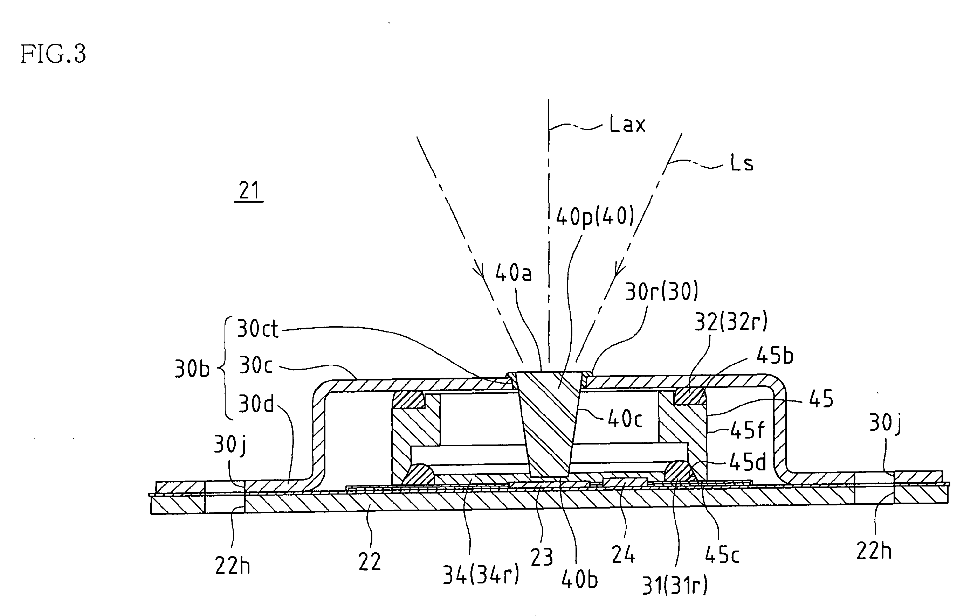

A solar cell according to the present embodiment and a method of manufacturing the solar cell will be described with reference to FIG. 3. The basic configuration of the solar cell of the present embodiment is the same as that of the solar cells 21 of Embodiments 1 and 2, which is thus referred to as appropriate to omit redundant description, and differences will mainly be described here.

FIG. 3 is a cross-sectional view schematically showing a cross-sectional state of a schematic configuration of a solar cell according to Embodiment 3 of the present invention.

A solar cell 21 according to the present embodiment includes an optical member 40 (columnar optical member 40p) that allows concentrated sunlight Ls to pass therethrough, a solar cell element 23 that converts the sunlight Ls that has passed through the optical member 40 into electricity and a receiver substrate 22 on which the solar cell element 23 is placed.

The solar cell 21 includes a first adhesive portion 31 that is adhered to the receiver substrate 22 and that is formed into a frame shape surrounding the solar cell element 23, a pedestal portion 45 that is in contact with the receiver substrate 22 and that is adhered to the first adhesive portion 31 so as to surround the solar cell element 23, and a resin sealing portion 34 that is surrounded by the first adhesive portion 31 and that covers the solar cell element 23.

Accordingly, the first adhesive portion 31 and the pedestal portion 45 are stacked on the receiver substrate 22 and the solar cell element 23 in the stacking direction and connected, and it is thus possible to easily and highly accurately position the resin sealing portion 34 and the optical member 40 (columnar optical member 40p) relative to the solar cell element 23 in the plane direction and stacking direction (height direction) corresponding to the optical axis Lax, to effectively direct the concentrated sunlight Ls to the solar cell element 23, and to insulate the solar cell element 23 from the outside, thereby preventing the influence on the solar cell element due to extraneous matter entering from the outside. Consequently, it is possible to obtain a solar cell 21 that has improved power generation efficiency and power generation, as well as improved heat resistance, weather resistance and reliability, and that can be manufactured with high productivity.

In other words, in the solar cell 21 of the present embodiment, it is possible to, for example, sequentially stack and position the receiver substrate 22, the solar cell element 23, the first adhesive portion 31, the pedestal portion 45 and the optical member 40 in the plane direction and stacking direction corresponding to the optical axis Lax.

The solar cell 21 of the present embodiment includes a second adhesive portion 32 formed on the top 45b of the pedestal portion 45, and also includes a pedestal covering portion 30b including a beam-shaped flange portion 30c that is adhered to the second adhesive portion 32 and that extends in a direction parallel to the receiver substrate 22 and a coupling flange portion 30d that extends outwardly from the beam-shaped flange portion 30c and that is connected to the receiver substrate 22 outside the pedestal portion 45.

Accordingly, it is possible to easily and highly accurately position the second adhesive portion 32 and the pedestal covering portion 30b relative to the receiver substrate 22, the solar cell element 23, the first adhesive portion 31 and the pedestal portion 45 in the plane direction and the stacking direction, enabling the pedestal portion 45 to be fixed by the second adhesive portion 32 and the pedestal covering portion 30b (beam-shaped flange portion 30c and coupling flange portion 30d) and to be protected from the environment by the pedestal covering portion 30b. Accordingly, a highly reliable solar cell 21 having improved physical strength of the pedestal portion 45 can be obtained.

The optical member 40 is a columnar optical member 40p having a columnar shape with its top face 40a larger than its bottom face 40b, and the columnar optical member 40p is fixed by a fixing portion 30 (fitting/fixing portion 30r) at the inner edge of the beam-shaped flange portion 30c.

Accordingly, it is possible to easily and highly accurately position the optical member 40 (columnar optical member 40p) relative to the pedestal portion 45 and the beam-shaped flange portion 30c in the plane direction and the stacking direction, enabling the columnar optical member 40p to be easily and highly accurately positioned relative to the solar cell element 23.

The bottom face 40b of the columnar optical member 40p has an area corresponding to the solar cell element 23, for example, an area corresponding to the effective light-receiving area of the solar cell element 23. In other words, with the bottom face 40b having the same area as the effective light-receiving area of the solar cell element 23, unnecessary sunlight Ls irradiation can be prevented, as a result of which a temperature increase due to solar energy can be prevented and the power generation efficiency can be improved.

The top face 40a of the columnar optical member 40p has an area larger than that of the bottom face 40b, and it is therefore possible to cause concentrated sunlight Ls to reliably enter the columnar optical member 40p.

Also, the optical member 40 (columnar optical member 40p) is horizontally disposed in an interior region of a perimeter frame 45f of the pedestal portion 45, and it is thus possible to highly accurately position the optical member 40 relative to the pedestal portion 45. Specifically, the optical member 40 (columnar optical member 40p) is positioned relative to the fitting/fixing portion 30r (fixing portion 30), the fitting/fixing portion 30r is positioned relative to the beam-shaped flange portion 30c (pedestal covering portion 30b), and the beam-shaped flange portion 30c is positioned relative to the pedestal portion 45 (receiver substrate 22).

Accordingly, the fixing portion 30 (fitting/fixing portion 30r) fixes the optical member 40 with respect to the pedestal portion 45. In other words, the solar cell 21 includes the fixing portion 30 (fitting/fixing portion 30r) that fixes the optical member 40 with respect to the pedestal portion 45.

In the solar cell 21 of the present embodiment, the fixing portion 30 is the fitting/fixing portion 30r that is fitted to an inner edge frame 30ct of the beam-shaped flange portion 30c and that fixes the columnar optical member 40p. Accordingly, the columnar optical member 40p can be easily and highly accurately adhered and fixed to the beam-shaped flange portion 30c.

The inner perimeter of the fitting/fixing portion 30r has been tapered in advance to face to an optical path inclined face 40c of the columnar optical member 40p, and it is therefore possible to position the columnar optical member 40p relative to the fitting/fixing portion 30r in a self aligned manner. The fitting/fixing portion 30r can be a molding prepared in advance using an appropriate a synthetic resin, which is fitted to the inner edge frame 30ct.

The resin sealing portion 34 that covers the solar cell element 23 is formed between the optical member 40 (columnar optical member 40p) and the receiver substrate 22 so as to cover the receiver substrate 22. The resin sealing portion 34 is in contact with the bottom face 40b of the optical member 40 (columnar optical member 40p). In other words, the space region between the resin sealing portion 34 and the columnar optical member 40p (bottom face 40b) is completely filled with a sealing resin 34r (resin sealing portion 34).

Accordingly, fluctuations in refractive index due to the gas (for example, air) present in the space region between the optical member 40 (columnar optical member 40p) and the resin sealing portion 34 can be prevented, and therefore the sunlight Ls can be efficiently guided to the solar cell element 23.

The solar cell 21 of the present embodiment can be incorporated in a concentrating solar power generation module 20 (see FIG. 4). The manner of application of the solar cell 21 to a concentrating solar power generation module 20 is the same as in Embodiments 1 and 2, and a detailed description will be given in Embodiment 4.

A method of manufacturing the solar cell 21 according to the present embodiment will be described. A typical example of the manufacturing process will be illustrated in detail in Embodiment 4, and thus an overall description of the method is given here.

The solar cell manufacturing method according to the present embodiment is a method of manufacturing a solar cell 21 including an optical member 40 that allows concentrated sunlight Ls to pass therethrough, a solar cell element 23 that converts the sunlight Ls that has passed through the optical member 40 into electricity, a receiver substrate 22 on which the solar cell element 23 is placed, a first adhesive portion 31 that is adhered to the receiver substrate 22 and that is formed into a frame shape surrounding the solar cell element 23, a pedestal portion 45 that is in contact with the receiver substrate 22 and that is adhered to the first adhesive portion 31 so as to surround the solar cell element 23, a second adhesive portion 32 formed on the top 45b of the pedestal portion 45, a resin sealing portion 34 that is surrounded by the first adhesive portion 31 and that covers the solar cell element 23, the solar cell 21 also including a pedestal covering portion 30b including a beam-shaped flange portion 30c that is adhered to the second adhesive portion 32 and that extends in a direction parallel to the receiver substrate 22 and a coupling flange portion 30d that extends outwardly from the beam-shaped flange portion 30c and that is connected to the receiver substrate 22 outside the pedestal portion 45, and a fixing portion 30 (fitting/fixing portion 30r) that fixes a columnar optical member 40p that has a columnar shape and that serves as the optical member 40.

The solar cell manufacturing method according to the present embodiment includes a first adhesive applying step of applying a first adhesive 31r that forms the first adhesive portion 31 to the receiver substrate 22, a pedestal portion placing step of placing the pedestal portion 45 onto the receiver substrate 22 by adhering the pedestal portion 45 to the first adhesive 31r, a second adhesive applying step of applying a second adhesive 32r that forms the second adhesive portion 32 to the top 45b of the pedestal portion 45, a pedestal covering portion placing step of placing the pedestal covering portion 30b onto the receiver substrate 22 by adhering the pedestal covering portion 30b to the second adhesive 32r, a first heat curing step of forming the first adhesive portion 31 and the second adhesive portion 32 by heating the first adhesive 31r and the second adhesive 32r, a fitting/fixing portion disposing step of disposing a fitting/fixing portion 30r serving as the fixing portion 30 in an inner edge frame 30ct of the beam-shaped flange portion 30c (also referred to as a fixing portion disposing step of disposing the fixing portion 30), a columnar optical member disposing step of disposing a columnar optical member 40p that has a columnar shape and that serves as the optical member 40 by fixing the columnar optical member 40p to a fitting/fixing portion 30r (an optical member disposing step of disposing the optical member 40), and a sealing resin injecting step of injecting a sealing resin 34r that resin-seals the solar cell element 23 into an interior region of the first adhesive portion 31.

Accordingly, because the first adhesive applying step, the pedestal portion placing step, the second adhesive applying step, the pedestal covering portion placing step, the fitting/fixing portion disposing step (fixing portion disposing step), the columnar optical member disposing step (optical member disposing step) and the sealing resin injecting step are performed, with the simple steps of sequentially stacking and positioning each constituent member (the first adhesive portion 31, the pedestal portion 45, the second adhesive portion 32, the pedestal covering portion 30b, the fitting/fixing portion 30r, the resin sealing portion 34 and the columnar optical member 40p (optical member 40)), it is possible to easily and highly accurately manufacture a solar cell 21 having high heat resistance, weather resistance and reliability.

The sealing resin injecting step can be performed during before the time the first adhesive applying step or the time between the first adhesive applying step (inclusive) and the columnar optical member disposing step (inclusive). Preferably, the sealing resin injecting step is performed after the first adhesive portion 31 has been formed in the first heat curing step but before the columnar optical member disposing step. After the sealing resin injecting step, a defoaming treatment step of performing a defoaming treatment on the sealing resin 34r and a second heat curing step of thermally curing the sealing resin 34r by heating the sealing resin 34r can be performed.

It is also possible to cure the first adhesive 31r and the second adhesive 32r separately. In other words, only the first adhesive portion 31 may be formed in the first heat curing step.

The solar cell manufacturing method according to the present embodiment is also a method of manufacturing a solar cell 21 including an optical member 40 that allows concentrated sunlight Ls to pass therethrough, a solar cell element 23 that converts the sunlight Ls that has passed through the optical member 40 into electricity, a receiver substrate 22 on which the solar cell element 23 is placed, a first adhesive portion 31 that is adhered to the receiver substrate 22 and that is formed into a frame shape surrounding the solar cell element 23, a pedestal portion 45 that is in contact with the receiver substrate 22 and that is adhered to the first adhesive portion 31 so as to surround the solar cell element 23, and a fixing portion 30 (fitting/fixing portion 30r) that fixes the optical member 40 with respect to the pedestal portion 45.

In other words, the solar cell manufacturing method according to the present embodiment includes a first adhesive applying step of applying a first adhesive 31r that forms the first adhesive portion 31 to the receiver substrate 22, a pedestal portion placing step of placing the pedestal portion 45 onto the receiver substrate 22 by adhering the pedestal portion 45 to the first adhesive 31r, a first heat curing step of forming the first adhesive portion 31 by heating the first adhesive 31r, and an optical member disposing step of disposing the optical member 40 (columnar optical member 40p) in the fixing portion 30 (fitting/fixing portion 30r).

Accordingly, with simple steps of sequentially stacking and positioning each constituent member (the first adhesive portion 31, the pedestal portion 45 and the optical member 40 (columnar optical member 40p)) by performing the first adhesive applying step, the pedestal portion placing step, the first heat curing step and the optical member disposing step, it is possible to easily and highly accurately manufacture a solar cell 21 that has high heat resistance, weather resistance and reliability, with high productivity.

### Embodiment 4

A solar cell and a concentrating solar power generation module according to the present embodiment will be described with reference to FIGS. 4 to 13. Firstly, the overall configuration will be described with reference to FIGS. 4 to 6, and the constituent elements will be described sequentially with reference to FIGS. 7 to 13. The basic configuration of the solar cell of the present embodiment is the same as that of the solar cells 21 of Embodiments 1 to 3, which is thus referred to as appropriate to omit redundant description, and differences will mainly be described here.

FIG. 4 is a cross-sectional view schematically showing a cross-sectional state of a schematic configuration of a solar cell and a concentrating solar power generation module according to Embodiment 4 of the present invention.

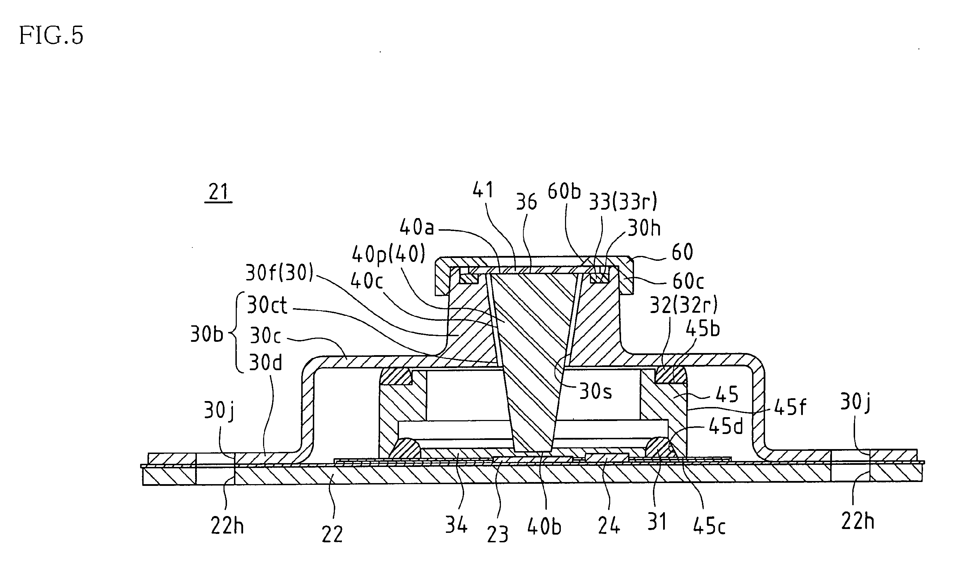

FIG. 5 is an enlarged cross-sectional view showing a cross-sectional state of an enlarged schematic configuration of the solar cell shown in FIG. 4.

FIG. 6 is a perspective plan view showing the schematic configuration of the solar cell shown in FIG. 4.

A solar cell 21 according to the present embodiment includes an optical member 40 (columnar optical member 40p) that allows sunlight Ls concentrated by a concentrating lens 50 to pass therethrough, a solar cell element 23 that converts the sunlight Ls that has passed through the optical member 40 into electricity, and a receiver substrate 22 on which the solar cell element 23 is placed.

The solar cell 21 also includes a first adhesive portion 31 that is adhered to the receiver substrate 22 and that is formed into a frame shape surrounding the solar cell element 23, a pedestal portion 45 that is in contact with the receiver substrate 22 and that is adhered to the first adhesive portion 31 so as to surround the solar cell element 23, and a resin sealing portion 34 that is surrounded by the first adhesive portion 31 and that covers the solar cell element 23.

Accordingly, the first adhesive portion 31 and the pedestal portion 45 are stacked on the receiver substrate 22 and the solar cell element 23 in the stacking direction and connected, and it is thus possible to easily and highly accurately position the resin sealing portion 34 and the optical member 40 (columnar optical member 40p) relative to the solar cell element 23 in the plane direction and stacking direction (height direction) corresponding to the optical axis Lax, to effectively direct the concentrated sunlight Ls to the solar cell element 23, and to insulate the solar cell element 23 from the outside, thereby preventing the influence on the solar cell element due to extraneous matter entering from the outside. Consequently, it is possible to obtain a solar cell 21 that has improved power generation efficiency and power generation, as well as improved heat resistance, weather resistance and reliability, and that can be manufactured with high productivity.

The pedestal portion 45 is adhered to the receiver substrate 22 by the first adhesive portion 31 disposed between a bottom recess 45d formed in the bottom face 45c of the pedestal portion 45 and the receiver substrate 22. In other words, the first adhesive portion 31 is formed between the bottom recess 45d of the pedestal portion 45 and the receiver substrate 22. Accordingly, the pedestal portion 45 and the receiver substrate 22 can be adhered and fixed to each other via the first adhesive portion 31 with high accuracy.

It is preferable to form the pedestal portion 45 so as to have a frame shape similar to the first adhesive portion 31, but the configuration is not limited thereto, and the pedestal portion 45 may have a four-leg structure, for example. That is to say, the pedestal portion 45 can have any structure as long as it is sufficiently adhered to the first adhesive portion 31 and is stably fixed to the receiver substrate 22.

The solar cell 21 of the present embodiment includes a second adhesive portion 32 formed on the top 45b of the pedestal portion 45, and also includes a pedestal covering portion 30b including a beam-shaped flange portion 30c that is adhered to the second adhesive portion 32 and that extends in a direction parallel to the receiver substrate 22 and a coupling flange portion 30d that extends outwardly from the beam-shaped flange portion 30c and that is connected to the receiver substrate 22 outside the pedestal portion 45.

Accordingly, it is possible to easily and highly accurately position the second adhesive portion 32 and the pedestal covering portion 30b relative to the receiver substrate 22, the solar cell element 23, the first adhesive portion 31 and the pedestal portion 45 in the plane direction and the stacking direction, enabling the pedestal portion 45 to be fixed by the second adhesive portion 32 and the pedestal covering portion 30b (beam-shaped flange portion 30c and coupling flange portion 30d) and to be protected from the environment by the pedestal covering portion 30b. Accordingly, a highly reliable solar cell 21 having improved physical strength of the pedestal portion 45 can be obtained.

The optical member 40 is a columnar optical member 40p having a columnar shape with its top face 40a larger than its bottom face 40b, and the columnar optical member 40p is fixed by a fixing portion 30 (upright fixing portion 30f) at the inner edge of the beam-shaped flange portion 30c.

Accordingly, it is possible to easily and highly accurately position the optical member 40 (columnar optical member 40p) relative to the pedestal portion 45 and the beam-shaped flange portion 30c in the plane direction and the stacking direction, enabling the columnar optical member 40p to be easily and highly accurately positioned relative to the solar cell element 23.

Also, the optical member 40 (columnar optical member 40p) is horizontally disposed in an interior region of a perimeter frame 45f of the pedestal portion 45, and it is thus possible to highly accurately position the optical member 40 relative to the pedestal portion 45. Specifically, the optical member 40 (columnar optical member 40p) is positioned relative to the upright fixing portion 30f (fixing portion 30), the upright fixing portion 30f is positioned relative to the beam-shaped flange portion 30c (pedestal covering portion 30b), and the beam-shaped flange portion 30c is positioned relative to the pedestal portion 45 (receiver substrate 22).

Accordingly, the fixing portion 30 (upright fixing portion 30f) fixes the optical member 40 with respect to the pedestal portion 45. In other words, the solar cell 21 includes the fixing portion 30 (upright fixing portion 30f) that fixes the optical member 40 with respect to the pedestal portion 45.

In the solar cell 21 of the present embodiment, the fixing portion 30 is the upright fixing portion 30f that is provided upright at the inner edge frame 30ct of the beam-shaped flange portion 30c and that includes a through inclined face 30s that allows the columnar optical member 40p to pass through and that faces the columnar optical member 40p. Accordingly, the columnar optical member 40p can be easily and highly accurately positioned and fixed to the beam-shaped flange portion 30c (upright fixing portion 30f) in the plane direction and the stacking direction.

The solar cell 21 includes a translucent protective plate 41 that is fixed to the upright fixing portion 30f so as to cover the top face 40a of the columnar optical member 40p. Accordingly, the translucent protective plate 41 can be easily and highly accurately positioned and fixed to the columnar optical member 40p in the plane direction and the stacking direction, and it is therefore possible to efficiently guide the sunlight Ls to the columnar optical member 40p and to insulate the gap between the columnar optical member 40p and the upright fixing portion 30f from the outside. Consequently, the solar cell element 23 and the columnar optical member 40p can be reliably protected from the external environment, and it is therefore possible to obtain a solar cell 21 having improved reliability.

The translucent protective plate 41 is adhered to a third adhesive portion 33 formed on the top 30h of the upright fixing portion 30f. Accordingly, the translucent protective plate 41 can be easily and highly accurately positioned relative to upright fixing portion 30f in the plane direction and the stacking direction, and the translucent protective plate 41 and the upright fixing portion 30f can be fixed without a gap, and it is therefore possible to insulate the columnar optical member 40p from the external environment and prevent the influence of extraneous matter.

The solar cell 21 also includes a cap 60 that is connected to the upright fixing portion 30f and that has a window frame 60b covering the perimeter edge of the translucent protective plate 41. Accordingly, the cap 60 can be easily and highly accurately positioned and fixed to the translucent protective plate 41 in the plane direction and the stacking direction, and it is therefore possible to obtain a solar cell 21 with improved reliability in which the translucent protective plate 41 is fixed, the perimeter edge of the top 30h of the upright fixing portion 30f is protected, and thereby the mechanical strength of the translucent protective plate 41 is secured.

The cap 60 (see FIG. 6) is coupled by a latching portion 60d extending from its frame portion 60c being fitted into and latched with a latching recess 30k formed in the upright fixing portion 30f. The window frame 60b (cap 60) has a shape that shields the third adhesive portion 33 from sunlight Ls. Irradiation of the third adhesive portion 33 with sunlight Ls is thereby prevented, and thus degradation of the third adhesive portion 33 (third adhesive 33r) can be prevented.

This makes it possible to insulate the solar cell element 23 and the columnar optical member 40p from the outside, and it is therefore possible to prevent extraneous matter (rain water, dust and the like) from entering the solar cell element 23 and the columnar optical member 40p from the outside and to obtain an inexpensive solar cell 21 with high heat resistance, reliability and weather resistance in which the power generation efficiency and power generation are improved by improving light concentrating properties over a wide wavelength region by the columnar optical member 40p.

In other words, the sunlight Ls that irradiates the solar cell element 23 is guided by the columnar optical member 40p, enabling improvement of light concentrating properties over a wide wavelength region. Also, because the perimeter of the solar cell element 23 and the columnar optical member 40p is covered with the upright fixing portion 30f, the pedestal portion 45 and the translucent protective plate 41, unnecessary external influence on the solar cell element 23 and the columnar optical member 40p can be eliminated, improving the light concentrating properties and reliability.

The translucent protective plate 41 is adhered to the top face 40a of the columnar optical member 40p via a translucent adhesive layer 36. Accordingly, by removing the gap (space region) between the translucent protective plate 41 and the columnar optical member 40p, fluctuations in refractive index between the translucent protective plate 41 and the columnar optical member 40p can be suppressed, and the sunlight Ls can be efficiently guided to the solar cell element 23.

When the columnar optical member 40p is made of glass, for example, it has a refractive index n of 1.5. When the translucent protective plate 41 is made of glass, for example, it has a refractive index n of 1.5. When the translucent adhesive layer 36 is made of a silicone resin, it has a refractive index n of 1.3.

Accordingly, no significant difference occurs in refractive index between the columnar optical member 40p and the translucent adhesive layer 36 and between the translucent adhesive layer 36 and the translucent protective plate 41. Because no significant difference occurs in refractive index between the translucent protective plate 41 and columnar optical member 40p, the sunlight Ls that has entered the translucent protective plate 41 can efficiently enter the columnar optical member 40p (top face 40a). In other words, the sunlight Ls that has entered the translucent protective plate 41 can be efficiently directed to the solar cell element 23 (effective light-receiving region).

The upright fixing portion 30f is adhered to the pedestal portion 45 by a second adhesive portion 32 disposed between the top 45b of the pedestal portion 45 and the beam-shaped flange portion 30c on which the upright fixing portion 30f stands upright. In other words, the second adhesive portion 32 is formed between the top 45b of the pedestal portion 45 and the upright fixing portion 30f.

Accordingly, the upright fixing portion 30f and the pedestal portion 45 can be adhered and fixed to each other via the second adhesive portion 32 without a gap, and it is therefore possible to prevent extraneous matter from passing between the upright fixing portion 30f and the pedestal portion 45 and intruding into the solar cell element 23 and the columnar optical member 40p.

The upright fixing portion 30f holds a side face (optical path inclined faces 40c) adjacent to the top face 40a of the columnar optical member 40p with its through inclined face 30s in contact with the side face. Also, the upright fixing portion 30f is integrated with the pedestal covering portion 30b (beam-shaped flange portion 30c and coupling flange portion 30d). The second adhesive portion 32 is disposed between the pedestal covering portion 30b (beam-shaped flange portion 30c) and the pedestal portion 45.

Accordingly, heat from the upright fixing portion 30f and the pedestal portion 45 can be efficiently dissipated to the receiver substrate 22 via the pedestal covering portion 30b (coupling flange portion 30d), and the upright fixing portion 30f can be positioned and fixed to the receiver substrate 22 via the pedestal covering portion 30b, as a result of which the heat dissipation properties and physical strength can be improved.

The pedestal covering portion 30b includes the beam-shaped flange portion 30c extending from the upright fixing portion 30f and disposed in the shape of a beam and the coupling flange portion 30d disposed by being bent from the beam-shaped flange portion 30c so as to make contact with the receiver substrate 22.

Accordingly, the degree of freedom of design of the upright fixing portion 30f is improved to form the upright fixing portion 30f to have an optimal shape, and the upright fixing portion 30f (fixing portion 30) can be reliably coupled to the receiver substrate 22.

The bottom face 40b of the columnar optical member 40p has an area corresponding to the solar cell element 23, for example, an area corresponding to the effective light-receiving area of the solar cell element 23. In other words, with the bottom face 40b having the same area as the effective light-receiving area of the solar cell element 23, unnecessary sunlight Ls irradiation can be prevented, as a result of which a temperature increase due to solar energy can be prevented and the power generation efficiency can be improved.

The top face 40a of the columnar optical member 40p has an area larger than that of the bottom face 40b, and it is therefore possible to cause concentrated sunlight Ls to be reliably enter the columnar optical member 40p.

The translucent protective plate 41 is adhered to the upright fixing portion 30f by the third adhesive portion 33 disposed between the top 30h of the upright fixing portion 30f and the translucent protective plate 41. In other words, the third adhesive portion 33 is formed between the upright fixing portion 30f and the translucent protective plate 41.

Accordingly, the translucent protective plate 41 and the upright fixing portion 30f can be fixed to each other via the third adhesive portion 33 without a gap, and it is therefore possible to insulate the columnar optical member 40p from the external environment and prevent the influence of extraneous matter on the columnar optical member 40p.

The resin sealing portion 34 that covers the solar cell element 23 is formed between the optical member 40 (columnar optical member 40p) and the receiver substrate 22 so as to cover the receiver substrate 22. The resin sealing portion 34 is surrounded by the first adhesive portion 31 at the edge thereof.

Accordingly, the members (for example, the solar cell element 23, a bypass diode 24, wires 29 (see FIG. 7) and a wiring member) disposed on the surface of the receiver substrate 22 within the pedestal portion 45 (first adhesive portion 31) can be reliably covered and protected (insulated), thereby improving insulation properties and weather resistance, improving the reliability.

The resin sealing portion 34 is in contact with the bottom face 40b of the columnar optical member 40p. Specifically, the bottom face 40b (columnar optical member 40p) is embedded within the resin sealing portion 34. Accordingly, by removing the gap between the columnar optical member 40p and the resin sealing portion 34, fluctuations in refractive index between the columnar optical member 40p and the resin sealing portion 34 can be suppressed, and the sunlight Ls can be efficiently guided to the solar cell element 23.

In other words, by combining the columnar optical member 40p and the resin sealing portion 34, the sunlight Ls that has entered the top face 40a and traveled through the columnar optical member 40p toward the solar cell element 23 via the bottom face 40b can be efficiently directed to the solar cell element 23, thereby improving the power generation efficiency.

The columnar optical member 40p is made of, for example, heat resistant glass, and the bottom face 40b is embedded at a depth of, for example, 0.3 mm to 0.5 mm within the resin sealing portion 34 included in the pedestal portion 45. As a specific example, the columnar optical member 40p (for example, glass) has a refractive index n of 1.5, and the resin sealing portion 34 has a refractive index n of 1.3 in the case of the resin sealing portion 34 being made of a silicone resin.

Accordingly, the difference in refractive index of the refractive index (n=1) of air with respect to the refractive index (n=1.5) of the columnar optical member 40p becomes large, and it is therefore possible to cause the sunlight Ls that has entered the columnar optical member 40p to efficiently travel to the front end (bottom face 40b) of the columnar optical member 40p while causing the sunlight Ls to be efficiently totally reflected by the optical path inclined face 40c.

Because no significant difference occurs in refractive index between the columnar optical member 40p and the resin sealing portion 34, the sunlight Ls that has traveled to the bottom face 40b while being totally reflected within the columnar optical member 40p can be efficiently directed to the solar cell element 23 (effective light-receiving region) via the resin sealing portion 34.

In other words, by combining the resin sealing portion 34 and the columnar optical member 40p, it makes it easy to adjust the refractive index or make the refractive index uniform in the secondary optical system (a light guiding path including the columnar optical member 40p), causing the sunlight Ls concentrated by the concentrating lens 50 to efficiently enter the solar cell element 23, and consequently, the power generation efficiency of the solar cell 21 can be increased.

The coupling flange portion 30d (pedestal covering portion 30b, upright fixing portion 30f) includes pedestal covering portion attachment holes 30j formed aligned to the attachment holes 22h formed in the receiver substrate 22. Two attachment holes 22h and two pedestal covering portion attachment holes 30j are formed such that the receiver substrate 22 and the upright fixing portion 30f can be positioned in a self aligned manner.

In other words, the upright fixing portion 30f is positioned relative to the receiver substrate 22 with high accuracy and good workability, and their relative positions can be fixed by fixing members 54h (for example, rivets).

This makes it possible to easily and highly accurately position and rigidly hold the upright fixing portion 30f relative to the receiver substrate 22, and thus the columnar optical member 40p can be easily and highly accurately positioned and rigidly held relative to the solar cell element 23. Also, light concentrating properties over a wide wavelength region are improved, improving the power generation efficiency and power generation, and it is thereby possible to obtain an inexpensive solar cell 21 having high heat resistance, reliability and weather resistance.

In addition to the solar cell 21, the present embodiment also describes a concentrating solar power generation module 20 incorporating the solar cell 21 (see FIG. 4). As described above, the solar cells 21 of Embodiments 1 to 3 can be used to produce a concentrating solar power generation module 20 in the same manner as in the present embodiment.

A concentrating solar power generation module 20 of the present embodiment includes a concentrating lens 50 that concentrates sunlight Ls and a solar cell 21that receives the concentrated sunlight Ls and converts the sunlight into electricity. Accordingly, it is possible to obtain an inexpensive concentrating solar power generation module 20 having high heat resistance, reliability and weather resistance in which the power generation efficiency and the power generation are improved by improving the light concentrating properties over a wide wavelength region.

The concentrating solar power generation module 20 includes a lens frame 51 that holds the concentrating lens 50 and that positions the solar cell 21 and the concentrating lens 50 relative to each other. The concentrating lens 50 is fixed to an upper edge face of the lens frame 51 by fixing members 55t (for example, screws).

The solar cell 21 (receiver substrate 22) is fastened to a heat dissipation fin 53 by fixing members 54h passing through the attachment holes 22h and the pedestal covering portion attachment holes 30j, and the heat dissipation fin 53 is fastened to the base plate 52 by fixing members 54p (for example, screws). The base plate 52 is fixed to a frame bottom portion 51b of the lens frame 51 by fixing members 55b (for example, screws).

In other words, the solar cell 21 is fixed to the lens frame 51 (frame bottom portion 51b) via the heat dissipation fin 53 and the base plate 52. Accordingly, the concentrating lens 50 and the solar cell 21 are easily and highly accurately positioned on the optical axis Lax, and therefore the concentrated sunlight Ls can be caused to highly accurately enter the solar cell 21 via a light transmission window 51w formed in the frame bottom portion 51b of the lens frame 51.

The receiver substrate 22 is connected to and integrated with the heat dissipation fin 53 by the fixing members 54h inserted into the attachment holes 22h. The heat dissipation fin 53 has a comb-like shape. Accordingly, the heat dissipation fin 53 connected to the back face of the receiver substrate 22 enables efficient dissipation of heat generated by the concentrated sunlight Ls in the receiver substrate 22 to the outside, and therefore the power generation efficiency and reliability of the solar cell element 23 can be further improved. The heat dissipation fin 53 is made of aluminum in order to achieve weight reduction.

The concentrating lens 50 can have any shape such as a biconvex lens, a planoconvex lens or a Fresnel lens. The material of the concentrating lens 50 is preferably a material having a high transmittance at the sensitivity wavelength of light of the solar cell element 23 and weather resistance. For example, it is possible to use a white glass plate, weather resistance grade acrylic resin, polycarbonate or the like that are generally used in conventional solar power generation modules.

The material of the concentrating lens 50 is not limited to those mentioned above, and it is also possible to use a multi-layered composition of these materials. For the purpose of preventing ultraviolet degradation of the concentrating lens 50 and other members, an appropriate ultraviolet light absorber may be added to these materials.

FIG. 7 is a perspective view showing the arrangement of the solar cell element and the receiver substrate of the solar cell shown in FIG. 4.

The solar cell element 23 is disposed in a center area of the receiver substrate 22 in consideration of uniform heat dissipation. A bypass diode 24 is connected to the solar cell element 23 in parallel. The bypass diode 24 secures a current path when the solar cell element 23 acts as a resistor in the event of interception of the sunlight Ls.

In the case where the concentrating solar power generation module 20 is constructed by, for example, connecting a plurality of solar cell elements 23, the bypass diode 24 is configured so as to be capable of maintaining the power generation function as a whole even if a particular solar cell element 23 fails to perform its power generation function.

In the solar cell element 23, a PN junction, electrodes and so on are formed by a known semiconductor manufacturing process using, for example, Si, or a GaAs-based compound semiconductor. From the viewpoint of reducing the material cost by achieving reduction of the solar cell material used, the process is performed on a wafer, and the wafer is diced into chips of an approximately 4 to 6 mm square after solar cell elements 23 have been formed. The solar cell element 23 includes, as electrodes, a substrate electrode (not shown) provided on the substrate-side of the chip and a surface electrode (not shown) provided on the surface side of the chip.

The receiver substrate 22 includes, for example, a base 22a, an intermediate insulating layer laminated on the base 22a, and a first connection pattern 25 and a second connection pattern 26 that are made of copper and laminated on the intermediate insulating layer. The receiver substrate 22 also includes a surface protection layer 27 that protects the first connection pattern 25 and the second connection pattern 26.

In the surface protection layer 27 covering the first connection pattern 25, a region for a first extraction electrode 25a to which an external terminal (not shown) is connected, and regions for mounting the solar cell element 23 and the bypass diode 24 have been removed, and thus the copper (conductor) of the first connection pattern 25 is directly exposed to the outside.

Similarly, in the surface protection layer 27 covering the second connection pattern 26, a region for a second extraction electrode 26a to which an external terminal (not shown) is connected, and a region for a wire connecting portion 26b that is connected to the surface electrode of the solar cell element 23 and the surface electrode of the bypass diode 24 via wires 29 have been removed, and thus the copper (conductor) of the second connection pattern 26 is directly exposed to the outside.

The receiver substrate 22 is, for example, a 24 mm to 60 mm square when the solar cell element 23 is, for example, an approximately 4 mm to 6 mm square. The receiver substrate 22 has a thickness of, for example, approximately 0.6 mm to 3 mm in consideration of heat dissipation properties. The base 22a is made of, for example, aluminum or a ceramic material so as to improve heat dissipation properties and achieve weight reduction.

A pair of attachment holes 22h formed diagonally in the receiver substrate 22 has a positioning function when the receiver substrate 22 is set on each manufacturing apparatus (not shown) in the subsequent process, in addition to the fixing function described above.

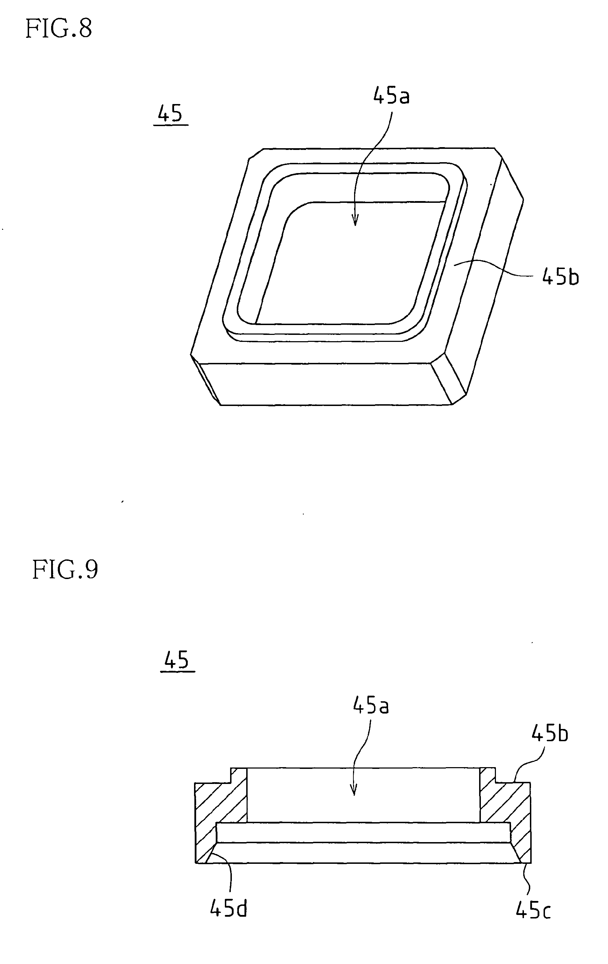

FIG. 8 is a perspective view showing a schematic configuration of the pedestal portion of the solar cell shown in FIG. 4.

FIG. 9 is a cross-sectional view showing a cross-sectional state of the pedestal portion shown in FIG. 8.

The pedestal portion 45 has a bottom recess 45d formed in the bottom face 45c that makes contact with the receiver substrate 22. The bottom recess 45d is formed by, for example, chamfering inside edges of the frame-shaped bottom face of the pedestal portion 45.

As described above, the pedestal portion 45 is adhered to the receiver substrate 22 by the first adhesive portion 31 filled into the bottom recess 45d. Accordingly, the pedestal portion 45 can be easily and highly accurately fixed (adhered) to the receiver substrate 22 with good workability.

The pedestal portion 45 is formed into a frame shape so as to form a through opening 45a for including the columnar optical member 40p, and has a frame-shaped top 45b that faces the beam-shaped flange portion 30c. The top 45b is provided with a step, and the outside edge of the top face of the pedestal portion 45 has been cut out, so that the second adhesive portion 32 can be highly accurately positioned and formed. As described above, the pedestal portion 45 is adhered to the beam-shaped flange portion 30c by the second adhesive portion 32 filled (formed) in the top 45b.

Accordingly, the receiver substrate 22 and the pedestal portion 45, as well as the pedestal portion 45 and the beam-shaped flange portion 30, are securely sealed together without a gap. The beam-shaped flange portion 30c is reliably and rigidly fixed because it is adhered to the pedestal portion 45 by the second adhesive portion 32.

The pedestal portion 45 has a frame shape that includes the solar cell element 23, the bypass diode 24 and the wire connecting portion 26b, with each side measuring 18 mm to 20 mm and with a thickness (height) of approximately 8 mm. The pedestal portion 45 shown here has a frame shape, but as described above, it may have a four-leg structure in which the four legs are brought into contact with the receiver substrate 22, for example.

There is a possibility that the pedestal portion 45 might come into contact with the first connection pattern 25 and the second connection pattern 26 that function as external electrodes and that are disposed on the surface of the receiver substrate 22, and it is therefore necessary to prevent current from flowing between the first connection pattern 25 and the second connection pattern 26 through the pedestal portion 45. Accordingly, the pedestal portion 45 is made of an insulation resin such as polycarbonate.

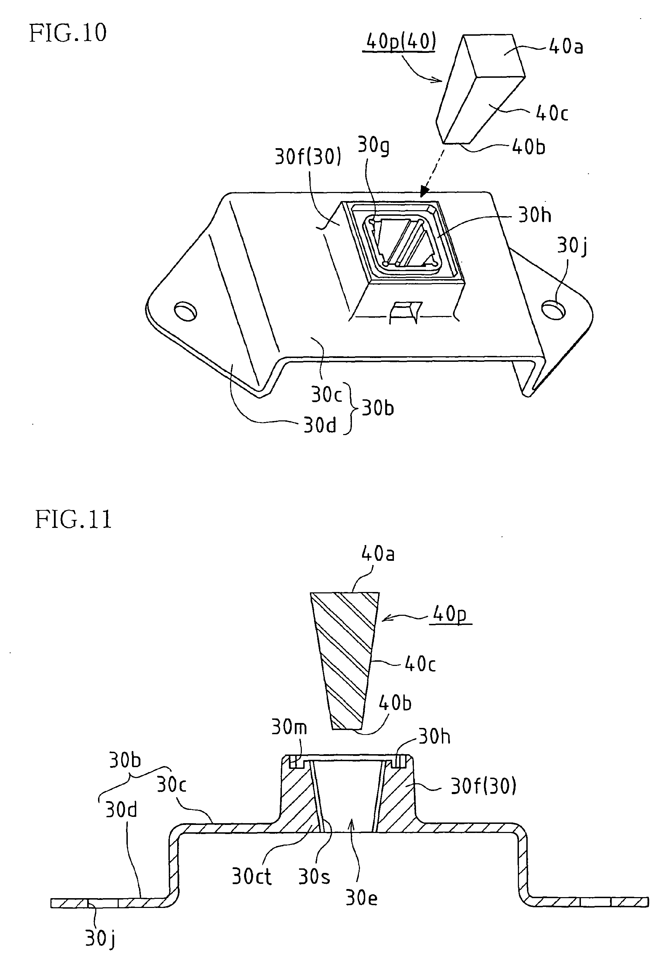

FIG. 10 is a perspective view showing a schematic configuration of the pedestal covering portion, the fixing portion and the columnar optical member of the solar cell shown in FIG. 4.

FIG. 11 is a cross-sectional view showing a cross-sectional state of the pedestal covering portion, the fixing portion and the columnar optical member shown in FIG. 10.

The pedestal covering portion 30b includes a beam-shaped flange portion 30c and a coupling flange portion 30d, and an upright fixing portion 30f serving as the fixing portion 30 is formed at the leading edge (inner edge frame 30ct) of the beam-shaped flange portion 30c.

In other words, the upright fixing portion 30f is connected to the pedestal covering portion 30b (beam-shaped flange portion 30c, coupling flange portion 30d), and thus is fixed to the receiver substrate 22 in a mechanically stable manner. Accordingly, the influence of the position of the center of gravity of the columnar optical member 40p can be eliminated, and the columnar optical member 40p can be held in a stable manner.

The pedestal covering portion 30b and the upright fixing portion 30f are integrated, and are formed using, for example, an aluminum alloy. In other words, the pedestal covering portion 30b and the upright fixing portion 30f are made of a metal. Accordingly, because the mechanical strength and heat dissipation properties of the pedestal covering portion 30b and the upright fixing portion 30f can be improved, the columnar optical member 40p can be reliably held in a stable manner, and heat accumulation in the columnar optical member 40p can be prevented, improving the power generation efficiency and the reliability.

The frame-shaped contour of the upright fixing portion 30f has each side measuring, for example, 17 mm and a height of, for example, 10 mm, and the height from the coupling flange portion 30d to the top face of the upright fixing portion 30f is, for example, 20 mm.

The columnar optical member 40p has a quadrangular prism having inclined sides, with its top face 40a and bottom face 40b having quadrangular shapes centered on each other. Accordingly, the columnar optical member 40p has four optical path inclined faces 40c defined by the bottom face 40b and the top face 40a that is made larger than the bottom face 40b. Because the columnar optical member 40p has the optical path inclined faces 40c, it serves as a light guiding path that efficiently guides and directs the concentrated sunlight Ls to the solar cell element 23.

The upright fixing portion 30f includes a through hole 30e for allowing the columnar optical member 40p (a quadrangular prism with the top and bottom faces having different areas) to pass therethrough having through inclined faces 30s that are brought into contact with (closely attached to) the optical path inclined faces 40c. In other words, the optical path inclined faces 40c and the through inclined faces 30s have the same inclination angle. Accordingly, the columnar optical member 40p is positioned in a self-aligned manner and fitted to the beam-shaped flange portion 30c (through hole 30e, upright fixing portion 30f) by taper-fitting, achieving high accuracy positioning.

Also, the upright fixing portion 30f (through inclined faces 30s) and the columnar optical member 40p (optical path inclined faces 40c) are closely and rigidly connected to each other, causing the concentrated sunlight Ls to be highly accurately directed to the solar cell element 23, thereby improving the light concentrating properties and improving the power generation efficiency.

The through hole 30e (through inclined faces 30s) is in contact with the upper position (top face 40a side) of the columnar optical member 40p (optical path inclined faces 40c). Accordingly, the columnar optical member 40p can be fixed in a stable manner irrespective of the position of the center of gravity of the columnar optical member 40p.

The top 30h of the upright fixing portion 30f has a groove-like recess for forming the third adhesive portion 33 with high accuracy and a frame-shaped positioning step 30m for facilitating the positioning of the translucent protective plate 41. Accordingly, the third adhesive portion 33 (see FIG. 5) can be formed easily and highly accurately, and the translucent protective plate 41 can be disposed easily and highly accurately.

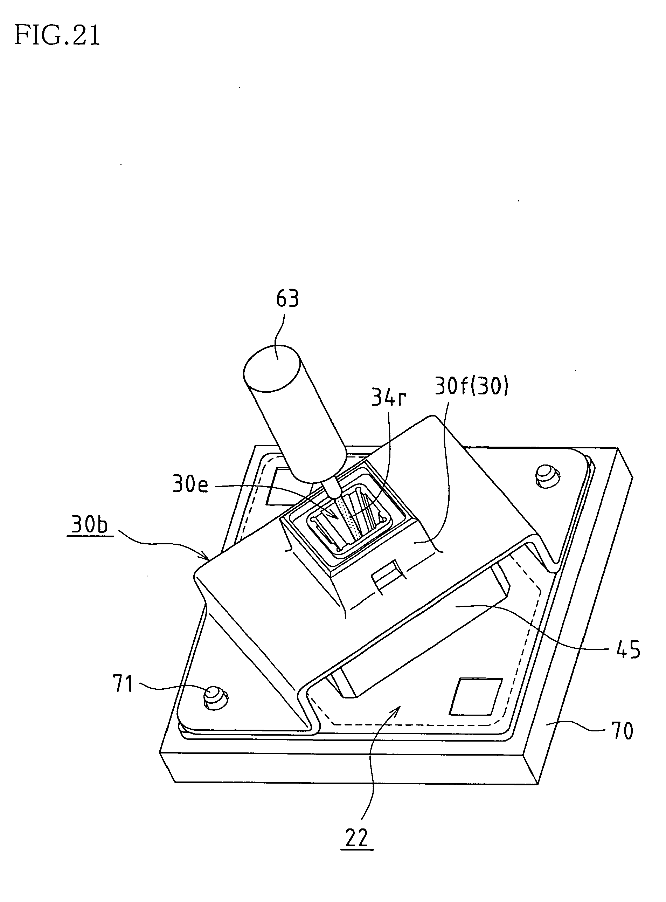

The through hole 30e has through groove portions 30g formed so as to correspond to the corners (four corners each formed by joining two adjacent optical path inclined faces 40c) of the quadrangular prism (columnar optical member 40p). Accordingly, the through groove portions 30g protect the corners of the columnar optical member 40p from damage, and form air passages extending from the solar cell element 23 to the top face 40a, and therefore air bubbles produced during the defoaming treatment of the sealing resin 34r (see FIG. 21) that is filled to form the resin sealing portion 34 can be effectively released to the outside.

The through groove portions 30g also produce a convection flow from the solar cell element 23 to the top face 40a during operation, improving heat dissipation properties. Wide grooves similar to the through groove portions 30g are formed in the through inclined faces 30s as well, so that total reflection at the optical path inclined faces 40c can effectively occur.

In the columnar optical member 40p, the top face 40a from which sunlight Ls enters is made larger than the bottom face 40b, and thus the margin for misalignment between the concentrating lens 50 and the solar cell 21 (top face 40a) can be increased, improving the power generation efficiency and the power generation.

In other words, light concentrating properties in which sunlight Ls over a wide wavelength region can be concentrated with high accuracy are obtained by securing a light guiding path (columnar optical member 40p) having a high positional accuracy and stability, thereby improving the light concentrating properties and the heat dissipation properties, preventing reduction of power generation efficiency and temperature increase caused by deviation of the concentrated sunlight Ls and improving power generation, and improving the heat resistance, the reliability and the weather resistance.

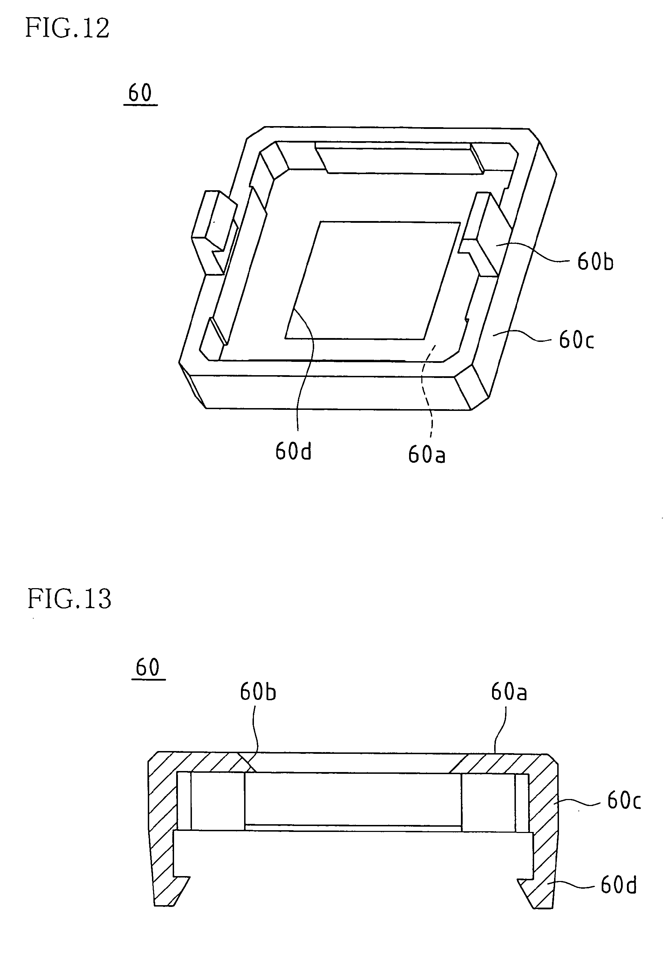

FIG. 12 is a perspective view showing a schematic configuration of the cap shown in FIG. 4.

FIG. 13 is a cross-sectional view showing a cross-sectional shape of the cap shown in FIG. 12.

The cap 60 (window frame 60b) has a shape that shields the third adhesive portion 33 from sunlight Ls. Accordingly, irradiation of the third adhesive portion 33 with sunlight Ls is prevented, and thus degradation of the third adhesive portion 33 (third adhesive 33r) can be prevented.

The cap 60 includes a flat face portion 60a that is adhered to the third adhesive portion 33 and that shields the third adhesive portion 33 from sunlight Ls, and also includes a frame portion 60c that is provided adjacent to the flat face portion 60a and that shields the top 30h of the upright fixing portion 30f (FIG. 11) from sunlight Ls. The flat face portion 60a has a window frame 60b formed in the center thereof so as to cause sunlight Ls to enter within the perimeter of the top face 40a. The frame portion 60c has a shape extending upright from the edges of the flat face portion 60a so as to surround the top 30h of the upright fixing portion 30f.

In other words, the cap 60 (flat face portion 60a and frame portion 60c) has an L-shaped cross section so that the third adhesive portion 33 is not directly irradiated with sunlight Ls. The cap 60 has a picture-frame shape with each side measuring, for example, 20 mm, and the flat face portion 60a and the frame portion 60c have a thickness of approximately 1.5 mm.

The cap 60 is made of a metal (for example, an aluminum alloy). Accordingly, the mechanical strength and heat dissipation properties of the cap 60 are increased, preventing the translucent protective plate 41 and the surface of the upright fixing portion 30f from being degraded or burnt by sunlight Ls, and the translucent protective plate 41 and the upright fixing portion 30f can be physically protected. Consequently, it is possible to provide a solar cell 21 having excellent power generation efficiency and reliability.

Two latching portions 60d extending from the frame portion 60c are formed in opposed positions, and the latching portions 60d are configured to be latched with latching recesses 30k (FIG. 6) provided in the upright fixing portion 30f. By locking each latching portion 60d into the latching recess 30k, the cap 60 can be latched with and fixed to the outer perimeter of the top 30h of the upright fixing portion 30f.

### Embodiment 5

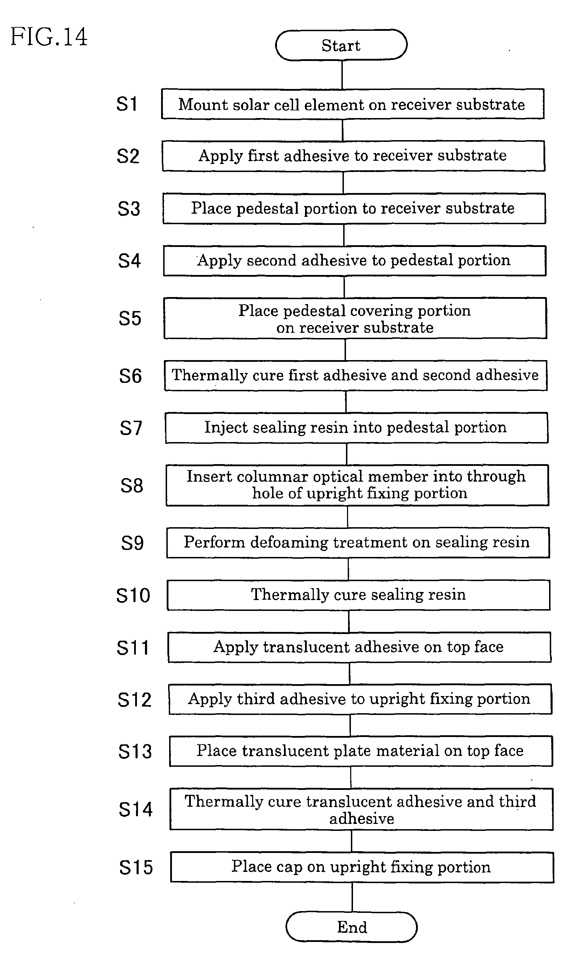

A method of manufacturing a solar cell according to the present embodiment will be described with reference to FIGS. 14 to 26 and FIG. 7.

A solar cell 21 according to the present embodiment is the same as the solar cells 21 described in Embodiments 1 to 4 (in particular, the solar cell 21 according to Embodiment 4), which is thus referred to as appropriate, and differences will mainly be described here.

Specifically, the solar cell manufacturing method according to the present embodiment is a method of manufacturing a solar cell 21 including an optical member 40 that allows concentrated sunlight Ls to pass therethrough, a solar cell element 23 that converts the sunlight Ls that has passed through the optical member 40 into electricity, a receiver substrate 22 on which the solar cell element 23 is placed, a first adhesive portion 31 that is adhered to the receiver substrate 22 and that is formed into a frame shape surrounding the solar cell element 23, a pedestal portion 45 that is in contact with the receiver substrate 22 and that is adhered to the first adhesive portion 31 so as to surround the solar cell element 23, a resin sealing portion 34 that is surrounded by the first adhesive portion 31 and that covers the solar cell element 23, and a second adhesive portion 32 formed on the top 45b of the pedestal portion 45, and also includes a pedestal covering portion 30b including a beam-shaped flange portion 30c that is adhered to the second adhesive portion 32 and that extends in a direction parallel to the receiver substrate 22 and a coupling flange portion 30d that extends outwardly from the beam-shaped flange portion 30c and that is connected to the receiver substrate 22 outside the pedestal portion 45, and a fixing portion 30 that fixes a columnar optical member 40p that has a columnar shape and that serves as the optical member 40.

The solar cell manufacturing method according to the present embodiment includes a first adhesive applying step, a pedestal portion placing step, a second adhesive applying step, a pedestal covering portion placing step (fixing portion disposing step), a first heat curing step, a sealing resin injecting step, a columnar optical member installing step (optical member disposing step), a defoaming treatment step, a second heat curing step, a translucent adhesive resin applying step, a third adhesive applying step, a translucent protective plate placing step, a third heat curing step, and a cap placing step, which will be described below.

FIG. 14 is a flowchart illustrating process steps of a method of manufacturing a solar cell according to Embodiment 5 of the present invention.

The method of manufacturing the solar cell 21 according to the present embodiment includes the following Steps S1 to S15. Each step will be described with reference to the drawing corresponding to the step (FIG. 7 and FIGS. 15 to 26).

### Step S1 (FIG. 7):

A solar cell element 23 is mounted onto a receiver substrate 22 (a solar cell element mounting step).

Firstly, a receiver substrate 22 is prepared. In the receiver substrate 22, a first connection pattern 25 and a second connection pattern 26 have been formed, and the surface is protected (insulated) by a surface protection layer 27. In the first connection pattern 25, a chip substrate (substrate electrode: not shown) for a solar cell element 23 and a chip substrate (substrate electrode: not shown) for a bypass diode 24 are adhered (die-adhered). The surface protection layer 27 has been removed in advance in regions to which a solar cell element 23 and a bypass diode 24 are connected, regions corresponding to a first extraction electrode 25a and a second extraction electrode 26a to which an external terminal is connected, and a region corresponding to a wire connecting portion 26b.

A solar cell element 23 is placed and soldered in a region (center area) for connecting the solar cell element 23 of the receiver substrate 22. Likewise, a bypass diode 24 is placed and soldered in a region for connecting the bypass diode that is spaced apart from the solar cell element 23 by a prescribed distance (an area located slightly away from the center area of the receiver substrate 22).

Next, the ends of, for example, four wires 29 are connected to the surface electrode (not shown) of the solar cell element 23, and the ends of, for example, two wires 29 are connected to the surface electrode (not shown) of the bypass diode 24. The other ends of these wires 29 are connected to the wire connecting portion 26b in which the second connection pattern 26 is exposed.

The receiver substrate 22 can be positioned as appropriate by attachment holes 22h.

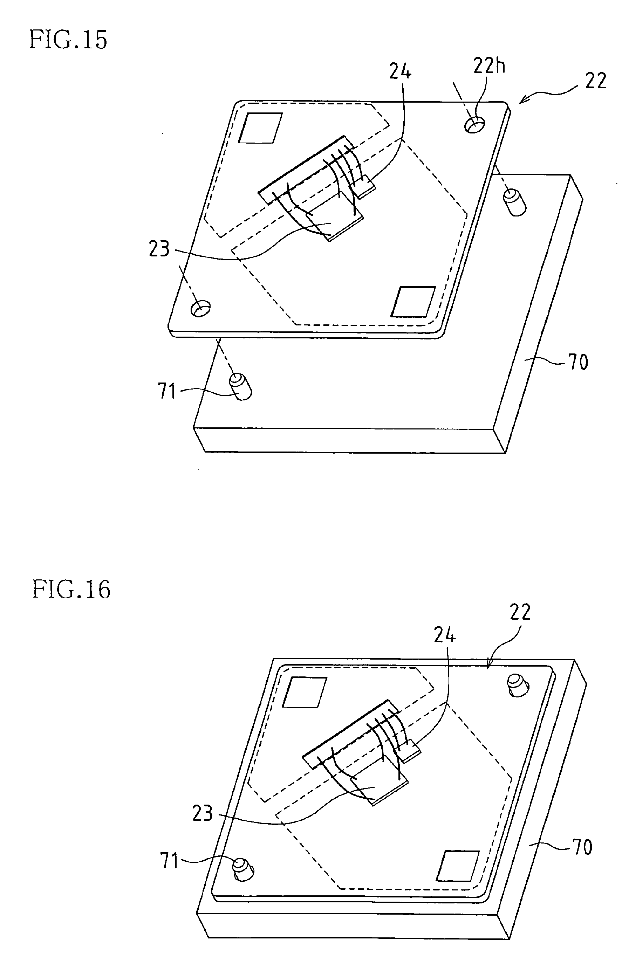

### Step S2 (FIGS. 15 to 17):

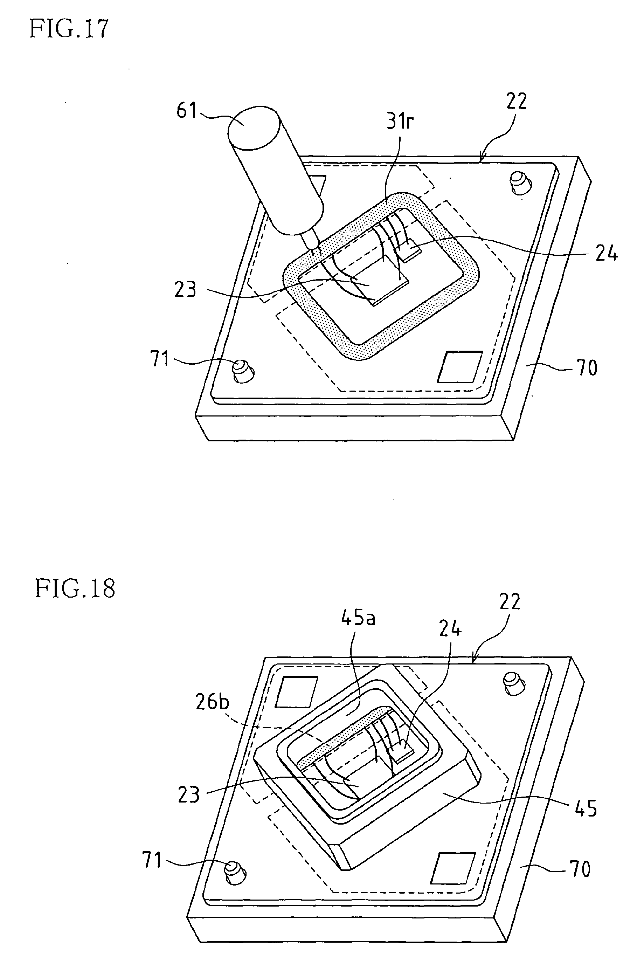

After a preparation step shown in FIGS. 15 and 16, a first adhesive 31r is applied to the receiver substrate 22 (FIG. 17, a first adhesive applying step).

FIG. 15 is a perspective view showing a step of setting the receiver substrate onto a positioning jig that is performed as a preparation step for applying a first adhesive that forms a first adhesive portion in the process of the solar cell manufacturing method according to Embodiment 5 of the present invention.

FIG. 16 is a perspective view showing a state in which the receiver substrate has been set on the positioning jig through the preparation step of FIG. 15.

After the solar cell element 23 and the bypass diode 24 has been mounted on the receiver substrate 22, the receiver substrate 22 is attached by aligning the attachment holes 22h provided in the receiver substrate 22 with positioning pins 71 provided in a positioning jig 70.

In other words, the pedestal covering portion attachment holes 30j of a pedestal covering portion 30b (coupling flange portion 30d) can be positioned with respect to the attachment holes 22h for positioning the positioning pins 71 of the positioning jig 70, and therefore the pedestal covering portion 30b can be easily and highly accurately positioned relative to the receiver substrate 22 with good workability.

FIG. 17 is a perspective view showing a step of applying a first adhesive portion in the process of the solar cell manufacturing method according to Embodiment 5 of the present invention.

A first adhesive 31r for forming a first adhesive portion 31 that adheres a pedestal portion 45 and the receiver substrate 22 is applied to the receiver substrate 22 (a first adhesive applying step).

The positioning jig 70 on which the receiver substrate 22 has been placed is set in a prescribed position on the table (not shown) of a first adhesive dispenser 61, and a first adhesive 31r is applied to a prescribed position of the receiver substrate 22 (the position corresponding to a bottom recess 45d (see FIG. 9), an appropriate mark may be formed in advance) in a shape prescribed to form a first adhesive portion 31.

In other words, a white silicone resin (first adhesive 31r) is applied to a predetermined position on the surface of the receiver substrate 22 on which the solar cell element 23 and the bypass diode 24 have been mounted, in a predetermined shape (frame shape, cross-sectional width, cross-sectional height).

### Step S3 (FIG. 18):

FIG. 18 is a perspective view showing a step of placing a pedestal portion onto the receiver substrate in the process of the solar cell manufacturing method according to Embodiment 5 of the present invention.

A pedestal portion 45 is placed onto the receiver substrate 22 by adhering the pedestal portion 45 to the first adhesive 31r (a pedestal portion placing step).

The placement of the pedestal portion 45 on the receiver substrate 22 is performed by positioning through adjustment such that the receiver substrate 22 and the pedestal portion 45 are centered on each other. The first adhesive 31r has been applied in a shape capable of filling the bottom recess 45d. Accordingly, the first adhesive 31r fills the bottom recess 45d, thereby forming a first adhesive portion 31 that rigidly adheres (fixes) the pedestal portion 45 to the receiver substrate 22.

The pedestal portion 45 is internally provided with a through opening 45a, and the through opening 45a has a shape that can include the solar cell element 23, the bypass diode 24 and the wire connecting portion 26b. Accordingly, the pedestal portion 45 can protect the solar cell element 23, the bypass diode 24 and the wire connecting portion 26b from the surrounding environment.

The first adhesive 31r (first adhesive portion 31) functions as a blocking material (dam material) for sealing a filler such as a resin (a sealing resin that constitutes the resin sealing portion 34) or a gas (between the first tabular optical member 40f and the resin sealing portion 34 of Embodiment 1). Accordingly, the frame-shaped pedestal portion 45 does not necessarily have a picture frame-shaped structure in which the bottom face 45c is in direct contact with and adhered to the receiver substrate 22, in the shape of a frame. In other words, the frame-shaped pedestal portion 45 is only necessary to be adhered such that at least a part of the bottom face 45c is in direct contact with the receiver substrate 22, so that the focal length of the optical member 40 can be defined.

For example, in the case of the pedestal portion 45 having a square shape (FIG. 18), it is possible to employ a configuration (variation) in which leg-like portions protruding toward the receiver substrate 22 are provided at four corners and the bottom faces of the leg-like portions are brought into direct contact with and adhered to the receiver substrate 22. Preferably, the first adhesive portion 31 is formed by squeezing the first adhesive 31r so as to fill the gap formed between the pedestal portion 45 and the receiver substrate 22 with the first adhesive 31r, and a space sealed from the surrounding environment is formed by using at least the resin sealing portion 34 and the pedestal portion 45.

With this configuration, a highly translucent resin (resin sealing portion 34) that seals the solar cell element 23 and a sealing resin (not shown) for the first extraction electrode 25a of the first connection pattern 25 and the second extraction electrode 26a of the second connection pattern 26 that are drawn to the periphery can be applied separately, and the highly translucent resin that is costly can be provided in a small space in an isolated and limited manner. Consequently, it is possible to manufacture a solar cell 21 at low cost without degradation of the power generation capability.

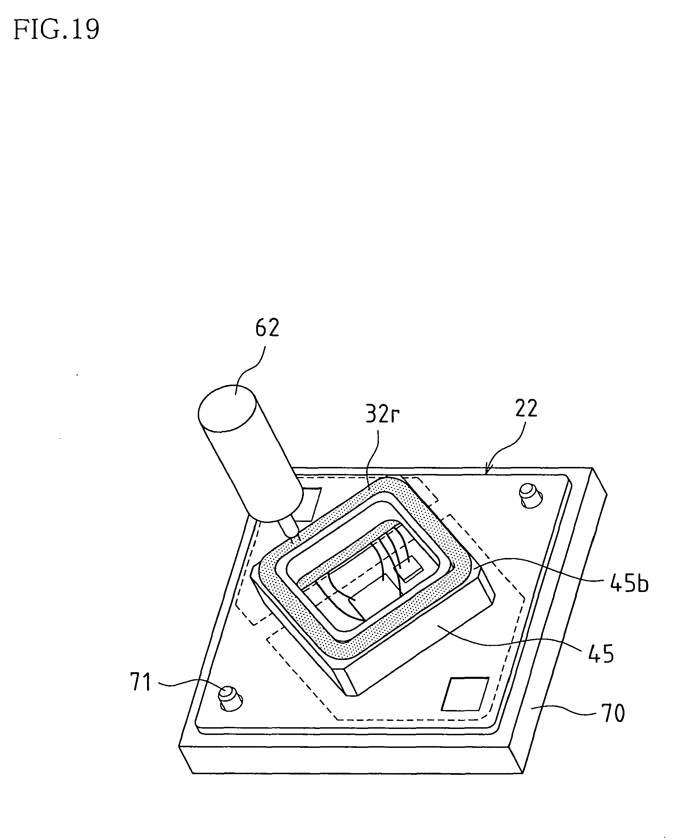

### Step S4 (FIG. 19):

FIG. 19 is a perspective view showing a step of applying a second adhesive portion to the pedestal portion in the process of the solar cell manufacturing method according to Embodiment 5 of the present invention.

A second adhesive 32r for forming a second adhesive portion 32 that adheres a pedestal covering portion 30b and the pedestal portion 45 is applied to the top 45b of the pedestal portion 45 (a second adhesive applying step).

The positioning jig 70 on which the receiver substrate 22 has been placed is set in a prescribed position on the table (not shown) of a second adhesive dispenser 62, and a second adhesive 32r is applied to the top 45b of the pedestal portion 45 that has been placed and adhered onto the receiver substrate 22 in a shape prescribed to form a second adhesive portion 32.

In other words, the second adhesive 32r is applied to the top 45b in a predetermined shape (frame shape, cross-sectional width, cross-sectional height). The first adhesive 31r and the second adhesive 32r may be the same resin, and the first adhesive dispenser 61 and the second adhesive dispenser 62 may be the same apparatus.

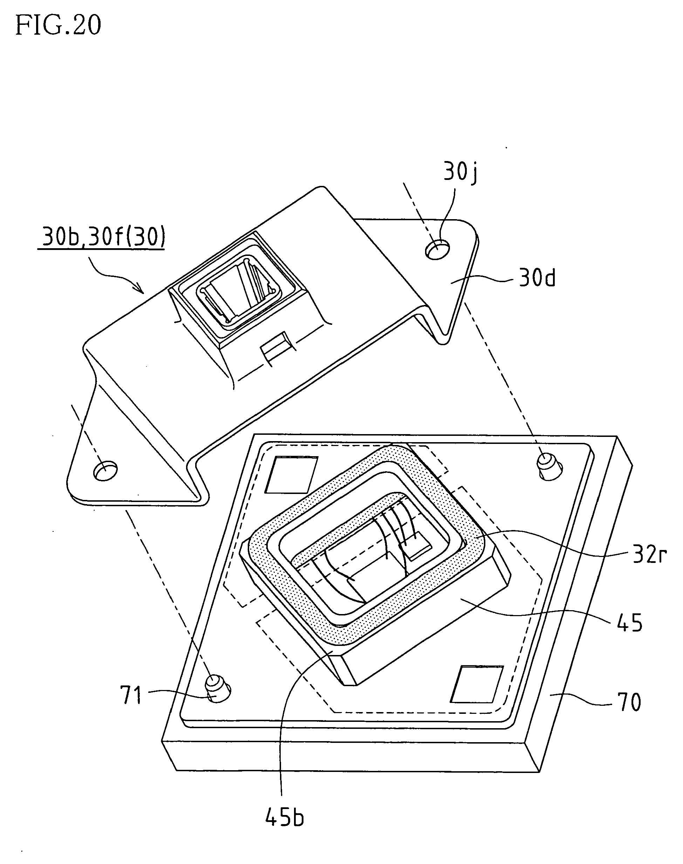

### Step S5 (FIG. 20):

FIG. 20 is a perspective view showing a step of placing a pedestal covering portion on the pedestal portion in the process of the solar cell manufacturing method according to Embodiment 5 of the present invention.

In the state in which the receiver substrate 22 is placed on the table of the second adhesive dispenser 62, a pedestal covering portion 30b is placed on the receiver substrate 22 (namely, on the second adhesive 32r applied to the pedestal portion 45) (a pedestal covering portion placing step).

Specifically, a pedestal covering portion 30b having an upright fixing portion 30f, serving as a fixing portion 30, that is provided upright at an inner edge frame 30ct of a beam-shaped flange portion 30c and that includes a through inclined face 30s that allows the columnar optical member 40p to pass through and that faces the columnar optical member 40p is placed on the receiver substrate 22 by adhering the pedestal covering portion 30b to the second adhesive 32r (a pedestal covering portion placing step or also referred to as a fixing portion disposing step of disposing the fixing portion 30).

The positioning pins 71 provided in the positioning jig 70 are fitted to pedestal covering portion attachment holes 30j formed in a coupling flange portion 30d of the pedestal covering portion 30b in a self-aligned manner, and thereby the pedestal covering portion 30b can be easily and highly accurately positioned relative to the receiver substrate 22. Also, the second adhesive 32r has been applied to the top 45b in the second adhesive applying step (Step S4), and therefore the pedestal covering portion 30b and the pedestal portion 45 (top 45b) are adhered and rigidly fixed to each other.

### Step S6:

The first adhesive 31r and the second adhesive 32r are thermally cured by application of heat so as to form the first adhesive portion 31 and the second adhesive portion 32 (a first heat curing step).

Specifically, the receiver substrate 22 is removed from the table of the second adhesive dispenser 62 and placed in an oven (not shown). In that state, the first adhesive 31r and the second adhesive 32r are heated at, for example, 150°C for 30 minutes, and thermally cured. Through the heat curing of the first adhesive 31r and the second adhesive 32r, the receiver substrate 22 and the pedestal portion 45 are integrated (coupled without a gap) by the first adhesive portion 31, and the pedestal portion 45 and the pedestal covering portion 30b are integrated and coupled without a gap by the second adhesive portion 32.

### Step S7 (FIG. 21):

FIG. 21 is a perspective view showing a step of injecting a sealing resin for resin-sealing the solar cell element into the pedestal portion in the process of the solar cell manufacturing method according to Embodiment 5 of the present invention.

A sealing resin 34r that resin-seals the solar cell element 23 is injected into the interior region of the pedestal portion 45 (first adhesive portion 31) (a sealing resin injecting step).

The positioning jig 70 on which the receiver substrate 22 has been placed is set in a prescribed position on the table (not shown) of a sealing resin dispenser 63, and a prescribed amount of sealing resin 34r is injected via a through hole 30e of the upright fixing portion 30f (fixing portion 30).

As the sealing resin 34r, a highly translucent silicone resin is used. The injection amount is set to such an amount that when a columnar optical member 40p has been fitted to the through hole 30e of the upright fixing portion 30f, the front end (bottom face 40b) of the columnar optical member 40p is covered to (embedded with) a depth of approximately 0.3 mm to 0.5 mm with respect to the surface of the injected sealing resin 34r (resin sealing portion 34).

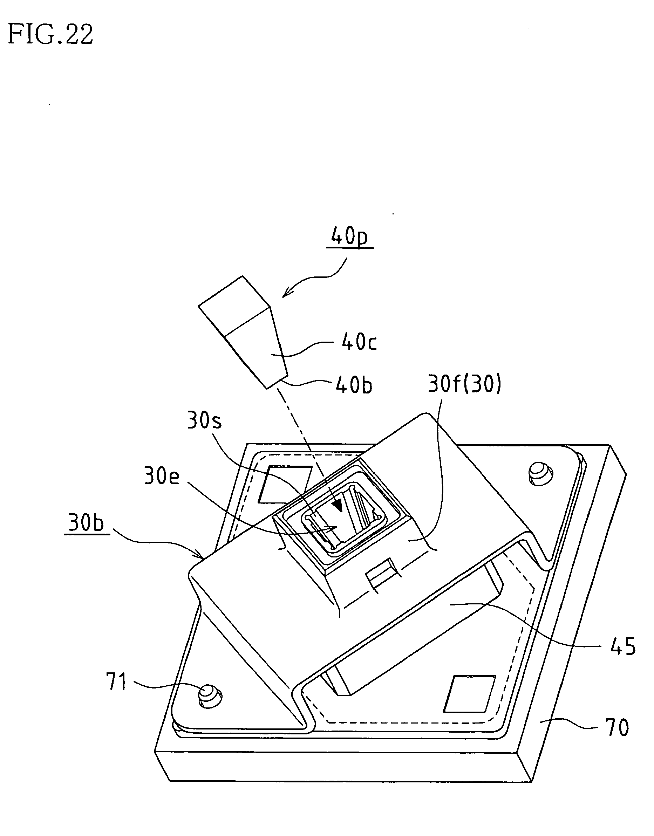

### Step S8 (FIG. 22):

FIG. 22 is a perspective view showing a step of inserting a columnar optical member into the through hole of the upright fixing portion in the process of the solar cell manufacturing method according to Embodiment 5 of the present invention.

A columnar optical member 40p is inserted into the through hole 30e of the upright fixing portion 30f (a columnar optical member disposing step). Specifically, the columnar optical member 40p is disposed such that it comes into contact with a through inclined face 30s and is fixed (also referred to as an optical member disposing step of disposing the optical member 40). The bottom face 40b of the columnar optical member 40p is covered with the sealing resin 34r when the columnar optical member 40p has been inserted into the upright fixing portion 30f (through hole 30e).

In the state in which the receiver substrate 22 is placed on the table of the sealing resin dispenser 63, the columnar optical member 40p is fitted to the upright fixing portion 30f (pedestal covering portion 30b). As described above, the columnar optical member 40p (optical path inclined faces 40c) is formed to be capable of self-alignment with the upright fixing portion 30f (through hole 30e, through inclined faces 30s), and therefore the columnar optical member 40p can be easily and highly accurately coupled to (brought into contact with) the pedestal covering portion 30b (upright fixing portion 30f).

### Step S9:

A defoaming treatment is performed on the sealing resin 34r (a defoaming treatment step).

In the state in which the columnar optical member 40p is fitted to the through hole 30e of the upright fixing portion 30f (pedestal covering portion 30b), the receiver substrate 22 is removed from the table of the sealing resin dispenser 63 and placed in a vacuum desiccator (not shown). In that state, a vacuum is drawn by a vacuum pump (not shown) so as to perform a defoaming treatment for removing air bubbles contained in the resin sealing portion 34.

### Step S10:

The sealing resin 34r is thermally cured by application of heat (a second heat curing step).

After the defoaming treatment, the receiver substrate 22 is removed from the vacuum desiccator (not shown) and placed in an oven (not shown). In that state, the sealing resin 34r is heated at, for example, 160°C for 40 minutes, and thermally cured. Through the heat curing of the sealing resin 34r, the front end (bottom face 40b) of the columnar optical member 40p is covered and fixed by the resin sealing portion 34 formed by the sealing resin 34r being cured. In other words, the columnar optical member 40p is fixed to the resin sealing portion 34, as well as to the inserted upright fixing portion 30f (through hole 30e).

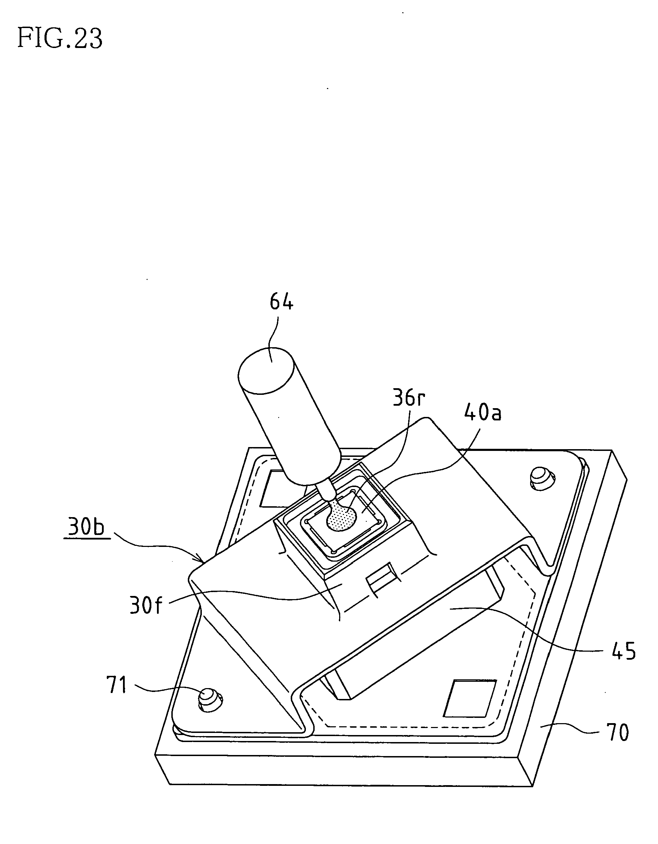

### Step S11 (FIG. 23):

FIG. 23 is a perspective view showing a step of applying a translucent adhesive to the top face of the columnar optical member in the process of the solar cell manufacturing method according to Embodiment 5 of the present invention.

A translucent adhesive 36r for forming a translucent adhesive layer 36 that adheres the top face 40a of the columnar optical member 40p and a translucent protective plate 41 is applied onto the top face 40a of the columnar optical member 40p (a translucent adhesive applying step).

The positioning jig 70 on which the receiver substrate 22 has been placed is set in a prescribed position on the table (not shown) of a translucent adhesive dispenser 64, and a prescribed amount of translucent adhesive 36r is thinly applied onto the top face 40a of the columnar optical member 40p.

As the translucent adhesive 36r, a highly translucent silicone resin is used. The application amount is set to such an amount that the formed translucent adhesive layer 36 has a thickness of approximately 0.5 mm, so that air is not included in the space between the translucent protective plate 41 and the columnar optical member 40p (top face 40a) when the translucent protective plate 41 is placed on the columnar optical member 40p.

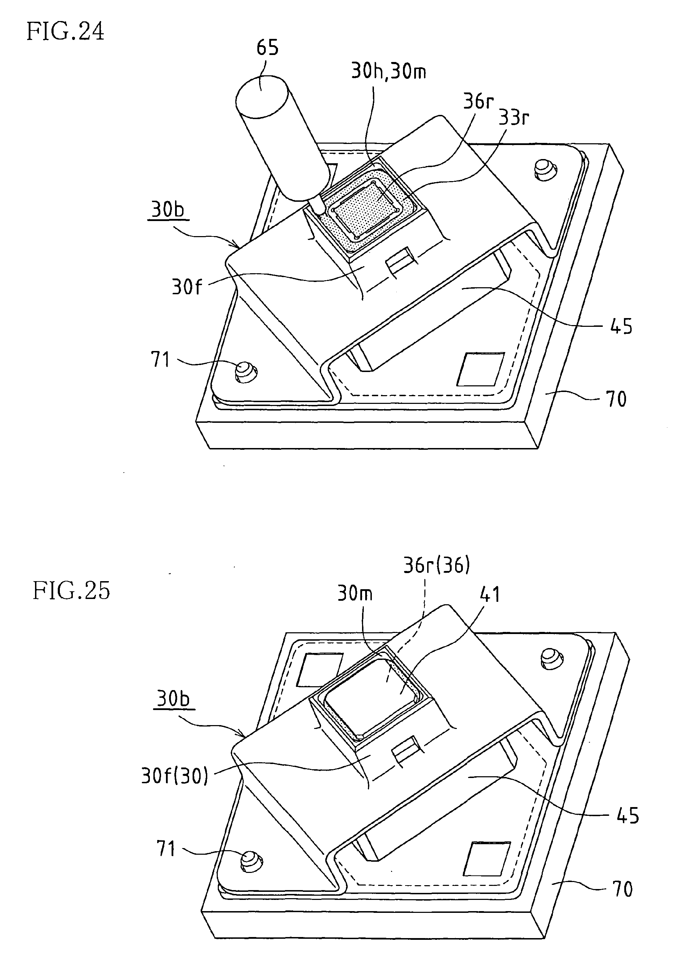

### Step S12 (FIG. 24):

FIG. 24 is a perspective view showing a step of applying a third adhesive onto the upright fixing portion in the process of the solar cell manufacturing method according to Embodiment 5 of the present invention.

A third adhesive 33r that covers the top face 40a of the columnar optical member 40p and that adheres a translucent protective plate 41 fixed to the upright fixing portion 30f is applied onto the top 30h of the upright fixing portion 30f (a third adhesive applying step).

The positioning jig 70 on which the receiver substrate 22 has been placed is set in a prescribed position on the table of a third adhesive dispenser 65, and a third adhesive 33r is applied onto the top 30h of the upright fixing portion 30f that is provided upright at the leading edge of the pedestal covering portion 30b that is placed and adhered onto the pedestal portion 45. In other words, the third adhesive 33r is applied onto the top 30h in the form of a frame with the use of the positioning step 30m.

The first adhesive 31r, the second adhesive 32r and the third adhesive 33r may be the same resin, and the first adhesive dispenser 61, the second adhesive dispenser 62 and the third adhesive dispenser 65 may be the same apparatus.

### Step S13 (FIG. 25):

FIG. 25 is a perspective view showing a step of placing a translucent protective plate onto the upright fixing portion in the process of the solar cell manufacturing method according to Embodiment 5 of the present invention.

A translucent protective plate 41 is placed onto the top face 40a of the columnar optical member 40p (a translucent protective plate placing step). Specifically, the translucent protective plate 41 is placed onto the top face 40a on which the translucent adhesive 36r has been applied and the upright fixing portion 30f on which the third adhesive 33r has been applied.

Because the translucent protective plate 41 is placed after the translucent adhesive 36r has been thinly applied onto the entire face of the top face 40a by the translucent adhesive dispenser 64, and the third adhesive 33r has been applied onto the top 30h of the upright fixing portion 30f by the third adhesive dispenser 65 in the form of a frame, the translucent adhesive layer 36 can be formed between the top face 40a and the translucent protective plate 41, and the translucent protective plate 41 can be adhered to the upright fixing portion 30f.

The positioning of the translucent protective plate 41 relative to the upright fixing portion 30f (third adhesive portion 33) is performed through adjustment such that the translucent protective plate 41 is positioned at the center of the upright fixing portion 30f with the use of the positioning step 30m formed together with the top 30h. Because the third adhesive 33r has been applied so as to fill the groove-like recess of the top 30h, the translucent protective plate 41 is rigidly adhered (fixed) to the upright fixing portion 30f.

The translucent protective plate 41 pushes the translucent adhesive 36r that has been applied thinly on the top face 40a of the columnar optical member 40p, and the translucent protective plate 41 and the columnar optical member 40p (top face 40a) are adhered via the translucent adhesive 36r (translucent adhesive layer 36).

### Step S14:

The translucent adhesive 36r and the third adhesive 33r are thermally cured by application of heat so as to form a translucent adhesive layer 36 and a third adhesive portion 33 (a third heat curing step).

Specifically, the receiver substrate 22 is removed from the table of the third adhesive dispenser 65 and placed in an oven (not shown). In that state, the third adhesive 33r and the translucent adhesive 36r are heated at, for example, 150°C for 30 minutes and thermally cured. Through the heat curing of the third adhesive 33r and the translucent adhesive 36r, the upright fixing portion 30f and the translucent protective plate 41 are integrated (coupled without a gap) by the third adhesive portion 33, and the translucent protective plate 41 and the columnar optical member 40p are integrated (coupled without a gap) by the translucent adhesive layer 36.

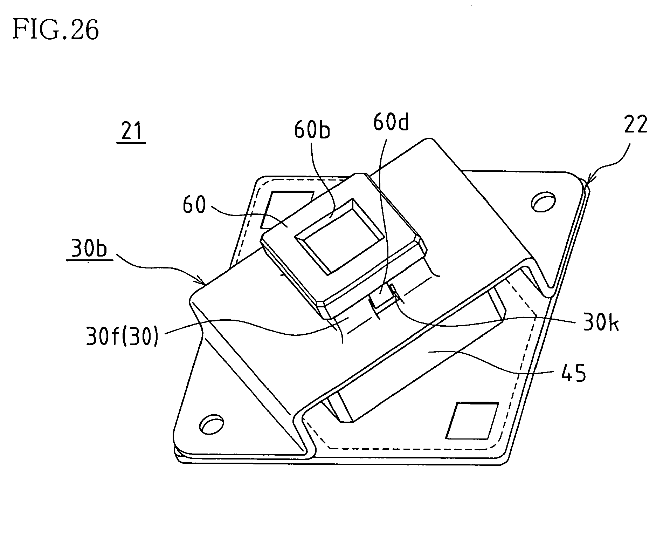

### Step S15 (FIG. 26):

FIG. 26 is a perspective view showing a step of placing a cap onto the upright fixing portion in the process of the solar cell manufacturing method according to Embodiment 5 of the present invention.

A cap 60 having a window frame 60b that covers the perimeter edge of the translucent protective plate 41 is connected to the upright fixing portion 30f (a cap connecting step).

The cap 60 is attached to the upright fixing portion 30f by aligning them such that the latching portions 60d of the cap 60 are brought to correspond to the latching recesses 30k of the upright fixing portion 30f, placing the cap 60 on the upright fixing portion 30f from above, and pushing the cap 60 until the latching portions 60d lock into the latching recesses 30k.

### Step after Step S15:

After Step S15, the receiver substrate 22 and a heat dissipation fin 53 are connected and integrated by fixing members 54h inserted through the attachment holes 22h and the pedestal covering portion attachment holes 30j with the use of a riveter (not shown) (a heat dissipation fin attaching step).

As described above, the solar cell manufacturing method according to the present embodiment is a method of manufacturing a solar cell including an optical member 40 that allows concentrated sunlight Ls to pass therethrough, a solar cell element 23 that converts the sunlight Ls that has passed through the optical member 40 into electricity, a receiver substrate 22 on which the solar cell element 23 is placed, a first adhesive portion 31 that is adhered to the receiver substrate 22 and that is formed into a frame shape surrounding the solar cell element 23, a pedestal portion 45 that is in contact with the receiver substrate 22 and that is adhered to the first adhesive portion 31 so as to surround the solar cell element 23, a resin sealing portion 34 that is surrounded by the first adhesive portion 31 and that covers the solar cell element 23, and a second adhesive portion 32 formed on the top 45b of the pedestal portion 45, and also includes a pedestal covering portion 30b including a beam-shaped flange portion 30c that is adhered to the second adhesive portion 32 and that extends in a direction parallel to the receiver substrate 22 and a coupling flange portion 30d that extends outwardly from the beam-shaped flange portion 30c and that is connected to the receiver substrate 22 outside the pedestal portion 45, and a fixing portion 30 (upright fixing portion 30f) that fixes a columnar optical member 40p that has a columnar shape and that serves as the optical member 40.

The solar cell manufacturing method according to the present embodiment includes a first adhesive applying step of applying a first adhesive 31r that forms the first adhesive portion 31 to the receiver substrate 22, a pedestal portion placing step of placing the pedestal portion 45 onto the receiver substrate 22 by adhering the pedestal portion 45 to the first adhesive 31r, a second adhesive applying step of applying a second adhesive 32r that forms the second adhesive portion 32 to the top 45b of the pedestal portion 45, a pedestal covering portion placing step of placing the pedestal covering portion 30b onto the receiver substrate 22 by adhering the pedestal covering portion 30b to the second adhesive 32r, the pedestal covering portion 30b having an upright fixing portion 30f, serving as the fixing portion 30, that is provided upright at an inner edge frame 30ct of the beam-shaped flange portion 30c and that has a through inclined face 30s that allows a columnar optical member 40p to pass through and that faces the columnar optical member 40p (also referred to as a fixing portion disposing step of disposing the fixing portion 30), a first heat curing step of forming the first adhesive portion 31 and the second adhesive portion 32 by heating the first adhesive 31r and the second adhesive 32r, a columnar optical member disposing step of disposing the columnar optical member 40p such that it comes into contact with the through inclined face 30s and is fixed (optical member disposing step of disposing the optical member 40), and a sealing resin injecting step of injecting a sealing resin 34r that resin-seals the solar cell element 23 into an interior region of the first adhesive portion 31.

Accordingly, with simple steps of sequentially stacking and positioning each constituent member (the first adhesive portion 31, the pedestal portion 45, the second adhesive portion 32, the pedestal covering portion 30b (the upright fixing portion 30f serving as the fixing portion 30), the resin sealing portion 34 and the columnar optical member 40p (optical member 40)) by performing the first adhesive applying step, the pedestal portion placing step, the second adhesive applying step, the pedestal covering portion placing step (fixing portion disposing step), the columnar optical member disposing step (optical member disposing step) and the sealing resin injecting step, it is possible to easily and highly accurately manufacture a solar cell 21 that has high heat resistance, weather resistance and reliability, with high productivity.

The solar cell manufacturing method according to the present embodiment further includes a translucent adhesive applying step of applying a translucent adhesive 36r for forming a translucent adhesive layer 36 that adheres the top face 40a of the columnar optical member 40p and a translucent protective plate 41 onto the top face 40a of the columnar optical member 40p, a third adhesive applying step of applying a third adhesive 33r that covers the top face 40a of the columnar optical member 40p and that adheres the translucent protective plate 41 that is fixed to the upright fixing portion 30f onto the top 30h of the upright fixing portion 30f, a translucent protective plate placing step of placing the translucent protective plate 41 onto the top face 40a of the columnar optical member 40p, a third heat curing step of forming a translucent adhesive layer 36 and a third adhesive portion 33 by thermally curing the translucent adhesive 36r and the third adhesive 33r by application of heat, and a cap connecting step of connecting a cap 60 having a window frame 60b that covers the perimeter edge of the translucent protective plate 41 to the upright fixing portion 30f.

Accordingly, with simple steps of sequentially stacking and positioning each constituent member (the third adhesive portion 33, the translucent adhesive layer 36, the translucent protective plate 41, the cap 60) by performing the third adhesive applying step, the translucent adhesive applying step, the translucent protective plate placing step, the third heat curing step and the cap connecting step on the first adhesive portion 31, the pedestal portion 45, the second adhesive portion 32, the pedestal covering portion 30b (fixing portion 30: upright fixing portion 30f) and the optical member 40 (columnar optical member 40p) that have been stacked, it is possible to easily and highly accurately manufacture a solar cell 21 that has high heat resistance, weather resistance and reliability, with high productivity.

The sealing resin injecting step of injecting a sealing resin 34r that resin-seals the solar cell element 23 into the interior region of the first adhesive portion 31 can be performed during the time before the first adhesive applying step or the time between the first adhesive applying step (inclusive) and the columnar optical member disposing step (inclusive). Preferably, the sealing resin injecting step is performed after the first adhesive portion 31 and the second adhesive portion 32 have been formed in the first heat curing step but before the columnar optical member disposing step. It is preferable to perform a defoaming treatment step of performing a defoaming treatment on the sealing resin 34r and a second heat curing step of thermally curing the sealing resin 34r by heating the sealing resin 34r, together with the sealing resin injecting step.

The solar cell manufacturing method according to the present embodiment is also a method of manufacturing a solar cell 21 including an optical member 40 that allows concentrated sunlight Ls to pass therethrough, a solar cell element 23 that converts the sunlight Ls that has passed through the optical member 40 into electricity, a receiver substrate 22 on which the solar cell element 23 is placed, a first adhesive portion 31 that is adhered to the receiver substrate 22 and that is formed into a frame shape surrounding the solar cell element 23, a pedestal portion 45 that is in contact with the receiver substrate 22 and that is adhered to the first adhesive portion 31 so as to surround the solar cell element 23, and a fixing portion 30 (fitting/fixing portion 30r) that fixes the optical member 40 with respect to the pedestal portion 45.

In other words, the solar cell manufacturing method according to the present embodiment includes a first adhesive applying step of applying a first adhesive 31r that forms the first adhesive portion 31 to the receiver substrate 22, a pedestal portion placing step of placing the pedestal portion 45 onto the receiver substrate 22 by adhering the pedestal portion 45 to the first adhesive 31r, a first heat curing step of forming the first adhesive portion 31 by heating the first adhesive 31r, and an optical member disposing step of disposing the optical member 40 (columnar optical member 40p) in the fixing portion 30 (upright fixing portion 30).

Accordingly, with simple steps of sequentially stacking and positioning each constituent member (the first adhesive portion 31, the pedestal portion 45, the optical member 40 (columnar optical member 40p)) by performing the first adhesive applying step, the pedestal portion placing step, the first heat curing step and the optical member disposing step, it is possible to easily and highly accurately manufacture a solar cell 21 that has high heat resistance, weather resistance and reliability, with high productivity.

### Embodiment 6

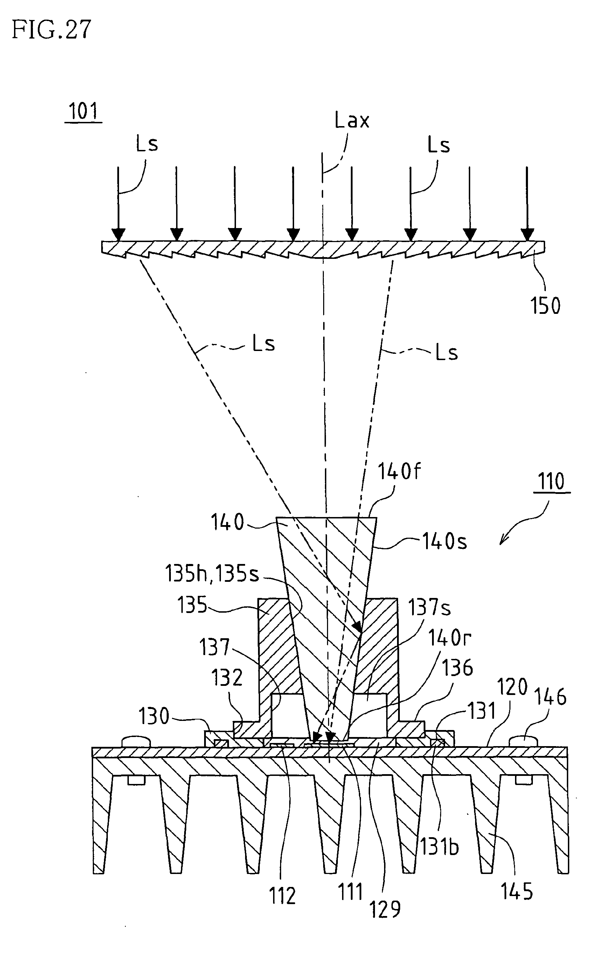

A concentrating solar power generation module and a solar cell according to the present embodiment will be described with reference to FIGS. 27 to 30C.

FIG. 27 is a cross-sectional view showing a cross-sectional state of a concentrating solar power generation module and a solar cell according to Embodiment 6 of the present invention.

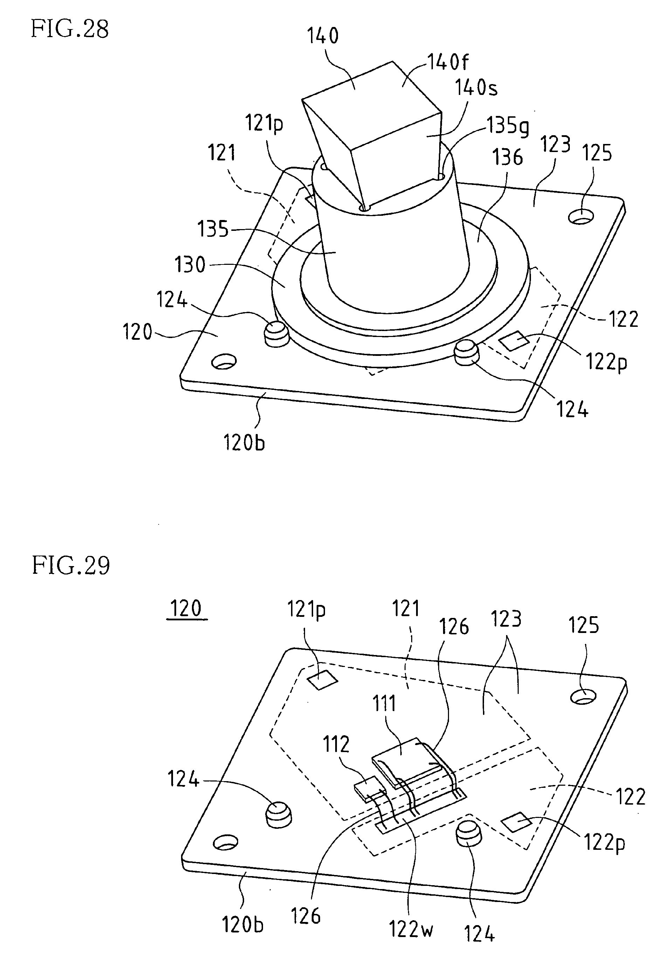

FIG. 28 is a perspective view showing an outer appearance of the solar cell shown in FIG. 27.

FIG. 29 is a perspective view showing a state in which the solar cell element shown in FIG. 27 has been mounted on a receiver substrate.

A solar cell 110 according to the present embodiment includes a solar cell element 111 that converts sunlight Ls concentrated by a concentrating lens 150 into electricity, a receiver substrate 120 on which the solar cell element 111 is placed, a columnar optical member 140 including an entrance face 140f that allows the concentrated sunlight Ls to enter and an irradiation face 140r that is disposed so as to face the solar cell element 111 and that directs the sunlight Ls to the solar cell element 111, and a holding portion 135 that holds the columnar optical member 140. The solar cell 110 also includes a frame-shaped pedestal portion 130 that is disposed around the solar cell element 111 in the shape of a frame and that is fixed to the receiver substrate 120, and the holding portion 135 is fitted to the frame-shaped pedestal portion 130.

Accordingly, the frame-shaped pedestal portion 130 can be easily and highly accurately positioned to and rigidly fixed to the receiver substrate 120, and the holding portion 135 can be easily and highly accurately positioned to the frame-shaped pedestal portion 130 and rigidly held, and thus the columnar optical member 140 can be easily and highly accurately positioned to the solar cell element 111 and rigidly held, as a result of which light concentrating properties over a wide wavelength region are improved, improving the power generation efficiency and the power generation, and it is therefore possible to obtain an inexpensive solar cell 110 having high heat resistance, reliability and weather resistance.

In the present embodiment, the holding portion 135 is configured to be fitted to the frame-shaped pedestal portion 130, but it is also possible to employ a configuration in which the frame-shaped pedestal portion 130 is fitted to the holding portion 135.

The irradiation face 140r has an area corresponding to the solar cell element 111, for example, an area corresponding to the effective light-receiving area of the solar cell element 111. In other words, with the irradiation face 140r having the same area as the effective light-receiving area of the solar cell element 111, unnecessary sunlight Ls irradiation can be prevented, as a result of which a temperature increase due to solar energy can be prevented and the power generation efficiency can be improved. The entrance face 140f has an area larger than that of the irradiation face 140r, and it is therefore possible to cause the concentrated sunlight Ls to reliably enter the columnar optical member 140.

In addition to the solar cell 110, the present embodiment also describes a concentrating solar power generation module 101 incorporating the solar cell 110. The concentrating solar power generation module 101 includes a concentrating lens 150 that concentrates sunlight Ls, and a solar cell 110 that receives the concentrated sunlight Ls and converts the sunlight into electricity. Accordingly, light concentrating properties over a wide wavelength region are improved, improving the power generation efficiency and the power generation, and it is therefore possible to obtain an inexpensive concentrating solar power generation module 101 that has high heat resistance, reliability and weather resistance.

The solar cell element 111 is disposed in a center area of the receiver substrate 120 in consideration of uniform heat dissipation. A bypass diode 112 is connected to the solar cell element 111 in parallel, and the bypass diode 112 secures a current path when the solar cell element 111 acts as a resistor in the event of interception of the sunlight Ls. The bypass diode 112 is configured so as to be capable of maintaining the power generation function as a whole even if a particular solar cell element 111 fails to perform its power generation function in the case where the concentrating solar power generation module 101 is constructed by, for example, connecting a plurality of solar cell elements 111.

In the solar cell element 111, a PN junction, electrodes and so on are formed by a known semiconductor manufacturing process using, for example, Si, or a GaAs-based compound semiconductor. From the viewpoint of reducing the material cost by achieving reduction of the solar cell material used, the process is performed on a wafer, and the wafer is diced into chips of an approximately 4 to 6 mm square after solar cell elements have been formed. The solar cell element 111 includes, as electrodes, a substrate electrode (not shown) provided on the substrate-side of the chip and a surface electrode (not shown) provided on the surface side of the chip.

The receiver substrate 120 includes, for example, a base 120b, an intermediate insulating layer (not shown) laminated on the base 120b, and a first connection pattern 121 and a second connection pattern 122 that are made of copper and laminated on the intermediate insulating layer. The receiver substrate 120 also includes a surface protection layer 123 that protects the first connection pattern 121 and the second connection pattern 122.

In the surface protection layer 123 covering the first connection pattern 121, a region for a first extraction electrode 121p to which an external terminal (not shown) is connected, and regions for mounting the solar cell element 111 and the bypass diode 112 have been removed, and thus the copper (conductor) of the first connection pattern 121 is directly exposed to the outside.

Similarly, in the surface protection layer 123 covering the second connection pattern 122, a region for a second extraction electrode 122p to which an external terminal (not shown) is connected, and a region for a wire connecting portion 122w that is connected to an electrode of the solar cell element 111 and an electrode of the bypass diode 112 via wires 126 have been removed, and thus the copper (conductor) of the second connection pattern 122 is directly exposed to the outside.

The receiver substrate 120 is, for example, a 24 mm to 60 mm square when the solar cell element 111 is, for example, an approximately 4 mm to 6 mm square. The receiver substrate 120 has a thickness of, for example, approximately 1 mm to 3 mm in consideration of heat dissipation properties. The base 120b is made of, for example, aluminum so as to improve heat dissipation properties and achieve weight reduction.

The receiver substrate 120 has a pair of substrate position fixing holes 125, disposed diagonally, for positioning the receiver substrate 120 when the receiver substrate 120 is set on each manufacturing apparatus or each manufacturing jig (not shown) in the subsequent process.

The receiver substrate 120 (solar cell 110) also includes positioning pins 124 that are disposed on the receiver substrate 120 and that positions the frame-shaped pedestal portion 130. Accordingly, the frame-shaped pedestal portion 130 can be easily and highly accurately positioned relative to the receiver substrate 120 with good workability. The positioning pins 124 are disposed in two predetermined positions of the receiver substrate 120, and therefore accurate positioning can be performed.

The frame-shaped pedestal portion 130 has a step portion 132 to which the holding portion 135 (brim-like protrusion 136) is fitted on the upper face side that is opposite to the lower face that is fixed to the receiver substrate 120. Accordingly, the holding portion 135 can be easily and highly accurately positioned relative to the frame-shaped pedestal portion 130 with good workability. The step portion 132 is disposed on the inner perimeter side of the frame-shaped pedestal portion 130, and therefore the holding portion 135 can be easily fitted. The configuration is not limited thereto, and the step portion 132 may be disposed on the outer perimeter side of the frame-shaped pedestal portion 130.

The frame-shaped pedestal portion 130 has a groove portion 131 formed in the lower face that is in contact with the receiver substrate 120, and the frame-shaped pedestal portion 130 is adhered to the receiver substrate 120 by a first adhesive 131b filled into the groove portion 131. Accordingly, the frame-shaped pedestal portion 130 can be easily and highly accurately fixed (adhered) to the receiver substrate 120 with good workability.

The holding portion 135 includes a brim-like protrusion 136 that is fitted to the step portion 132 at an end that faces the step portion 132. Accordingly, the columnar optical member 140 can be held in a stable manner while reducing the outer perimeter shape of the holding portion 135, and weight reduction can be achieved. In other words, the holding portion 135 has a mechanically stable structure, and therefore the influence of the position of the center of gravity of the columnar optical member 140 can be eliminated, and the columnar optical member 140 can be held in a stable manner.

The holding portion 135 is formed using, for example, an aluminum alloy. In other words, the holding portion 135 is made of a metal. Accordingly, the mechanical strength and heat dissipation properties of the holding portion 135 can be improved, the columnar optical member 140 can be reliably held in a stable manner, and the power generation efficiency and the reliability can be improved.

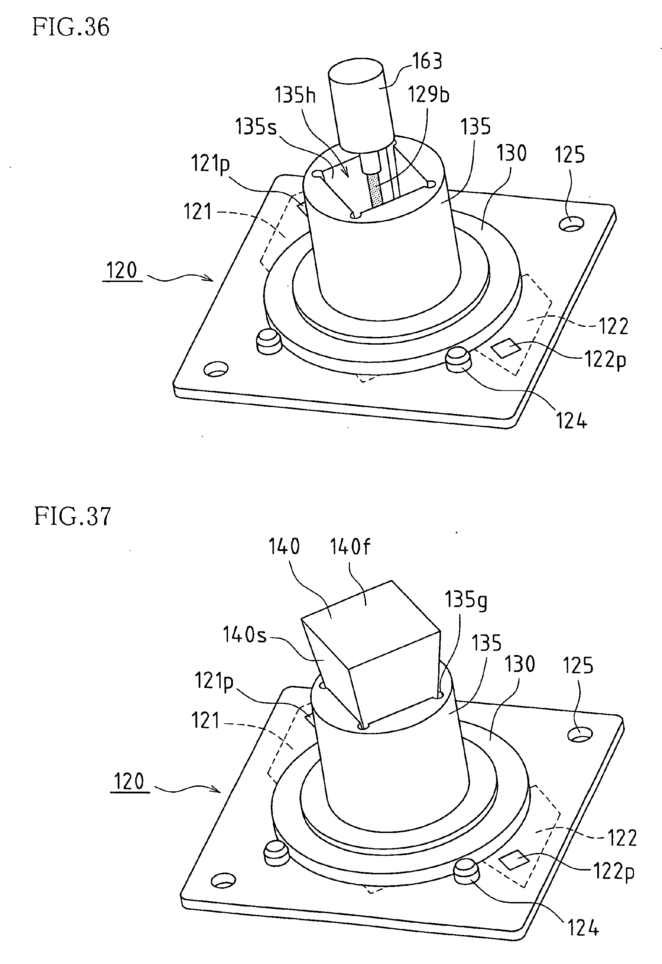

The holding portion 135 has, on the side facing the solar cell element 111, a recessed portion 137 that forms a space 137s in which the columnar optical member 140 is exposed. Accordingly, the space 137s is formed between a resin sealing portion 129 and the holding portion 135, and air bubbles produced from a sealing resin 129b (FIG. 36) when forming the resin sealing portion 129 can be released to the space 137s, and thus the sealing resin 129b can be efficiently injected in a short time. In addition, air bubbles are not contained in the resin sealing portion 129, and therefore the light-transmitting properties of the resin sealing portion 129 can be improved, improving the power generation efficiency.

The columnar optical member 140 is formed into a quadrangular prism, and the holding portion 135 is formed into a column having a through hole 135h constituted by through inclined faces 135s that are formed to correspond to the quadrangular prism and be in contact with the optical path inclined faces 140s. Accordingly, the columnar optical member 140 can be positioned relative to the holding portion 135 (through hole 135h) in a self-aligned manner, and the concentrated sunlight Ls can be highly accurately directed to the solar cell element 111, improving the light concentrating properties, and improving the power generation efficiency.

The through hole 135h has through groove portions 135g formed so as to correspond to the corners of the quadrangular prism (columnar optical member 140). Accordingly, the corners of the columnar optical member 140 can be protected from damage, and air passages extending from the solar cell element 111 to the outside can be formed, and therefore air bubbles produced when forming the resin sealing portion 129 can be released to the outside. Also, a convection flow from the solar cell element 111 to the outside can be produced during operation, improving the power generation efficiency.

The irradiation face 140r and the entrance face 140f have quadrangular shapes centered on each other. Accordingly, the columnar optical member 140 has optical path inclined faces 140s defined by the irradiation face 140r and the entrance face 140f that is made larger than the irradiation face 140r. In other words, a configuration capable of efficiently directing the concentrated sunlight Ls to the solar cell element 111 is employed.

The columnar optical member 140 has the optical path inclined faces 140s that concentrate sunlight Ls to the solar cell element 111 and that have the same inclination angle as the through inclined faces 135s of the through hole 135h of the holding portion 135. Accordingly, the columnar optical member 140 can be positioned in a self-aligned manner and fitted to the holding portion 135 (through hole 135h) by taper-fitting, achieving high accuracy positioning.

The columnar optical member 140 of the present embodiment causes the sunlight Ls concentrated by the concentrating lens 150 to directly enter the solar cell element 111, and thus the power generation efficiency of the solar cell 110 can be increased.

In the columnar optical member 140, the entrance face 140f from which sunlight Ls enters is made larger than the irradiation face 140r, and thus the margin for misalignment between the concentrating lens 150 and the solar cell 110 can be increased, improving the power generation efficiency and the power generation. In other words, light concentrating properties in which sunlight Ls over a wide wavelength region can be concentrated with high accuracy are obtained by securing a light guiding path (columnar optical member 140) having a high positional accuracy and stability, thereby improving the light concentrating properties and the heat dissipation properties, preventing reduction of power generation efficiency and temperature increase caused by deviation of the concentrated sunlight Ls and improving the power generation, and improving the heat resistance, the reliability and the weather resistance.

The holding portion 135 (through inclined faces 135s) and the columnar optical member 140 (optical path inclined faces 140s) are in contact with each other at the upper position of the holding portion 135. At the lower position of the holding portion 135, the columnar optical member 140 is exposed in the space 137s formed by the recessed portion 137 provided in the holding portion 135 and is in contact with air.

The columnar optical member 140 is made of, for example, heat resistant glass. Accordingly, the difference in refractive index of the refractive index (n=1) of air with respect to the refractive index (n=1.5) on the columnar optical member 140 side becomes large, and it is therefore possible to cause the sunlight Ls that has entered the columnar optical member 140 to efficiently travel to the front end (irradiation face 140r) of the columnar optical member 140 while causing the sunlight Ls to be efficiently totally reflected by the optical path inclined faces 140s.

The irradiation face 140r and the solar cell element 111 are resin-sealed by the resin sealing portion 129 filled into the frame-shaped pedestal portion 130. In other words, the front end (irradiation face 140r) of the columnar optical member 140 is covered to a depth of, for example, approximately 0.3 mm to 0.5 mm with the resin sealing portion 129 formed in the frame-shaped pedestal portion 130. The upper face (surface) of the resin sealing portion 129 is exposed in the recessed portion 137 (space 137s), and thus the heat generated in the solar cell element 111 is dissipated to the space 137s via the resin sealing portion 129.

As described above, the columnar optical member 140 has a refractive index n of 1.5. On the other hand, when the sealing resin 129b (FIG. 36) that constitutes the resin sealing portion 129 is a silicone resin, the resin sealing portion 129 has a refractive index n of 1.3, and therefore there is no significant difference in refractive index between the columnar optical member 140 and the resin sealing portion 129, and the sunlight Ls that has traveled through the columnar optical member 140 while being totally reflected is efficiently directed to the solar cell element 111 (effective light-receiving region) via the resin sealing portion 129.

In other words, by combining the holding portion 135, the columnar optical member 140, the resin sealing portion 129 and the space 137s, the sunlight Ls that has entered from the entrance face 140f and is directed to the solar cell element 111 via the irradiation face 140r can be efficiently guided, improving the power generation efficiency. Also, the solar cell element 111 and the wires and the like connected to the solar cell element 111 can be protected (insulated) from the surrounding environment by the resin sealing portion 129, improving the dielectric strength, and improving the reliability.

In order to dissipate heat generated in the receiver substrate 120 by the concentrated sunlight Ls to the outside, a heat dissipation fin 145 is connected to the back face of the receiver substrate 120. In other words, the receiver substrate 120 is connected to and integrated with the heat dissipation fin 145 by rivets 146 inserted into the substrate position fixing holes 125. The heat dissipation fin 145 has a comb-like shape, and therefore heat can be efficiently dissipated, further improving the power generation efficiency and the reliability of the solar cell element 111. The heat dissipation fin 145 is made of aluminum in order to achieve weight reduction.

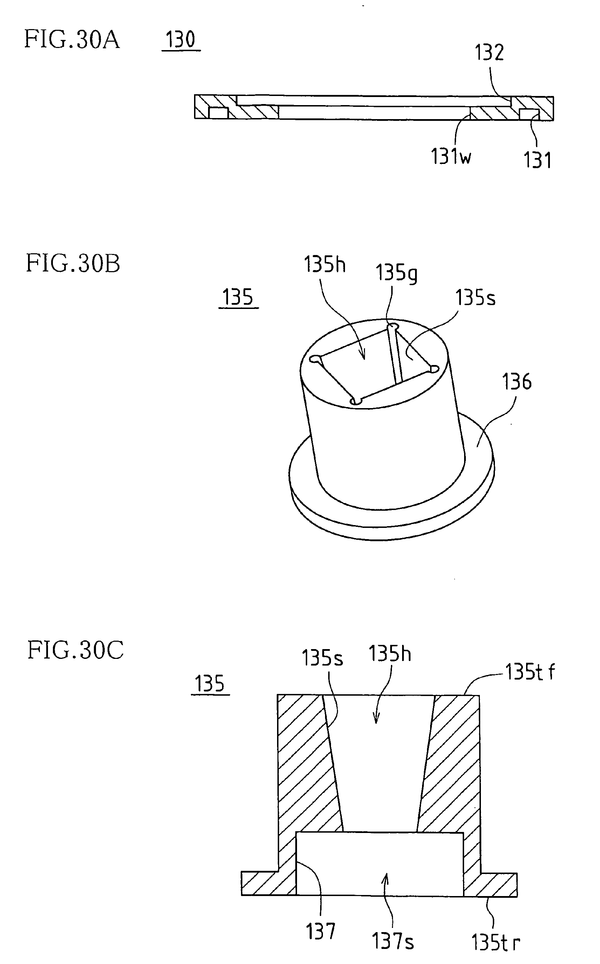

FIG. 30A is a cross-sectional view showing a cross-sectional shape of the frame-shaped pedestal portion shown in FIG. 27.

The frame-shaped pedestal portion 130 has a frame shape (annular shape) with a diameter of 25 mm to 30 mm and a thickness of approximately 5 mm. In the frame-shaped pedestal portion 130, the step portion 132 into which the brim-like protrusion 136 of the holding portion 135 is fitted is provided on the upper face side of the frame-shaped pedestal portion 130 concentrically to the center of the frame-shaped pedestal portion 130, and the recess-shaped groove portion 131 that is filled with the first adhesive 131b is provided concentrically on the lower face side (back face side).

There is a possibility that the frame-shaped pedestal portion 130 might come into direct contact with the first connection pattern 121 and the second connection pattern 122 that function as external electrodes and that are disposed on the surface of the receiver substrate 120, and it is therefore necessary to prevent current from flowing between the first connection pattern 121 and the second connection pattern 122 through the frame-shaped pedestal portion 130. Accordingly, the frame-shaped pedestal portion 130 is made of a resin such as polycarbonate.

FIG. 30B is a perspective view showing a schematic structure of the holding portion shown in FIG. 27.

FIG. 30C is a cross-sectional view showing a cross-sectional shape of the holding portion shown in FIG. 30B.

The holding portion 135 has a columnar shape, and includes a brim-like protrusion 136 at an end facing the frame-shaped pedestal portion 130. The holding portion 135 has an outer perimeter diameter of, for example, 15 mm and a height of, for example, 20 mm. The outer perimeter of the brim-like protrusion 136 has a circular shape with a diameter of 20 mm so that it can be fitted to the inner perimeter of the step portion 132 of the frame-shaped pedestal portion 130.

In the axis direction of the holding portion 135 (the center area of the holding portion 135), a through hole 135h having a quadrangular prism shape that is narrow at the side of an end face 135tr having the brim-like protrusion 136, and becomes wider toward the side of an end face 135tf not having the brim-like protrusion 136, is formed. Also, the four corners of the through hole 135h of the holding portion 135 are provided with through groove portions 135g for reliably performing a defoaming treatment on the resin sealing portion 129 after the resin sealing portion 129 has been filled. The through groove portions 135g also have the effect of preventing the edges each formed by joining two adjacent optical path inclined faces 140s of the columnar optical member 140 from damage.

Through inclined faces 135s constituting the through hole 135h are formed so as to be brought into contact with (closely attached to) the optical path inclined faces 140s of the columnar optical member 140. Accordingly, the columnar optical member 140 can be placed relative to the holding portion 135 reliably and highly accurately.

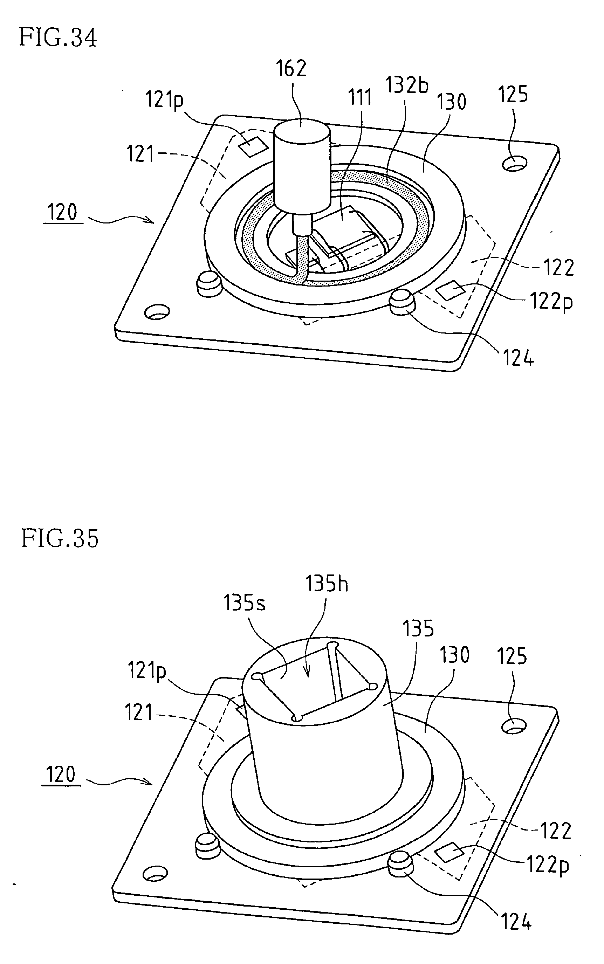

The holding portion 135 is adhered and reliably fixed to the frame-shaped pedestal portion 130 by the second adhesive 132b (FIG. 34) applied between the step portion 132 of the frame-shaped pedestal portion 130 and the brim-like protrusion 136.

The concentrating lens 150 can have any shape such as a biconvex lens, a planoconvex lens or a Fresnel lens. The material of the concentrating lens 150 is preferably a material having a high transmittance at the sensitivity wavelength of light of the solar cell element 111 and weather resistance. For example, it is possible to use a thin glass plate, weather resistance grade acrylic resin, polycarbonate or the like that are generally used in conventional solar power generation modules.

The material of the concentrating lens 150 is not limited to those mentioned above, and it is also possible to use a multi-layered composition of these materials. For the purpose of preventing ultraviolet degradation of the concentrating lens 150 and other members, an appropriate ultraviolet light absorber may be added to these materials.

### Embodiment 7

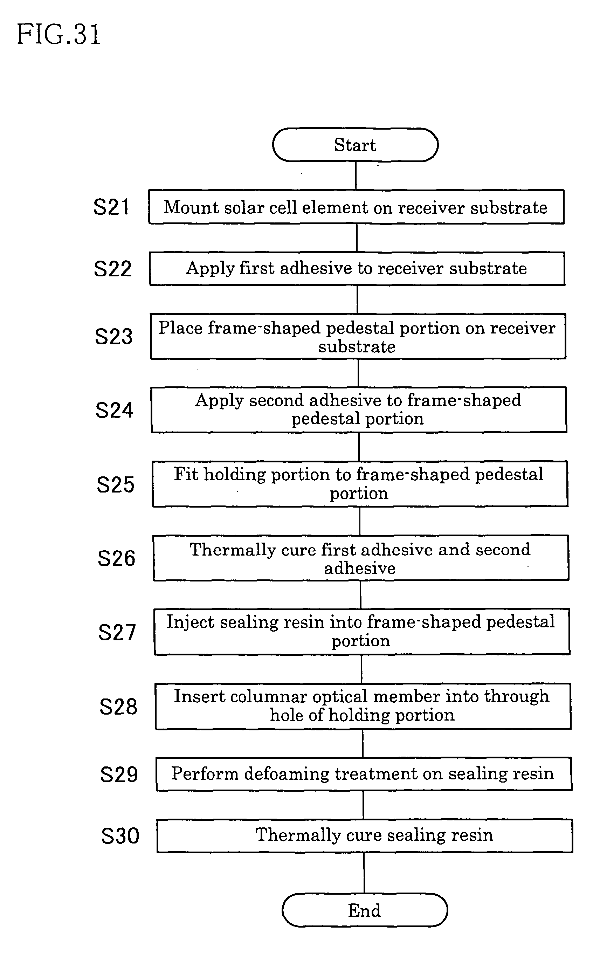

A method of manufacturing a solar cell according to the present embodiment will be described with reference to FIG. 29 (Embodiment 6) and FIGS. 31 to 37.

A solar cell 110 according to the present embodiment is the same as the solar cell 110 described in Embodiment 6, which is thus referred to as appropriate, and differences will mainly be described here.

FIG. 31 is a flowchart illustrating process steps of a method of manufacturing a solar cell according to Embodiment 7 of the present invention.

The method of manufacturing the solar cell 110 of the present embodiment includes the following Steps S21 to S30. Each step will be described with reference to the drawing corresponding to the step (FIG. 29, and FIGS. 32 to 37).

### Step S21 (FIG. 29):

A solar cell element 111 is mounted onto a receiver substrate 120 (a solar cell element mounting step).

Firstly, a receiver substrate 120 as described in Embodiment 6 is prepared. In the receiver substrate 120, a first connection pattern 121 and a second connection pattern 122 have been formed, and the surface is protected (insulated) by a surface protection layer 123. In the first connection pattern 121, a substrate for a solar cell element 111 (substrate electrode: not shown) and a substrate for a bypass diode 112 (substrate electrode: not shown) are connected. The surface protection layer 123 has been removed in advance in regions to which a solar cell element 111 and a bypass diode 112 are connected, and a region corresponding to a first extraction electrode 121p to which an external terminal is connected.

A solar cell element 111 is placed and soldered in a corresponding region (center area) of the receiver substrate 120. Likewise, a bypass diode 112 is placed and soldered in a corresponding region of the receiver substrate 120 that is spaced apart from the solar cell element 111 by a prescribed distance (an area located slightly away from the center area of the receiver substrate 120).

Next, the ends of, for example, four wires 126 are connected to the surface electrode (not shown) of the solar cell element 111, and the ends of, for example, two wires 126 are connected to the surface electrode (not shown) of the bypass diode 112. The other ends of these wires 126 are connected to a wire connecting portion 122w in which the second connection pattern 122 is exposed.

The receiver substrate 120 can be positioned as appropriate by substrate position fixing holes 125.

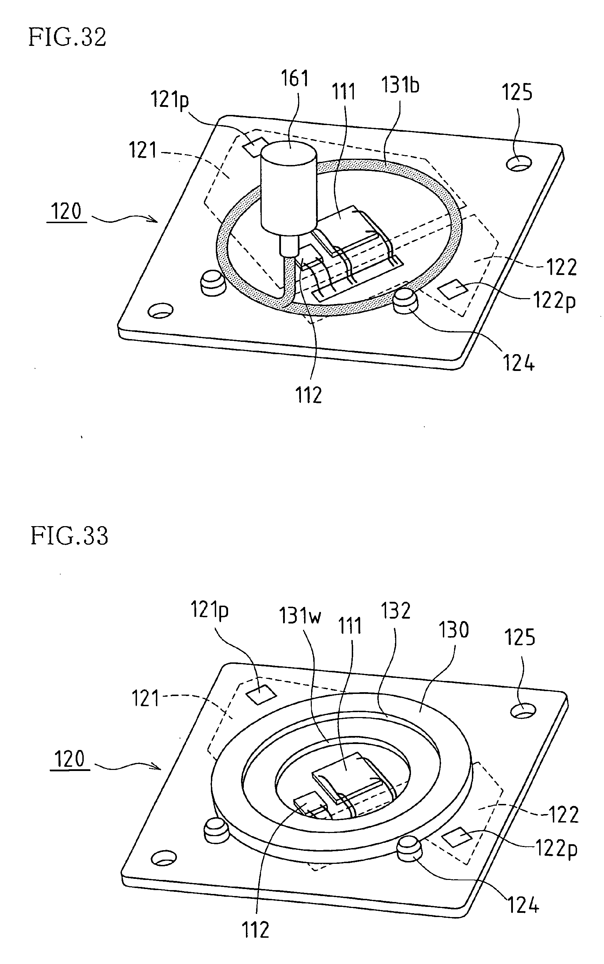

### Step S22 (FIG. 32):

FIG. 32 is a perspective view showing a step of applying a first adhesive in the process of the solar cell manufacturing method according to Embodiment 7 of the present invention.

After the solar cell element 111 and the bypass diode 112 have been mounted onto the receiver substrate 120, a first adhesive 131b that adheres a frame-shaped pedestal portion 130 to the receiver substrate 120 is applied to the receiver substrate 120 (a first adhesive applying step).

The receiver substrate 120 is set in a prescribed position on the table (not shown) of a first adhesive dispenser 161, and a first adhesive 131b is applied to a prescribed position of the receiver substrate 120 (the position corresponding to a groove portion 131, an appropriate mark may be formed in advance) in a prescribed shape. In other words, a first adhesive 131b made of a white silicone resin is applied to a predetermined position on the surface of the receiver substrate 120 on which the solar cell element 111 and the bypass diode 112 have been mounted, in a circular shape of a predetermined size.

### Step S23 (FIG. 33):

FIG. 33 is a perspective view showing a step of placing a frame-shaped pedestal portion onto the receiver substrate in the process of the solar cell manufacturing method according to Embodiment 7 of the present invention.

A frame-shaped pedestal portion 130 is positioned and placed onto the receiver substrate 120 on which the first adhesive 131b has been applied (a frame-shaped pedestal portion placing step).

The positioning of the frame-shaped pedestal portion 130 relative to the receiver substrate 120 can be performed easily and highly accurately by pressing the side face of the frame-shaped pedestal portion 130 against two positioning pins 124 provided in the receiver substrate 120. Because the first adhesive 131b has been applied in a shape capable of filling the groove portion 131, the first adhesive 131b fills the groove portion 131, and thus the frame-shaped pedestal portion 130 is rigidly adhered (fixed) to the receiver substrate 120.

The frame-shaped pedestal portion 130 is internally provided with an opening 131w, and the opening 131w has a shape capable of including the solar cell element 111, the bypass diode 112 and the wire connecting portion 122w. Accordingly, the frame-shaped pedestal portion 130 can protect the solar cell element 111, the bypass diode 112 and the wire connecting portion 122w from the surrounding environment.

### Step S24 (FIG. 34):

FIG. 34 is a perspective view showing a step of applying a second adhesive to the frame-shaped pedestal portion in the process of the solar cell manufacturing method according to Embodiment 7 of the present invention.

A second adhesive 132b that adheres a holding portion 135 to the frame-shaped pedestal portion 130 is applied to the frame-shaped pedestal portion 130 (a second adhesive applying step).

The receiver substrate 120 is set in a prescribed position on the table (not shown) of a second adhesive dispenser 162, and a second adhesive 132b is applied to the step portion 132 of the frame-shaped pedestal portion 130 placed on and adhered to the receiver substrate 120. In other words, the second adhesive 132b is applied to the step portion 132 in a circular shape.

The first adhesive 131b and the second adhesive 132b may be the same resin, and the first adhesive dispenser 161 and the second adhesive dispenser 162 may be the same apparatus.

### Step S25 (FIG. 35):

FIG. 35 is a perspective view showing a step of fitting a holding portion to the frame-shaped pedestal portion in the process of the solar cell manufacturing method according to Embodiment 7 of the present invention.

In the state in which the receiver substrate 120 is placed on the table of the second adhesive dispenser 162, a holding portion 135 is fitted to the frame-shaped pedestal portion 130 (a fitting step).

The step portion 132 of the frame-shaped pedestal portion 130 and the brim-like protrusion 136 of the holding portion 135 have shapes that can be fitted to each other, and therefore positioning can be performed easily and highly accurately. Also, the second adhesive 132b has been applied in advance to the step portion 132, and therefore the holding portion 135 (brim-like protrusion 136) and the frame-shaped pedestal portion 130 (step portion 132) are adhered and rigidly fixed to each other.

Fine adjustment for the positioning of the holding portion 135 relative to the frame-shaped pedestal portion 130 can be performed by rotating the holding portion 135 in a circumferential direction relative to the frame-shaped pedestal portion 130.

### Step S26:

The first adhesive 131b and the second adhesive 132b are thermally cured by application of heat (a first heat curing step).

Specifically, the receiver substrate 120 is removed from the table of the second adhesive dispenser 162 and placed in an oven (not shown). In that state, the first adhesive 131b and the second adhesive 132b are heated at, for example, 150°C for 30 minutes and thermally cured. Through the heat curing of the first adhesive 131b and the second adhesive 132b, the receiver substrate 120 and the frame-shaped pedestal portion 130 are integrated by the first adhesive 131b, and the frame-shaped pedestal portion 130 and the holding portion 135 are integrated by the second adhesive 132b.

### Step S27 (FIG. 36):

FIG. 36 is a perspective view showing a step of injecting a sealing resin for resin-sealing the solar cell element into the frame-shaped pedestal portion in the process of the solar cell manufacturing method according to Embodiment 7 of the present invention.

A sealing resin 129b that resin-seals the solar cell element 111 is injected into the frame-shaped pedestal portion 130 (a sealing resin injecting step).

The receiver substrate 120 is set in a prescribed position on the table (not shown) of a sealing resin dispenser 163, and a prescribed amount of sealing resin 129b that forms a resin sealing portion 129 is injected via a through hole 135h of the holding portion 135.

As the sealing resin 129b, a highly translucent silicone resin is used. The injection amount is set to such an amount that when a columnar optical member 140 has been fitted to the through hole 135h of the holding portion 135, the front end (irradiation face 140r) of the columnar optical member 140 is covered to (embedded with) a depth of approximately 0.3 mm to 0.5 mm with respect to the surface of the resin sealing portion 129.

The holding portion 135 includes a recessed portion 137 formed so as to face the solar cell element 111 mounted on the receiver substrate 120, and therefore the air bubbles contained in the sealing resin 129b injected into the frame-shaped pedestal portion 130 are easily removed, and the sealing resin 129b that forms the resin sealing portion 129 can be efficiently injected in a short time.

### Step S28 (FIG. 37):

FIG. 37 is a perspective view showing a step of inserting a columnar optical member into the through hole of the holding portion in the process of the solar cell manufacturing method according to Embodiment 7 of the present invention.

A columnar optical member 140 is inserted into (fitted to) the through hole 135h of the holding portion 135 such that the irradiation face 140r of the columnar optical member 140 facing the solar cell element 111 is covered with the sealing resin (a columnar optical member installing step).

In the state in which the receiver substrate 120 is placed on the table of the sealing resin dispenser 163, a columnar optical member 140 is fitted to the holding portion 135. As described above, the columnar optical member 140 (optical path inclined faces 140s) is formed to be capable of self-alignment with the holding portion 135 (through hole 135h, through inclined faces 135s), and therefore the columnar optical member 140 can be easily and highly accurately connected to the holding portion 135.

### Step 29:

A defoaming treatment is performed on the sealing resin 129b (a defoaming treatment step).

In the state in which the columnar optical member 140 is fitted to the holding portion 135, the receiver substrate 120 is removed from the table of the sealing resin dispenser 163 and placed in a vacuum desiccator (not shown). In that state, a vacuum is drawn by a vacuum pump (not shown) so as to perform a defoaming treatment for removing air bubbles contained in the sealing resin 129b that constitutes the resin sealing portion 129.

### Step S30:

The sealing resin 129b is thermally cured by application of heat (a second heat curing step).

After the defoaming treatment, the receiver substrate 120 is removed from the vacuum desiccator (not shown) and placed in an oven (not shown). In that state, the sealing resin 129b (resin sealing portion 129) is heated at, for example, 160°C for 40 minutes, and thermally cured. Through the heat curing of the sealing resin 129b, the columnar optical member 140 is closely attached to the front end (irradiation face 140r) of the resin sealing portion 129, and fixed to the holding portion 135 and the resin sealing portion 129

After Step S30, the receiver substrate 120 is connected to and integrated with a heat dissipation fin 145 by the rivets 146 inserted through the substrate position fixing holes 125 with the use of a riveter (not shown) (a heat dissipation fin attaching step).

As described above, according to the present embodiment, in the respective processing steps, the receiver substrate 120 is processed with its surface on which the solar cell element 111 is placed facing in the same direction (visible direction). Accordingly, the need for complex transferring processing, such as setting the receiver substrate 120 on a jig, removing it from the jig, and setting it to another jig, and positioning processing can be eliminated. In other words, a solar cell 110 having improved light concentrating properties and high heat resistance, reliability and weather resistance can be manufactured easily and highly accurately with high productivity at a low cost.

As described above, the solar cell manufacturing method according to the present embodiment is a method of manufacturing a solar cell 110 including a solar cell element 111 that converts sunlight Ls concentrated by a concentrating lens 150 into electricity, a receiver substrate 120 on which the solar cell element 111 is placed, a columnar optical member 140 having an entrance face 140f that allows the concentrated sunlight Ls to enter and an irradiation face 140r that is disposed so as to face the solar cell element 111 and that directs the sunlight Ls to the solar cell element 111, a holding portion 135 that holds the columnar optical member 140, and a frame-shaped pedestal portion 130 that is disposed around the solar cell element 111 in the shape of a frame, that is fixed to the receiver substrate 120, and to which the holding portion 135 is fitted.

The solar cell manufacturing method according to the present embodiment includes a solar cell element mounting step, a first adhesive applying step, a frame-shaped pedestal portion placing step, a second adhesive applying step, a fitting step, a first heat curing step, a sealing resin injecting step, a columnar optical member installing step, a defoaming treatment step, and a second heat curing step, which were described above.

Accordingly, the frame-shaped pedestal portion 130 can be highly accurately positioned and rigidly fixed to the receiver substrate 120, and the holding portion 135 can be highly accurately positioned and rigidly fixed to the frame-shaped pedestal portion 130, as a result of which the columnar optical member 140 can be highly accurately positioned and rigidly fixed to the solar cell element 111, and therefore light concentrating properties over a wide wavelength region are improved, improving the power generation efficiency and the power generation. Consequently, an inexpensive solar cell 110 having high heat resistance, reliability and weather resistance can be easily and highly accurately manufactured with high productivity.

The present invention may be embodied in various other forms without departing from the gist or essential characteristics thereof. Therefore, the embodiments given above are to be considered in all respects as illustrative and not limiting. The scope of the invention is indicated by the appended claims rather than by the foregoing description, and all modifications or changes that come within the meaning and range of equivalency of the claims are intended to be embraced therein.

This application claims priority on Japanese Patent Application No. 2008-163395 filed in Japan on June 23, 2008 and Japanese Patent Application No. 2009-050751 filed in Japan on March 4, 2009, the entire content of which is incorporated herein by reference.

### Industrial Applicability

The present invention is applicable to a solar cell including an optical member that directs concentrated sunlight to a solar cell element and a receiver substrate on which the solar cell element is placed, as well as to a concentrating solar power generation module incorporating such a solar cell and a method of manufacturing such a solar cell.

### Description of Reference Numerals

- 20: Concentrating Solar Power Generation Module
- 21: Solar Cell
- 22: Receiver Substrate
- 22h: Attachment Hole
- 23: Solar Cell Element
- 30: Fixing Portion
- 30b: Pedestal Covering Portion
- 30c: Beam-Shaped Flange Portion
- 30ct: Inner Edge Frame
- 30d: Coupling Flange Portion
- 30e: Through Hole
- 30f: Upright Fixing Portion (Fixing Portion)
- 30g: Through Groove Portion
- 30h: Top
- 30j: Pedestal Covering Portion Attachment Hole
- 30k: Latching Recess
- 30m: Positioning Step
- 30r: Fitting/Fixing Portion (Fixing Portion)
- 30s: Through Inclined Face
- 31: First Adhesive Portion
- 31r: First Adhesive
- 32: Second Adhesive Portion
- 32r: Second Adhesive
- 33: Third Adhesive Portion
- 33r: Third Adhesive
- 34: Resin Sealing Portion
- 34r: Sealing Resin
- 36: Translucent Adhesive Layer
- 36r: Translucent Adhesive
- 40: Optical Member
- 40a: Top Face
- 40b: Bottom Face
- 40c: Optical Path Inclined Face
- 40f: First Tabular Optical Member (Optical Member)
- 40s: Second Tabular Optical Member (Optical Member)
- 40st: Perimeter Edge
- 40p: Columnar Optical Member (Optical Member)
- 41: Translucent Protective Plate
- 45: Pedestal Portion
- 45a: Through Opening
- 45b: Top
- 45c: Bottom Face
- 45d: Bottom Recess
- 45f: Perimeter Frame
- 50: Concentrating Lens
- 51: Lens Frame
- 52: Base Plate
- 54h, 54p: Fixing Member
- 55b, 55t: Fixing Member
- 60: Cap
- 60a: Flat Face Portion
- 60b: Window Frame
- 60c: Frame Portion
- 60d: Latching Portion
- 61: First Adhesive Dispenser
- 62: Second Adhesive Dispenser
- 63: Sealing Resin Dispenser
- 64: Translucent Adhesive Dispenser
- 65: Third Adhesive Dispenser
- 70: Positioning Jig
- 71: Positioning Pin
- 101: Concentrating Solar Power Generation Module
- 110: Solar Cell
- 111: Solar Cell Element
- 112: Bypass Diode
- 120: Receiver Substrate
- 120b: Base
- 121: First Connection Pattern
- 121p: First Extraction Electrode
- 122: Second Connection Pattern
- 122p: Second Extraction Electrode
- 122w: Wire Connecting Portion
- 123: Surface Protection Layer
- 124: Positioning Pin
- 125: Substrate Position Fixing Hole
- 126: Wire
- 129: Resin Sealing Portion
- 129b: Sealing Resin
- 130: Frame-Shaped Pedestal Portion
- 131: Groove Portion
- 131b: First Adhesive
- 131w: Opening
- 132: Step Portion
- 132b: Second Adhesive
- 135: Holding Portion
- 135g: Through Groove Portion
- 135h: Through Hole
- 135s: Through Inclined Face
- 135tf: End Face
- 135tr: End Face
- 136: Brim-Like Protrusion
- 137: Recessed Portion
- 137s: Space
- 140: Columnar Optical Member
- 140f: Entrance Face
- 140r: Irradiation Face
- 140s: Optical Path Inclined Face
- 145: Heat Dissipation Fin
- 146: Rivet
- 150: Concentrating Lens
- 161: First Adhesive Dispenser
- 162: Second Adhesive Dispenser
- 163: Sealing Resin Dispenser
- Lax: Optical Axis
- Ls: Sunlight

## Claims

1. A solar cell including an optical member that allows concentrated sunlight to pass therethrough, a solar cell element that converts the sunlight that has passed through the optical member into electricity, and a receiver substrate on which the solar cell element is placed, the solar cell comprising:
a first adhesive portion that is adhered to the receiver substrate and that is formed into a frame shape surrounding the solar cell element;
a pedestal portion that is in contact with the receiver substrate and that is adhered to the first adhesive portion so as to surround the solar cell element; and
a resin sealing portion that is surrounded by the first adhesive portion and that covers the solar cell element.

2. The solar cell according to claim 1,
wherein the optical member is a first tabular optical member having a tabular shape, and the first tabular optical member is disposed between the first adhesive portion and the pedestal portion.

3. The solar cell according to claim 1, comprising:
a second adhesive portion that is formed on top of the pedestal portion; and
a pedestal covering portion including a beam-shaped flange portion that is adhered to the second adhesive portion and that extends in a direction parallel to the receiver substrate and a coupling flange portion that extends outwardly from the beam-shaped flange portion and that is connected to the receiver substrate outside the pedestal portion.

4. The solar cell according to claim 3,
wherein the optical member is a second tabular optical member having a tabular shape, and the second tabular optical member is placed on top of the pedestal portion with a perimeter edge thereof covered with the beam-shaped flange portion.

5. The solar cell according to claim 3,
wherein the optical member is a columnar optical member having a columnar shape with a top face thereof larger than a bottom face thereof, and the columnar optical member is fixed by a fixing portion at an inner edge of the beam-shaped flange portion.

6. The solar cell according to claim 5,
wherein the fixing portion is an upright fixing portion that is provided upright at an inner edge frame of the beam-shaped flange portion and that has a through inclined face that allows the columnar optical member to pass through and that faces the columnar optical member.

7. A concentrating solar power generation module comprising a concentrating lens that concentrates sunlight and a solar cell that receives the concentrated sunlight and converts the sunlight into electricity,
wherein the solar cell is a solar cell according to any one of claims 1 to 6.

8. A method of manufacturing a solar cell including an optical member that allows concentrated sunlight to pass therethrough, a solar cell element that converts the sunlight that has passed through the optical member into electricity, a receiver substrate on which the solar cell element is placed, a first adhesive portion that is adhered to the receiver substrate and that is formed into a frame shape surrounding the solar cell element, a pedestal portion that is in contact with the receiver substrate and that is adhered to the first adhesive portion so as to surround the solar cell element, and a fixing portion that fixes the optical member with respect to the pedestal portion, the method comprising:
a first adhesive applying step of applying a first adhesive that forms the first adhesive portion to the receiver substrate;
a pedestal portion placing step of placing the pedestal portion on the receiver substrate by adhering the pedestal portion to the first adhesive;
a first heat curing step of forming the first adhesive portion by heating the first adhesive; and
an optical member disposing step of disposing the optical member in the fixing portion.

9. A method of manufacturing a solar cell including an optical member that allows concentrated sunlight to pass therethrough, a solar cell element that converts the sunlight that has passed through the optical member into electricity, a receiver substrate on which the solar cell element is placed, a first adhesive portion that is adhered to the receiver substrate and that is formed into a frame shape surrounding the solar cell element, a pedestal portion that is in contact with the receiver substrate and that is adhered to the first adhesive portion so as to surround the solar cell element, a resin sealing portion that is surrounded by the first adhesive portion and that covers the solar cell element, and a second adhesive portion formed on top of the pedestal portion, and also including a pedestal covering portion including a beam-shaped flange portion that is adhered to the second adhesive portion and that extends in a direction parallel to the receiver substrate and a coupling flange portion that extends outwardly from the beam-shaped flange portion and that is connected to the receiver substrate outside the pedestal portion, and a fixing portion that fixes a columnar optical member that has a columnar shape and that serves as the optical member, the method comprising:
a first adhesive applying step of applying a first adhesive that forms the first adhesive portion to the receiver substrate;
a pedestal portion placing step of placing the pedestal portion on the receiver substrate by adhering the pedestal portion to the first adhesive;
a second adhesive applying step of applying a second adhesive that forms the second adhesive portion on top of the pedestal portion;
a pedestal covering portion placing step of placing the pedestal covering portion on the receiver substrate by adhering the pedestal covering portion to the second adhesive, the pedestal covering portion having an upright fixing portion, serving as the fixing portion, that is provided upright at an inner edge frame of the beam-shaped flange portion and that has a through inclined face that allows the columnar optical member to pass through and that faces the columnar optical member;
a first heat curing step of forming the first adhesive portion and the second adhesive portion by heating the first adhesive and the second adhesive;
a columnar optical member disposing step of disposing the columnar optical member such that the columnar optical member comes into contact with the through inclined face and is fixed; and
a sealing resin injecting step of injecting a sealing resin for resin-sealing the solar cell element into an interior region of the first adhesive portion.

10. A solar cell comprising a solar cell element that converts sunlight concentrated by a concentrating lens into electricity, a receiver substrate on which the solar cell element is placed, a columnar optical member having an entrance face that allows the concentrated sunlight to enter and an irradiation face that is disposed so as to face the solar cell element and that directs the sunlight to the solar cell element, and a holding portion that holds the columnar optical member,
wherein the solar cell includes a frame-shaped pedestal portion that is disposed around the solar cell element in the shape of a frame and that is fixed to the receiver substrate, and
the holding portion is fitted to the frame-shaped pedestal portion.

11. The solar cell according to claim 10,
wherein the solar cell includes a positioning pin that is disposed on the receiver substrate and that positions the frame-shaped pedestal portion.

12. The solar cell according to claim 10 or 11,
wherein the frame-shaped pedestal portion has a step portion to which the holding portion is fitted.

13. The solar cell according to any one of claims 10 to 12,
wherein the frame-shaped pedestal portion has a groove portion formed in a face coming into contact with the receiver substrate, and is adhered to the receiver substrate by the first adhesive filled into the groove portion.

14. The solar cell according to claim 12 or 13,
wherein the holding portion includes a brim-like protrusion that is fitted to the step portion at an end facing the step portion.

15. The solar cell according to any one of claims 10 to 14,
wherein the columnar optical member is formed into a quadrangular prism, and the holding portion has a columnar shape having a through hole that makes contact with the quadrangular prism.

16. The solar cell according to any one of claims 10 to 15,
wherein the holding portion is made of a metal.

17. The solar cell according to any one of claims 10 to 16,
wherein the irradiation face and the solar cell element are resin-sealed by a resin sealing portion filled into the frame-shaped pedestal portion.

18. The solar cell according to any one of claims 10 to 17,
wherein the holding portion has a recessed portion constituting a space in which the columnar optical member is exposed on a side facing the solar cell element.

19. The solar cell according to any one of claims 15 to 18,
wherein the through hole has through groove portions formed so as to correspond to the corners of the quadrangular prism.

20. A concentrating solar power generation module comprising a concentrating lens that concentrates sunlight and a solar cell that receives the concentrated sunlight and converts the sunlight into electricity,
wherein the solar cell is a solar cell according to any one of claims 10 to 19.

21. A method of manufacturing a solar cell including a solar cell element that converts sunlight concentrated by a concentrating lens into electricity, a receiver substrate on which the solar cell element is placed, a columnar optical member including an entrance face that allows the concentrated sunlight to enter and an irradiation face that is disposed so as to face the solar cell element and that directs the sunlight to the solar cell element, a holding portion that holds the columnar optical member, and a frame-shaped pedestal portion that is disposed around the solar cell element in the shape of a frame, that is fixed to the receiver substrate, and to which the holding portion is fitted, the method comprising:
a solar cell element mounting step of mounting the solar cell element onto the receiver substrate;
a first adhesive applying step of applying a first adhesive for adhering the frame-shaped pedestal portion to the receiver substrate onto the receiver substrate;
a frame-shaped pedestal portion placing step of positioning and placing the frame-shaped pedestal portion on the receiver substrate;
a second adhesive applying step of applying a second adhesive for adhering the holding portion to the frame-shaped pedestal portion onto the frame-shaped pedestal portion;
a fitting step of fitting the holding portion to the frame-shaped pedestal portion;
a first heat curing step of thermally curing the first resin and the second resin by application of heat;
a sealing resin injecting step of injecting a sealing resin for resin-sealing the solar cell element into the frame-shaped pedestal portion;
a columnar optical member installing step of inserting the columnar optical member into a through hole of the holding portion such that the irradiation face of the columnar optical member that faces the solar cell element is covered with the sealing resin;
a defoaming treatment step of performing a defoaming treatment on the sealing resin; and
a second heat curing step of thermally curing the sealing resin by application of heat.
